(19) Europäisches Patentamt
European Patent Office
Office européen des brevets

(11) EP 4 578 991 A2

(12) EUROPEAN PATENT APPLICATION

(43) Date of publication:
02.07.2025 Bulletin 2025/27

(21) Application number: 25175538.5

(22) Date of filing: 07.01.2019

(51) International Patent Classification (IPC):
C23C 16/44 (2006.01)

(52) Cooperative Patent Classification (CPC):
C23C 16/4404; C23C 16/4412; C23C 16/4585;
H01J 37/321; H01J 37/32119; H01J 37/32467;
H01J 37/32477; H01J 37/32495; H01J 37/32871

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 08.01.2018 US 201862614974 P

(62) Document number(s) of the earlier application(s) in
accordance with Art. 76 EPC:
19736155.3 / 3 738 136

(71) Applicant: LAM Research Corporation
Fremont, CA 94538 (US)

(72) Inventors:
• PENG, Gordon, Wen-yin
Fremont, 94538 (US)
• CHHATRE, Ambarish (Rish)
Fremont, 94538 (US)
• MAROHI, Dan
Fremont, 94538 (US)
• PANDHUMSOPORN, Tamarak
Fremont, 94538 (US)
• CHAZARO, Ignacio (nacho)
Fremont, 94538 (US)

(74) Representative: Mewburn Ellis LLP
Aurora Building
Counterslip
Bristol BS1 6BX (GB)

Remarks:
This application was filed on 09-05-2025 as a
divisional application to the application mentioned
under INID code 62.

(54) COMPONENTS AND PROCESSES FOR MANAGING PLASMA PROCESS BYPRODUCT MATERIALS

(57) Components and processes are disclosed herein for managing non-volatile and/or low-volatility byproduct materials that are generated within a plasma processing region of a plasma processing chamber during performance of various plasma-based processes on a substrate. The components include a top window structure, a liner structure, an edge ring structure, a focus ring structure, a ground ring structure, a substrate access port shield, an insert liner for a port opening in a chamber wall, and an exhaust baffle assembly for positioning within an exhaust channel connected to the chamber. One or more process-exposed surface(s) of the various components are subjected to a surface roughening/texturizing process to impart a surface roughness and/or engineered topography to the process-exposed surface that promotes adhesion and retention of plasma process byproduct materials. The various components with roughened/texturized process-exposed surface(s) are configured for use in lead zirconate titanate (PZT) film etching and/or platinum (Pt) film etching processes.

Fig. 3

## Description

## Background

### 1. Field of the Invention

The present invention relates to semiconductor device fabrication.

### 2. Description of the Related Art

In various semiconductor fabrication processes, a process gas is transformed into a plasma within a processing chamber in which a substrate is positioned. The substrate is exposed to the plasma to produce a desired effect on the substrate, such as to etch/remove material from the substrate, and/or deposit material on the substrate, and/or modify a characteristic of a material on the substrate. During some semiconductor fabrication processes, non-volatile and/or low-volatility plasma process byproduct materials can be generated within the processing chamber. As these byproduct materials deposit and buildup on various components with the processing chamber, various problems can occur. For example, the byproduct materials can flake-off and/or peel-off of components and land on surfaces within the processing chamber that should remain contaminant-free, such as a substrate support structure and the substrate itself. Additionally, the byproduct materials can diffuse into small openings and mechanically active structures within the processing chamber causing operational problems and/or increasing an amount of time and cost required to clean the processing chamber. Also, byproduct material buildup and dislodgement within the processing chamber increases a frequency at which the processing chamber must be taken out of service for cleaning, which negatively impacts substrate fabrication throughput of the processing chamber. It is within this context that the present invention arises.

## Summary

In an example embodiment, a surface-textured plasma process chamber component is disclosed as a ceramic component configured for placement within a plasma process chamber, where the ceramic component includes at least one roughened surface oriented to be in exposure to plasma process byproduct material when the ceramic component is placed within the plasma process chamber during operation of the plasma process chamber. The at least one roughened surface is configured to promote adherence of the plasma process byproduct material to the ceramic component.

In an example embodiment, a plasma process chamber is disclosed. The plasma process chamber includes a substrate support structure configured to hold a substrate in exposure to a plasma during operation of the plasma process chamber. The plasma process chamber also includes a top window structure positioned above the substrate support structure to establish a plasma processing region between the substrate support structure and the top window structure. The top window structure is formed of ceramic material. The top window structure has a bottom surface facing the plasma processing region. The bottom surface has a surface roughness that promotes adherence of plasma process byproduct material to the bottom surface.

In an example embodiment, a method is disclosed for plasma processing of a substrate. The method includes having a plasma process chamber that includes a substrate support structure and a top window structure. The substrate support structure is configured to hold the substrate in exposure to a plasma. The top window structure is positioned above the substrate support structure to establish a plasma processing region between the substrate support structure and the top window structure. The top window structure is formed of ceramic material. The top window structure has a bottom surface facing the plasma processing region. The bottom surface has a surface roughness that promotes adherence of plasma process byproduct material to the bottom surface. The method also includes generating a plasma in the plasma processing region. Constituents of the plasma interact with a material on the substrate to generate plasma process byproduct material, with some of the plasma process byproduct material adhering to the bottom surface of the top window structure.

In an example embodiment, a method is disclosed for manufacturing a component for use within a plasma process chamber. The method includes forming a ceramic component for installation within a plasma process chamber. The ceramic component has at least one process-exposed surface. The method also includes roughening the at least one process-exposed surface to have a surface roughness average within a range extending from about 150 microinches to about 500 microinches.

In an example embodiment, a method is disclosed for converting a coated component for use within a plasma process chamber into a surface-roughened component for use within the plasma process chamber. The method includes stripping a coating from a ceramic component down to a bare ceramic material of which the ceramic component is formed. The ceramic component is configured for installation within a plasma process chamber. The ceramic component has at least one process-exposed surface. The method also includes roughening the at least one process-exposed surface to have a surface roughness average within a range extending from about 150 microinches to about 500 microinches.

In an example embodiment, a focus ring for use in a plasma process chamber is disclosed. The focus ring includes a ring structure formed of a ceramic material. The ring structure is configured to circumscribe a substrate support structure within a plasma process chamber. The ring structure has an inner surface oriented to be in exposure to plasma process byproduct material when the ring structure is placed within the plasma process chamber during operation of the plasma process chamber. The inner surface is formed to have a controlled surface topographical variation that promotes adherence of the plasma process byproduct material to the inner surface.

In an example embodiment, a plasma process chamber is disclosed. The plasma process chamber includes a substrate support structure configured to hold a substrate in exposure to a plasma during operation of the plasma process chamber. The plasma process chamber also includes a focus ring including a ring structure formed of a ceramic material. The ring structure is configured to circumscribe the substrate support structure within the plasma process chamber. The ring structure has an inner surface oriented to be in exposure to plasma process byproduct material during operation of the plasma process chamber. The inner surface is formed to have a controlled surface topographical variation that promotes adherence of the plasma process byproduct material to the inner surface.

In an example embodiment, a method is disclosed for plasma processing of a substrate. The method includes having a plasma process chamber that includes a substrate support structure and a focus ring. The focus ring includes a ring structure formed of a ceramic material. The ring structure is configured to circumscribe the substrate support structure within the plasma process chamber. The ring structure has an inner surface oriented to be in exposure to plasma process byproduct material during operation of the plasma process chamber. The inner surface is formed to have a controlled surface topographical variation that promotes adherence of the plasma process byproduct material to the inner surface. The method also includes generating a plasma in a plasma processing region above the substrate support structure. Constituents of the plasma interact with a material on the substrate to generate plasma process byproduct material, with some of the plasma process byproduct material adhering to the inner surface of the ring structure.

In an example embodiment, a method is disclosed for manufacturing a focus ring for use in a plasma process chamber. The method includes forming a ring structure of a ceramic material. The ring structure is configured to circumscribe a substrate support structure within a plasma process chamber. The ring structure has an inner surface oriented to be in exposure to plasma process byproduct material when the ring structure is placed within the plasma process chamber during operation of the plasma process chamber. The method also includes forming a controlled surface topographical variation on the inner surface of the ring structure. The controlled surface topographical variation promotes adherence of the plasma process byproduct material to the inner surface.

In an example embodiment, a substrate access port shield for use in a plasma process chamber is disclosed. The substrate access port shield includes a shield segment, a first support segment, and a second support segment. The first support segment extends from a first end of the shield segment. The first support segment is configured to engage with a vertically movable component within the plasma process chamber. The second support segment extends from a second end of the shield segment. The second support segment is configured to engage with the vertically movable component within the plasma process chamber. The shield segment and the first and second support segments form an integral shield structure that extends along an arc. Vertical movement of the vertically movable component causes corresponding vertical movement of the integral shield structure. The shield segment is configured to at least partially cover a substrate access port opening of the plasma process chamber when the first and second support segments are engaged with the vertically movable component and the vertically movable component is in a lowered vertical position. The shield segment configured to uncover the substrate access port opening of the plasma process chamber when the first and second support segments are engaged with the vertically movable component and the vertically movable component is in a raised vertical position.

In an example embodiment, a plasma process chamber is disclosed. The plasma process chamber includes a substrate support structure configured to hold a substrate in exposure to a plasma during operation of the plasma process chamber. The plasma process chamber also includes a focus ring structure configured to circumscribe the substrate support structure within the plasma process chamber. The focus ring structure includes a ring portion formed as a right circular hollow cylinder and three radial extension structures configured to extend radially outward from an outer surface of the ring portion. The three radial extension structures are spaced apart along an outer perimeter of the ring portion. The plasma process chamber also includes an integral shield structure that includes a shield segment, a first support segment, and a second support segment. The first support segment extends from a first end of the shield segment. The first support segment is configured to engage with a first of the three radial extension structures of the focus ring structure. The second support segment extends from a second end of the shield segment. The second support segment is configured to engage with a second of the three radial extension structures of the focus ring structure. The integral shield structure is formed to extend along an arc. The shield segment is configured to at least partially cover a substrate access port opening of the plasma process chamber when the focus ring structure is in a lowered vertical position. The shield segment is configured to uncover the substrate access port opening of the plasma process chamber when the focus ring structure is in a raised vertical position.

In an example embodiment, a method is disclosed for plasma processing of a substrate. The method includes having a plasma process chamber that includes a substrate support structure, a focus ring structure, and an integral shield structure. The focus ring structure is configured to circumscribe the substrate support structure. The focus ring structure includes a ring portion formed as a right circular hollow cylinder and three radial extension structures configured to extend radially outward from an outer surface of the ring portion. The three radial extension structures are spaced apart along an outer perimeter of the ring portion. The integral shield structure includes a shield segment, a first support segment, and a second support segment. The first support segment extends from a first end of the shield segment. The first support segment is configured to engage with a first of the three radial extension structures of the focus ring structure. The second support segment extends from a second end of the shield segment. The second support segment is configured to engage with a second of the three radial extension structures of the focus ring structure. The integral shield structure is formed to extend along an arc. The shield segment is configured to at least partially cover a substrate access port opening of the plasma process chamber when the focus ring structure is in a lowered vertical position. The shield segment is configured to uncover the substrate access port opening of the plasma process chamber when the focus ring structure is in a raised vertical position. The method also includes positioning the focus ring structure in the lowered vertical position. The method also includes generating a plasma in a plasma processing region above the substrate support structure.

In an example embodiment, a method is disclosed for manufacturing a substrate access port shield for use in a plasma process chamber. The method includes forming an integral shield structure to include a shield segment, a first support segment extending from a first end of the shield segment, and a second support segment extending from a second end of the shield segment. The first support segment is configured to engage with a vertically movable component within the plasma process chamber. The second support segment is configured to engage with the vertically movable component within the plasma process chamber. The integral shield structure is formed to extend along an arc. The shield segment is configured to at least partially cover a substrate access port opening of the plasma process chamber when the first and second support segments are engaged with the vertically movable component and the vertically movable component is in a lowered vertical position. The shield segment is configured to uncover the substrate access port opening of the plasma process chamber when the first and second support segments are engaged with the vertically movable component and the vertically movable component is in a raised vertical position.

In an example embodiment, an insert liner for a port of a plasma process chamber is disclosed. The insert liner is configured to cover an inner surface of the port formed through a wall of the plasma process chamber. The insert liner is configured to have mechanical flexibility sufficient for compression of an outer surface profile of the insert liner to enable insertion of the insert liner into the port. The insert liner is configured to impart a spring force against the inner surface of the port upon release of compression of the outer surface profile of the insert liner.

In an example embodiment, a plasma process system is disclosed. The plasma process system includes a plasma process chamber that includes a plasma processing region in which a plasma is generated during operation of the plasma process chamber. The plasma process chamber includes a wall that forms part of an enclosure around the plasma processing region. The wall includes a port formed through the wall. The plasma process system includes an insert liner positioned within the port. The insert liner is configured to cover an inner surface of the port. The insert liner is configured to impart a spring force against the inner surface of the port to hold the insert liner in position within the port.

In an example embodiment, a method is disclosed for plasma processing of a substrate. The method includes having a plasma process chamber that includes a plasma processing region in which a plasma is generated during operation of the plasma process chamber. The plasma process chamber includes a wall that forms part of an enclosure around the plasma processing region. The wall includes a port formed through the wall. The method also includes positioning an insert liner within the port. The insert liner is configured to cover an inner surface of the port. The insert liner is configured to impart a spring force against the inner surface of the port to hold the insert liner in position within the port. The method also includes generating a plasma in the plasma processing region in exposure to a substrate. Constituents of the plasma interact with a material on the substrate to generate plasma process byproduct material. The insert liner prevents plasma process byproduct material from contacting the inner surface of the port.

In an example embodiment, a method is disclosed for manufacturing an insert liner for a port of a plasma process chamber. The method includes forming an insert liner to cover an inner surface of the port formed through a wall of the plasma process chamber. The insert liner is configured to have mechanical flexibility sufficient for compression of an outer surface profile of the insert liner to enable insertion of the insert liner into the port. The insert liner is configured to impart a spring force against the inner surface of the port upon release of compression of the outer surface profile of the insert liner.

In an example embodiment, an exhaust baffle assembly is disclosed for use in a plasma process chamber. The exhaust baffle assembly includes at least one baffle member configured to fit within an exhaust channel of the plasma process chamber. The at least one baffle member is shaped to deflect a flow of process exhaust gas when positioned within the exhaust channel. An outer surface of the at least one baffle member is conditioned to promote adherence of plasma process byproduct material present within the flow of process exhaust gas to the at least one baffle member.

In an example embodiment, a plasma process system is disclosed. The plasma process system includes a plasma process chamber that includes a plasma processing region in which a plasma is generated during operation of the plasma process chamber. The plasma process system also includes an exhaust channel for the plasma process chamber. The exhaust channel is fluidly connected to the plasma processing region. The exhaust channel is configured to direct a flow of process exhaust gas from the plasma processing region. The plasma process system also includes a pump connected to the exhaust channel. The pump is configured to apply a negative pressure to an interior of the exhaust channel. The plasma process system also includes an exhaust baffle assembly positioned within the exhaust channel. The exhaust baffle assembly includes at least one baffle member shaped to deflect the flow of process exhaust gas within the exhaust channel. An outer surface of the at least one baffle member is conditioned to promote adherence of plasma process byproduct material present within the flow of process exhaust gas to the at least one baffle member.

In an example embodiment, a method is disclosed for plasma processing of a substrate. The method includes having a plasma process system that includes a plasma process chamber and an exhaust channel for the plasma process chamber. The plasma process chamber includes a plasma processing region in which a plasma is generated during operation of the plasma process chamber. The exhaust channel is fluidly connected to the plasma processing region. The exhaust channel is configured to direct a flow of process exhaust gas from the plasma processing region. The plasma process system also includes a pump connected to the exhaust channel. The pump is configured to apply a negative pressure to an interior of the exhaust channel. The plasma process system includes an exhaust baffle assembly positioned within the exhaust channel. The exhaust baffle assembly includes at least one baffle member shaped to deflect the flow of process exhaust gas within the exhaust channel. An outer surface of the at least one baffle member is conditioned to promote adherence of plasma process byproduct material present within the flow of process exhaust gas to the at least one baffle member. The method also includes generating a plasma in the plasma processing region in exposure to a substrate. The method also includes operating the pump to apply the negative pressure to the interior of the exhaust channel to draw the flow of process exhaust gas from the plasma processing region into the exhaust channel and through the exhaust baffle assembly within the exhaust channel.

In an example embodiment, a method is disclosed for manufacturing an exhaust baffle assembly for use in a plasma process system. The method includes forming at least one baffle member to fit within an exhaust channel of a plasma process chamber. The at least one baffle member is shaped to deflect a flow of process exhaust gas when positioned within the exhaust channel. The method also includes conditioning an outer surface of the at least one baffle member to promote adherence of plasma process byproduct material present within the flow of process exhaust gas to the at least one baffle member.

Other aspects and advantages of the invention will become more apparent from the following detailed description, taken in conjunction with the accompanying drawings, illustrating by way of example the present invention.

**Brief Description of the Drawings**

Figure 1A shows an example system for performing a plasma process on a substrate, in accordance with some embodiments.

Figure 1B shows a vertical cross-section view through of a portion of the system of Figure 1A, in accordance with some embodiments.

Figure 1C shows an isometric view of the substrate support structure with an edge ring structure and a ground ring structure positioned to surround the substrate support structure, in accordance with some example embodiments.

Figure 1D shows an isometric view of the substrate support structure with the edge ring structure and the ground ring structure positioned to surround the substrate support structure, and with a focus ring structure positioned above and around a upper surface of the substrate support structure, in accordance with some example embodiments.

Figure 1E shows the configuration of Figure 1D with the focus ring structure in the raised position relative to the substrate support structure, in accordance with some example embodiments.

Figure 1F shows an isometric view of an example of the liner structure positioned on the ground ring structure, in accordance with some example embodiments.

Figure 2 shows an isometric view of a bottom surface of the top window structure, in accordance with some embodiments.

Figure 3 shows an isometric view of the liner structure, in accordance with some embodiments.

Figure 4 shows an isometric view of the edge ring structure, in accordance with some embodiments.

Figure 5 shows an isometric view of the focus ring structure, in accordance with some embodiments.

Figure 6 shows an isometric view of the ground ring structure, in accordance with some embodiments.

Figure 7 shows a flowchart of a method for plasma processing of a substrate, in accordance with some embodiments.

Figure 8 shows a flowchart of a method for manufacturing a surface-textured plasma process chamber component, in accordance with some embodiments.

Figure 9 shows a flowchart of a method for converting a coated plasma process chamber component into a surface-textured plasma process chamber component, in accordance with some embodiments.

Figure 10A shows an isometric view of a focus ring structure that has a controlled surface topographical variation on an inner surface of a ring portion of the focus ring structure, in accordance with some embodiments.

Figure 10B shows a transparent view of the focus ring structure of Figure 10A, in accordance with some embodiments.

Figure 10C shows a top view of the focus ring structure of Figure 10A, in accordance with some embodiments.

Figure 10D shows a detailed view as referenced in Figure 10C, in accordance with some embodiments.

Figure 10E shows a cross-section view through two adjacent convex structures, in accordance with some embodiments.

Figure 10F shows a vertical cross-section through a center of the focus ring structure, in accordance with some embodiments.

Figure 10G shows a diagram for forming the convex structures in a rectangular lattice over the inner surface of the ring portion of the focus ring structure, in accordance with some embodiments.

Figure 10H shows a diagram for forming the convex structures in a square lattice over the inner surface of the ring portion of the focus ring structure, in accordance with some embodiments.

Figure 10I shows a diagram for forming the convex structures in a hexagonal lattice over the inner surface of the ring portion of the focus ring structure, in accordance with some embodiments.

Figure 10J shows a diagram for forming the convex structures in a parallelogrammic lattice over the inner surface of the ring portion of the focus ring structure, in accordance with some embodiments.

Figure 10K shows a diagram for forming the convex structures in a rhombic lattice over the inner surface of the ring portion of the focus ring structure, in accordance with some embodiments.

Figure 11 shows a flowchart of a method for plasma processing of a substrate, in accordance with some embodiments.

Figure 12 shows a flowchart of a method for manufacturing a focus ring structure for use in a plasma process chamber, in accordance with some embodiments.

Figure 13A shows the system of Figure 1A with an access control device positioned to cover the opening, in accordance with some embodiments.

Figure 13B shows a diagram of the chamber interfaced with a substrate handling module by way of the access control device, in accordance with some embodiments.

Figure 14 shows a substrate access port shield for use in the chamber, in accordance with some embodiments.

Figure 15 shows an isometric view of the substrate access port shield showing the cutout areas, in accordance with some embodiments.

Figure 16 shows a variation of the substrate access port shield in which a shield segment has a reduced vertical distance to enable sufficient uncovering of the opening of the chamber when the focus ring structure is in its fully raised vertical position, in accordance with some embodiments.

Figure 17A shows a side view of the example substrate access port shield positioned on the focus ring structure, with the focus ring structure in the fully lowered position, in accordance with some embodiments.

Figure 17B shows a side view of the example substrate access port shield positioned on the focus ring structure, with the focus ring structure in the fully raised position, in accordance with some embodiments.

Figure 18 shows a flowchart of a method for plasma processing of a substrate, in accordance with some embodiments.

Figure 19 shows a flowchart of a method for manufacturing a substrate access port shield for use in a plasma process chamber, in accordance with some embodiments.

Figure 20 shows the chamber with the opening for transfer of the substrate into and out of the chamber, in accordance with some embodiments.

Figure 21 shows an insert liner configured for insertion into the opening for transfer of the substrate into and out of the chamber and an insert liner configured for insertion into the opening for the viewport, in accordance with some embodiments.

Figure 22 shows an isometric view of the insert liner configured for insertion into the opening for transfer of the substrate into and out of the chamber, in accordance with some embodiments.

Figure 23 shows an isometric view of the insert liner configured for insertion into the opening for the viewport, in accordance with some embodiments.

Figure 24 shows a variation of the insert liner of Figure 22, where the insert liner is cut through on a vertical side of the insert liner to form a gap, in accordance with some embodiments.

Figure 25 shows front view of a variation of the insert liner of Figure 22 that includes a convex region formed over an upper surface of the insert liner, in accordance with some embodiments.

Figure 26 shows an insert liner that is configured to insert into the opening for the viewport and that includes a vertical surface that blocks off the opening at the inner surface of the chamber wall, in accordance with some embodiments.

Figure 27 shows an insert liner that is configured to insert into the opening for the viewport and that includes a vertical surface that substantially covers the surface of the window that is exposed through the opening, in accordance with some embodiments.

Figure 28 shows an insert liner that is configured to insert into the opening for the viewport and that includes a first vertical surface that substantially covers the surface of the window that is exposed through the opening, and that includes a second vertical surface that blocks off the opening at the inner surface of the chamber wall, in accordance with some embodiments.

Figure 29 shows an insert plug configured to just fit within the opening for the viewport and provide a continuation of a profile of the inner surface of the wall of the chamber, in accordance with some embodiments.

Figure 30 shows a flowchart of a method for plasma processing of a substrate, in accordance with some embodiments.

Figure 31 shows a flowchart of a method for manufacturing an insert liner for a plasma process chamber, in accordance with some embodiments.

Figure 32 shows an example exhaust baffle assembly positioned within the exhaust channel of the exhaust assembly, in accordance with some example embodiments.

Figure 33 shows the exhaust baffle assembly positioned within the exhaust channel proximate to the chamber, in accordance with some embodiments.

Figure 34 shows a vertical cross-section view through the chamber, the exhaust assembly, and the exhaust baffle assembly, with the exhaust baffle assembly positioned at the exhaust exit from the chamber, in accordance with some embodiments.

Figure 35 shows an isometric view of the example exhaust baffle assembly, in accordance with some embodiments.

Figure 36 shows a front view of the exhaust baffle assembly, in accordance with some embodiments.

Figure 37 shows a side view of the exhaust baffle assembly, in accordance with some embodiments.

Figure 38 shows a flowchart of a method for plasma processing of a substrate, in accordance with some embodiments.

Figure 39 shows a flowchart of a method for manufacturing an exhaust baffle assembly for use in a plasma process system, in accordance with some embodiments.

## Detailed Description

In the following description, numerous specific details are set forth in order to provide a thorough understanding of the present invention. It will be apparent, however, to one skilled in the art that the present invention may be practiced without some or all of these specific details. In other instances, well known process operations have not been described in detail in order not to unnecessarily obscure the present invention.

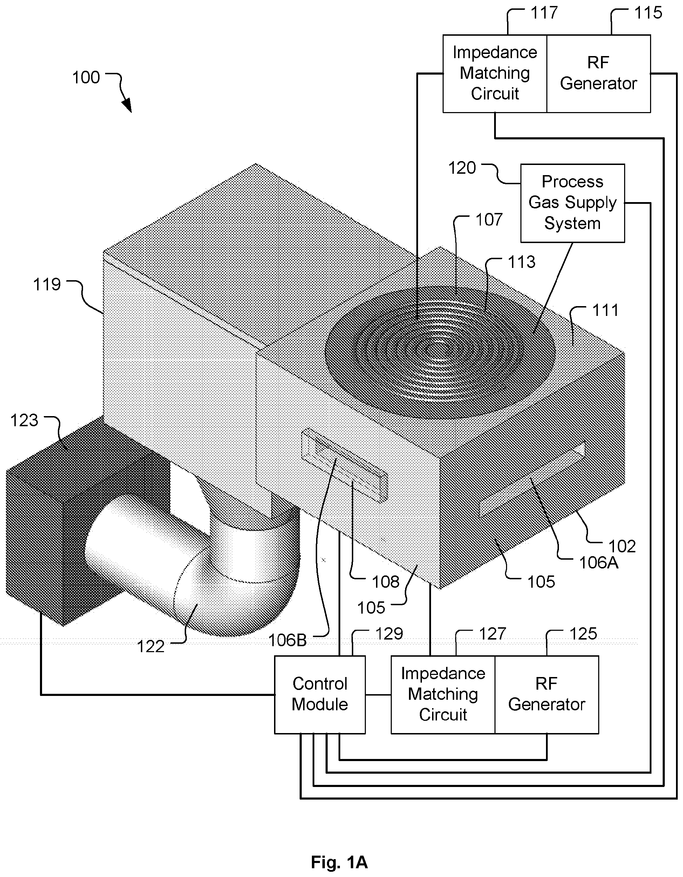

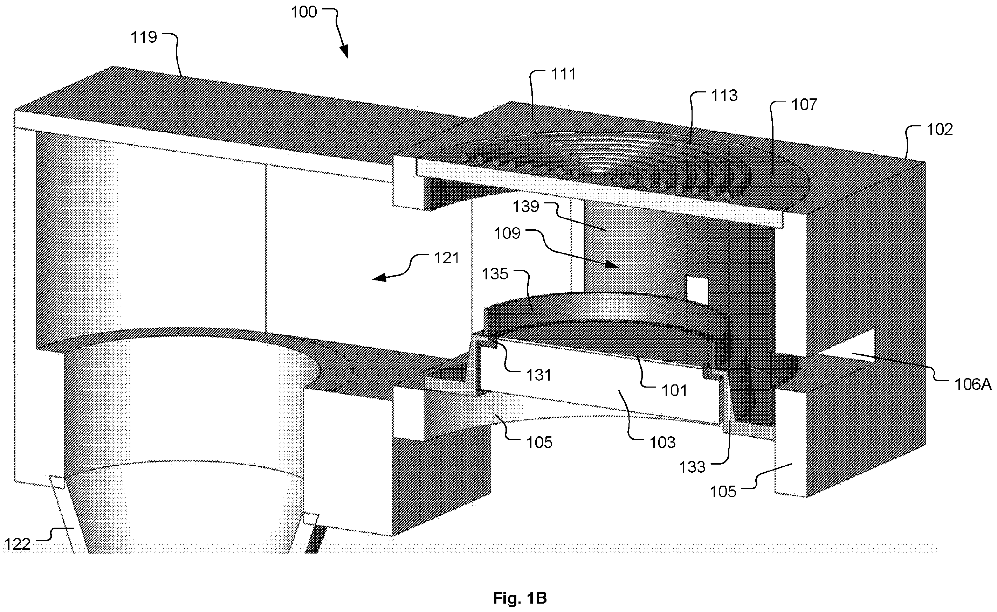

Figure 1A shows an example system 100 for performing a plasma process on a substrate 101, in accordance with some embodiments. Figure 1B shows a vertical cross-section view through of a portion of the system 100, in accordance with some embodiments. In some example embodiments, the substrate 101 as referred to herein is a semiconductor wafer. However, it should be understood that in other embodiments, the substrate 101 as referred to herein can be a substrate formed of sapphire, GaN, GaAs or SiC, or other substrate materials, and can include glass panels/substrates, metal foils, metal sheets, polymer materials, or the like. Also, in various embodiments, the substrate 101 as referred to herein may vary in form, shape, and/or size. For example, in some embodiments, the substrate 101 may correspond to a 200 mm (millimeters) semiconductor wafer, a 300 mm semiconductor wafer, or a 450 mm semiconductor wafer. Also, in some embodiments, the substrate 101 may correspond to a non-circular substrate, such as a rectangular substrate for a flat panel display, or the like, among other shapes.

The system 100 includes a plasma process chamber 102 for performing a plasma-based process on the substrate 101. The plasma-based process can be essentially any process in which constituents of a plasma are used to modify characteristics of the substrate 101 in a prescribed and controlled manner. In various embodiments, the plasma-based process is an etching process to remove material from the substrate 101, or a deposition process to add material to the substrate 101, or a combination of etching and deposition processes.

The chamber 102 includes walls 105 that enclose an interior of the chamber 102. In some embodiments, the walls 105 are formed of an electrically conductive material and have an electrical connection to a reference ground potential. The walls 105 can include a number of openings/ports configured for various purposes. For example, walls 105 of the example chamber 102 include an opening 106A for transfer of the substrate 101 into and out of the chamber 102. In some embodiments, the opening 106A interfaces with a slit-valve that provides for passage of a robotic substrate handling device into the chamber 102 through the opening 106A and that provides for sealing of the opening 106A when the chamber 102 is in operation. Also, the walls 105 of the example chamber 102 include an opening 106B that provides a viewport for viewing of a plasma processing region 109 within the chamber 102 either manually or by various equipment, such as an optical monitoring device or optical endpoint detection device, among other devices. The opening 106B can be covered in a sealed manner by a window 108 formed of an optically transparent material, such as glass or plastic, or other similar material.

A substrate support structure 103 is present within the interior of the chamber 102 and is configured to hold the substrate 101 during performance of a plasma process within the chamber 102. In some embodiments, the substrate support structure 103 is an electrostatic chuck configured to generate an electrostatic field that holds the substrate 101. In various embodiments, the substrate support structure 103 can include various components and systems. For example, the substrate support structure 103 can be configured to include one or more electrodes for transmission of radiofrequency power and/or for generation of bias voltage. Also, the substrate support structure 103 can include one or more temperature control devices, such as heaters and/or cooling channels. Also, the substrate support structure 103 can include a number of lifting pins and associated mechanics to facilitate movement of the substrate 101 between a robotic handling device and the substrate support structure 103. Also, the substrate support structure 103 can include a number of sensors and/or probes for measuring temperature and for measuring electrical parameters, such as voltage and/or current.

A top window structure 107 is positioned above the substrate support structure 103 and separated from the substrate support structure 103 such that the plasma processing region 109 is present between the substrate support structure 103 and the top window structure 107. In some embodiments, the walls 105 include an upper flange structure 111 configured to receive and support the top window structure 107. The top window structure 107 is formed of a material through which radiofrequency (RF) signals can be transmitted, such as quartz or ceramic, among others. Also, in some embodiments, the top window structure 107 is configured to function as a gas distribution plate. For example, the top window structure 107 can include a number of gas input ports, an arrangement of internal fluid channels fluidly connected to the gas input ports, and a number of gas output ports fluidly connected to the internal fluid channels. Process gas(es) supplied to the gas input ports of the top window structure 107 are flowed through the internal fluid channels to the gas output ports of the top window structure 107 where the process gas(es) are dispensed into the plasma processing region 109. The gas output ports and internal fluid channels of the top window structure 107 can be configured to dispense process gas(es) into the plasma processing region 109 in a spatially controlled manner.

A coil assembly 113 is positioned above the top window structure 107. The coil assembly 113 is connected to a radiofrequency (RF) generator 115 through an impedance matching circuit 117. The coil assembly 113 is configured to transmit RF power through the top window structure 107 to the plasma processing region 109 when RF power is transmitted to the coil assembly 113 from the RF generator 115 by way of the impedance matching circuit 117. The impedance matching circuit 117 includes an arrangement of capacitors and inductors configured to ensure that an impedance seen by the RF generator 115 at the input of the impedance matching circuit 117 is sufficiently close to an output impedance for which the RF generator 115 is designed to operate (usually 50 Ohm), so that RF power generated and transmitted by the RF generator 115 will be transmitted into the plasma processing region 109 in an efficient manner, e.g., without unacceptable or undesirable reflection.

In various embodiments, the RF generator 115 can include one or more RF signal generators operating at one or more frequencies. Multiple RF signal frequencies can be supplied to the coil assembly 113 at the same time. In some embodiments, signal frequencies output by the RF generator 115 are set within a range extending from 1 kHz (kiloHertz) to 100 MHz (megaHertz). In some embodiments, signal frequencies output by the RF generator 115 are set within a range extending from 400 kHz to 60 MHz. In some embodiments, the RF generator 115 is set to generate RF signals at frequencies of 2 MHz, 27 MHz, 13.56 MHz, and 60 MHz. In some embodiments, the RF generator 115 is set to generate one or more high frequency RF signals within a frequency range extending from about 2 MHz to about 60 MHz, and generate one or more low frequency RF signals within a frequency range extending from about 100 kHz to about 2 MHz. It should be understood that the above-mentioned RF signal frequency ranges are provided by way of example. In practice, the RF generator 115 can be configured to generate essentially any RF signal having essentially any frequency as needed to generate the plasma within the plasma processing region 109. Additionally, the RF generator 115 can include frequency-based filtering, i.e., high-pass filtering and/or low-pass filtering, to ensure that specified RF signal frequencies are transmitted to the coil assembly 113.

The chamber 102 is connected to a process gas supply system 120, such that one or more process gas(es) can be supplied in a controlled manner to the plasma processing region 109. It should be understood that the process gas supply system 120 includes one or more process gas sources and an arrangement of valves and mass flow controllers to enable provision of the one or more process gas(es) to the plasma processing region 109 at a controlled flow rate and a controlled flow time. During operation, the process gas supply system 120 operates to deliver the one or more process gas(es) to the plasma processing region 109, and RF power is delivered from the RF generator 115 to the coil assembly 113, such that the RF power generates an electromagnetic field within the plasma processing region 109 so as to transform the one or more process gas(es) within the plasma processing region 109 into the plasma. Then, reactive constituents of the plasma, such as ions and/or radicals, can interact with portions of the substrate 101.

An exhaust assembly 119 is connected to the plasma process chamber 102. The exhaust assembly 119 includes an exhaust channel 121 that has an interior flow region fluidly connected to the plasma processing region 109. The exhaust assembly 119 also includes a pump 123 fluidly connected to the interior flow region of the exhaust channel 121. In some embodiments, the exhaust assembly 119 includes ducting/tubing 122 to fluidly connect the exhaust channel 121 to the pump 123. During operation, the pump 123 operates to draw exhaust gases and process byproduct materials from the plasma processing region 109, through the interior flow region of the exhaust channel 121, through the ducting/-tubing 122, to the pump 123.

In some embodiments, the substrate support structure 103 is configured to receive bias RF power from a bias RF generator 125 through an impedance matching circuit 127 to provide for generation of a bias voltage on the substrate support structure 103 (and on the substrate 101 itself) in order to attract ions from the plasma within the plasma processing region 109 toward the substrate 101 held on the substrate support structure 103. The impedance matching circuit 127 includes an arrangement of capacitors and inductors configured to ensure that an impedance seen by the RF generator 125 at the input of the impedance matching circuit 127 is sufficiently close to an output impedance for which the RF generator 125 is designed to operate (usually 50 Ohm), so that RF power generated and transmitted by the RF generator 125 will be transmitted to the substrate support structure 103 in an efficient manner, e.g., without unacceptable or undesirable reflection.

In various embodiments, the bias RF generator 125 can include one or more RF signal generators operating at one or more frequencies. Multiple RF signal frequencies can be supplied to the substrate support structure 103 at the same time. In some embodiments, signal frequencies output by the bias RF generator 125 are set within a range extending from 1 kHz to 100 MHz. In some embodiments, signal frequencies output by the bias RF generator 125 are set within a range extending from 400 kHz to 60 MHz. In some embodiments, the bias RF generator 125 is set to generate RF signals at frequencies of 2 MHz, 27 MHz, 13.56 MHz, and 60 MHz. In some embodiments, the bias RF generator 125 is set to generate one or more high frequency RF signals within a frequency range extending from about 2 MHz to about 60 MHz, and generate one or more low frequency RF signals within a frequency range extending from about 100 kHz to about 2 MHz. It should be understood that the above-mentioned RF signal frequency ranges are provided by way of example. In practice, the bias RF generator 125 can be configured to generate essentially any RF signal having essentially any frequency as needed to generate a prescribed bias voltage at the substrate 101. Additionally, the bias RF generator 125 can include frequency-based filtering, i.e., high-pass filtering and/or low-pass filtering, to ensure that specified RF signal frequencies are transmitted to the substrate support structure 103.

The system 100 can also include a control module 129. In some embodiments, the control module 129 is implemented as a combination of computer hardware and software. The control module 129 can be connected and configured to provide for control of the process gas supply system 120, the RF generator 115 and associated impedance matching circuit 117, the RF generator 125 and associated impedance matching circuit 127, the pump 123, and essentially any other controllable component of the system 100, such as temperature control devices and substrate lifting pins within the substrate support structure 103, among other components. Also, the control module 129 can be connected and configured to receive signals from various components, sensors, and monitoring devices within the system 100. For example, the control module 129 can be connected and configured to receive electrical voltage and/or current measurement signals from the substrate support structure 103. And, the control module 129 can be connected and configured to receive temperature and pressure measurement signals from within the plasma processing region 109. It should be understood that the control module 129 can be connected and configured to control essentially any active device, i.e., controllable device, within the system 100. And, it should be understood that the control module 129 can be connected and configured to monitor essentially any physical and/or electrical state, condition, and/or parameter at essentially any location within the system 100. The control module 129 can also be configured to direct operation of various components within the system 100 in a synchronous manner to perform a prescribed plasma processing operation on the substrate 101. For example, the control module 129 can be configured to operate the system 100 by executing process input and control instructions/programs. The process input and control instructions/programs may include process recipes having time-dependent directions for parameters such as power levels, timing parameters, process gases, mechanical movement of the substrate 101, etc., as needed to obtain a desired process result on the substrate 101.

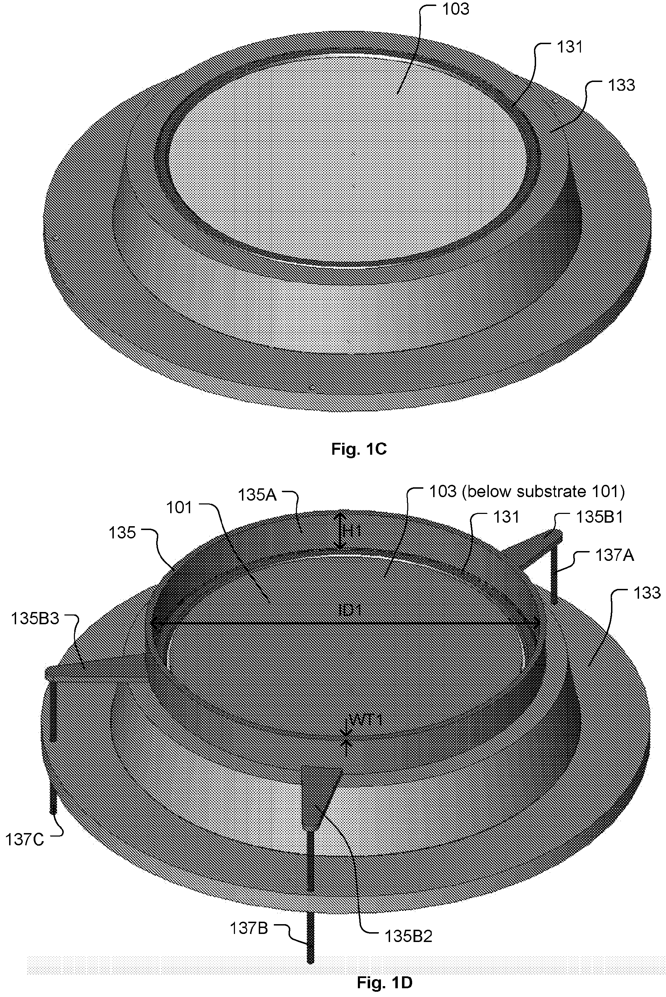

Figure 1C shows an isometric view of the substrate support structure 103 with an edge ring structure 131 and a ground ring structure 133 positioned to surround the substrate support structure 103, in accordance with some example embodiments. A vertical cross-section view of the edge ring structure 131 and the ground ring structure 133 is also shown in Figure 1B, in accordance with some example embodiments. In some embodiments, the edge ring structure 131 is configured to surround the substrate support structure 103 at a location immediately adjacent to the substrate support structure 103. The edge ring structure 131 provides a uniform RF field to support uniformity in plasma generation within the plasma processing region 109. In some embodiments, the edge ring structure 131 is formed of ceramic material. In some embodiments, the edge ring structure 131 is formed of aluminum oxide. In some embodiments, the edge ring structure 131 is formed of silicon carbide. It should be understood that in various embodiments, the edge ring structure 131 can be formed of essentially any material that has sufficiently high electrical resistance to maintain electrical separation between the substrate support structure 103 and the ground ring structure 133, and that is chemically compatible with materials that will be present within the plasma processing region 109 during operation of the chamber 102, and that has mechanical and thermal stability in the presence of temperatures and pressures that will be present within the plasma processing region 109 during operation of the chamber 102.

The ground ring structure 133 is formed of an electrically conductive material and is electrically connected to the chamber walls 105, so as to be electrically connected to the reference ground potential. In some embodiments, the ground ring structure 133 is formed of a metallic material, such as aluminum or stainless steel, or alloy thereof, among others. It should be understood that in various embodiments the ground ring structure 133 can be formed of essentially any material that has sufficiently high electrical conductivity to provide a surface at the reference ground potential around the substrate support structure 103, and that is chemically compatible with materials that will be present within the plasma processing region 109 during operation of the chamber 102, and that has mechanical and thermal stability in the presence of temperatures and pressures that will be present within the plasma processing region 109 during operation of the chamber 102.

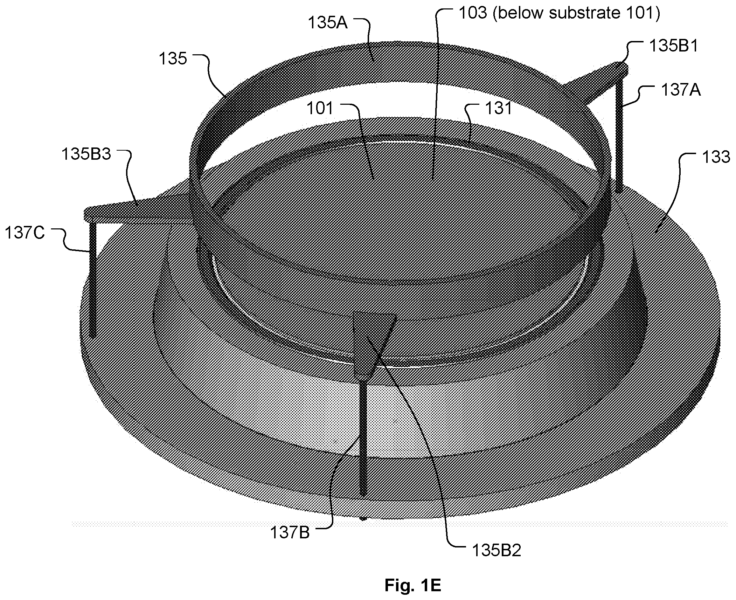

Figure 1D shows an isometric view of the substrate support structure 103 with the edge ring structure 131 and the ground ring structure 133 positioned to surround the substrate support structure 103, and with a focus ring structure 135 positioned above and around a upper surface of the substrate support structure 103, in accordance with some example embodiments. A vertical cross-section view of the focus ring structure 135 is shown in Figure 1B, in accordance with some example embodiments. In some embodiments, the focus ring structure 135 is positioned within the plasma process chamber 102 to surround the plasma processing region 109. The focus ring structure 135 includes a ring portion 135A configured as a right circular hollow cylinder of height H1, inner diameter ID1, and wall thickness WT1. The focus ring structure 135 can also include three radial extension structures 135B1, 135B2, 135B3 configured to extend radially outward from an outer surface of the ring portion 135A. The three radial extension structures 135B1, 135B2, 135B3 are spaced apart along an outer perimeter of the ring portion 135A in a manner that provides for stable vertical movement of the ring portion 135A by way of the three radial extension structures 135B1, 135B2, 135B3. The three radial extension structures 135B1, 135B2, 135B3 are configured to engage with three respective lifting components 137A, 137B, 137C to provide for raising and lowering of the focus ring structure 135 relative to the substrate support structure 103 when the focus ring structure 135 is placed within the plasma process chamber 102. For example, the focus ring structure 135 can be raised relative to the substrate support structure 103 to provide for placement of the substrate 101 on the substrate support structure 103 and to provide for removal of the substrate 101 from the substrate support structure 103. Figure 1E shows the configuration of Figure 1D with the focus ring structure 135 in the raised position relative to the substrate support structure 103, in accordance with some example embodiments. During processing of the substrate 101, the focus ring structure 135 can be lowered relative to the substrate support structure 103 to position the focus ring structure 135 close to a top surface of the substrate 101, such as shown in Figure 1D.

In some embodiments, the focus ring structure 135 is configured to assist with focusing of ions, generated within the plasma within the plasma processing region 109, onto the surface of the substrate 101 held on the substrate support structure 103. The focusing of ions provided by the focus ring structure 135 can increase process uniformity across the substrate 101 and at the edge of the substrate 101. In some embodiments, the focus ring structure 135 is formed of ceramic material. In some embodiments, the focus ring structure 135 is formed of aluminum oxide. In some embodiments, the focus ring structure 135 is formed of silicon carbide. It should be understood that in various embodiments, the focus ring structure 135 can be formed of essentially any material that has appropriate electrical properties to enable focusing of ions toward the substrate 101 from the plasma within the plasma processing region 109 during operation of the chamber 102, and that is chemically compatible with materials that will be present within the plasma processing region 109 during operation of the chamber 102, and that has mechanical and thermal stability in the presence of temperatures and pressures that will be present within the plasma processing region 109 during operation of the chamber 102.

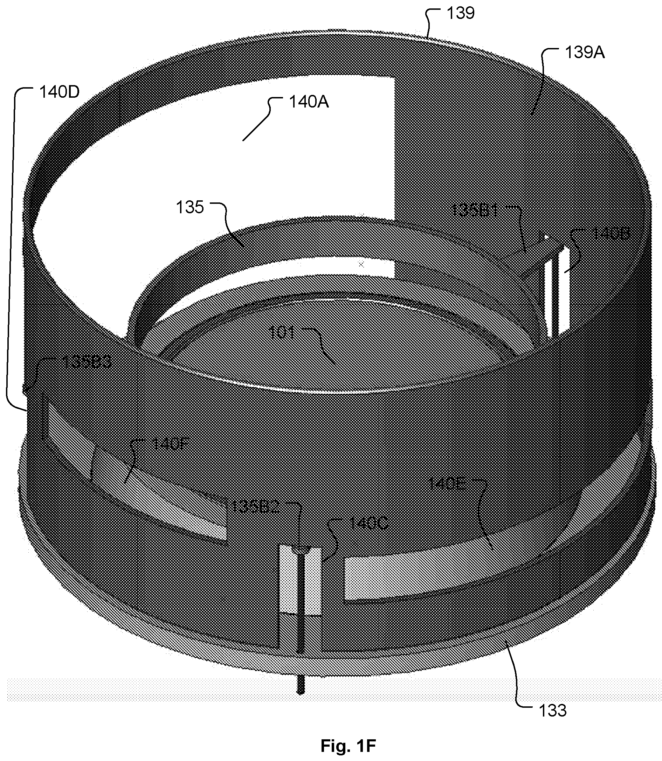

In some embodiments, a liner structure 139 is positioned within the plasma process chamber 102. Figure 1F shows an isometric view of an example of the liner structure 139 positioned on the ground ring structure 133, in accordance with some example embodiments. In some embodiments, the liner structure 139 is configured to physically contact the ground ring structure 133. The liner structure 139 is configured to extend around at least a portion of the plasma processing region 109 within the plasma process chamber 102. The liner structure 139 has an inner surface 139A that faces the plasma processing region 109. In some embodiments, the liner structure 139 is formed of ceramic material. In some embodiments, the liner structure 139 is formed of aluminum oxide. In some embodiments, the liner structure 139 is formed of silicon carbide. It should be understood that in various embodiments, the liner structure 139 can be formed of essentially any material that has appropriate electrical properties compatible with generation of the plasma within the plasma processing region 109 during operation of the chamber 102, and that is chemically compatible with materials that will be present within the plasma processing region 109 during operation of the chamber 102, and that has mechanical and thermal stability in the presence of temperatures and pressures that will be present within the plasma processing region 109 during operation of the chamber 102.

In some embodiments, the liner structure 139 is configured to substantially cover and/or shield inner surfaces of the walls 105 of the chamber 102 from materials that will be present within the plasma processing region 109 during operation of the chamber 102. More specifically, the liner structure 139 can be formed as a right circular hollow cylinder and can include a number of cutaway portions, i.e., openings, where components can extend through the liner structure 139 and/or where a view is to be provided through the liner structure 139. For example, the liner structure 139 includes an opening 140A to expose the plasma processing region 109 to the exhaust channel 121. Also, the liner structure 139 includes openings 140B, 140C, and 140D to provide for unobstructed vertical movement of the three radial extension structures 135B1, 135B2, 135B3 of the focus ring structure 135. Also, the liner structure 139 includes an opening 140E at the location of the opening 106A within the wall 105 of the chamber 102 to provide for insertion of the substrate 101 into the chamber 102 and removal of the substrate 101 from the chamber 102. Also, the liner structure 139 includes an opening 140F at the location of the opening 106B within the wall 105 of the chamber 102 to provide an unobstructed view of the interior of the chamber 102.

During processing of the substrate 101 within the chamber 102, non-volatile byproduct materials and/or low-volatility byproduct materials can be generated within the plasma processing region 109. In some processes, abundant amounts of these non-volatile and/or low-volatility byproduct materials can be generated. For example, in some processes, a lead zirconate titanate (PZT) film present on the substrate 101, e.g., silicon substrate, is etched with corresponding generation of large amounts of non-volatile and/or low-volatility byproduct materials. And, in another example, in some processes, a platinum-based film present on the substrate 101 is etched with corresponding generation of large amounts of non-volatile and/or low-volatility byproduct materials. Also, it should be understood that other plasma-based processes performed on the substrate 101 can have corresponding generation of large amounts of non-volatile and/or low-volatility byproduct materials. The non-volatile and/or low-volatility byproduct materials can adhere to surfaces of various components within the chamber 102. However, the non-volatile and/or low-volatility byproduct materials can have poor adhesion or poor retention with the surfaces of the various components within the chamber 102, leading to flaking-off and/or peeling-off of the non-volatile and/or low-volatility byproduct materials from the surfaces of the various components within the chamber 102. The non-volatile and/or low-volatility byproduct materials that flake off or peel off of surfaces within the chamber 102 can cause serious problems, such as increased particle counts on the substrate 101 that in turn cause device failure, which leads to higher yield loss. The non-volatile and/or low-volatility byproduct materials that flake off or peel off can also cause problems when they settle on the top surface of the substrate support structure 103 or on a window used for optical viewing of the plasma processing region 109, such as for optical endpoint detection. The non-volatile and/or low-volatility byproduct materials that flake off or peel off can also cause problems when they get sucked into the exhaust pump and associated exhaust mechanical systems.

Also, with the generation of non-volatile and/or low-volatility byproduct materials that tend to flake off or peel off of the surfaces of the components within the chamber 102, it can be necessary for the chamber 102 to be frequently taken out of service for cleaning of the non-volatile and/or low-volatility byproduct materials before they build up to a level at which flaking and/or peeling is likely to occur. It should be understood that having to frequently take the chamber 102 out of service for cleaning reduces substrate 101 processing throughput. Additionally, the non-volatile and/or low-volatility byproduct materials can be resistant to waferless auto clean processes, which means that manual opening and cleaning of the chamber 102 can be required, which is time-consuming and expensive. Moreover, components within the chamber 102 may be formed of aluminum-based material with an exterior coating, which may not be resilient to frequent cleaning processes. For example, some components within the chamber 102 may be formed of anodized aluminum and/or have a coating, such as a yttria coating. The aggressive cleaning required to remove the non-volatile and/or low-volatility byproduct materials from these components can strip off the anodization/coating, requiring the components to be re-anodized/re-coated after cleaning, which leads to increased expense. Also, each time a component has to be re-anodized/re-coated, base material of the component is consumed, which shortens the useful lifetime of the component, i.e., each component can be subjected to a limited number of re-anodization/re-coating cycles. And, each time a component has to be aggressively cleaning and/or re-anodized/re-coated, there is a possibility that the component will be damaged and become unusable, which causes further expense.

Components and processes are disclosed herein for managing non-volatile and/or low-volatility byproduct materials that are generated within the plasma processing region 109 during performance of various plasma-based processes on the substrate 101. In some embodiments, various components within the chamber 102 are formed of ceramic material and are formed to have a roughened/textured exterior surface. For example, in various embodiments, the top window structure 107, and/or the liner structure 139, and/or the edge ring structure 131 can be formed of ceramic material and can be formed to have a roughened/textured exterior surface in exposure to the plasma processing region 109. The roughened/textured exterior surface promotes adhesion and retention of the non-volatile and/or low-volatility byproduct materials. It should be appreciated that with the non-volatile and/or low-volatility byproduct materials adhered to and retained on the surfaces of the components with the chamber 102, it is possible to operate the chamber 102 for a longer time between cleanings. For example, use of ceramic components having roughened/textured exterior surfaces within the chamber 102 can increase the mean-time-between-cleaning (MTBC) of the chamber 102 by up to 400%, or more, by not allowing the non-volatile and/or low-volatility byproduct materials to flake off or peel off onto the substrate 101 and substrate support structure 103. Therefore, use of ceramic components having roughened/textured exterior surfaces within the chamber 102 can lower defect density on the substrate 101, enhance productivity, i.e., extend chamber 102 availability and increase substrate 101 processing throughput by the chamber 102, and improve component lifetime by reducing the frequency of component cleaning and component reconditioning cycles.

Also, use of uncoated, ceramic material for various components within the chamber 102, such as the top window structure 107, and/or the liner structure 139, and/or the edge ring structure 131, can provide for better control of surface roughness as compared to anodized/coated materials. More specifically, because anodization/coating of a component has to be done after completion of the surface roughening process on the component, it is difficult to predict and control how application of the anodization/coating affects the previously applied surface roughness of the component. For example, application of a coating to a surface of a component that has been roughened/texturized may adversely smooth the surface. Also, application of a coating on a surface of a component after the surface has been roughened/texturized can cause damage to the component by introducing stresses over the surface of the component that can lead to cracking of the component. Additionally, ceramic components are more resilient than non-ceramic components after many refurbishment/cleaning cycles, because less material of the ceramic component is consumed during the refurbishment/cleaning process and subsequent re-roughening/re-texturizing process. The resilience of ceramic components to aggressive refurbishment/cleaning processes provides for reduced costs, because the bulk ceramic of the component can endure many refurbishment/cleaning/re-roughening/re-texturizing cycles.

In some embodiments, various components within the chamber 102, or portions thereof, such as the lower surface of the top window structure 107 that is exposed to the plasma processing region 109, and/or the liner structure 139, and/or the edge ring structure 131, by way of example, are subjected to a surface roughening/texturizing process to have a surface roughness average (Ra) within a range extending from about 150 microinches to about 500 microinches. In some embodiments, various components within the chamber 102, or portions thereof, such as the lower surface of the top window structure 107 that is exposed to the plasma processing region 109, and/or the liner structure 139, and/or the edge ring structure 131, by way of example, are subjected to a surface roughening/texturizing process to have a surface roughness average (Ra) of about 500 microinches. The surface roughness average (Ra) is the arithmetic average of the absolute values of the surface profile height deviations from the surface mean line, recorded within the evaluation length along the surface, as shown in Equation 1:

$$\text{Equation 1.} \quad Ra = \frac{1}{L} \int_0^L |Z(x)| \, dx,$$

where L = evaluation length, Z(x) = the profile height function.

In various embodiments, a surface-textured plasma process chamber component is disclosed. The surface-textured plasma process chamber component includes a ceramic component configured for placement within a plasma process chamber, such as within the chamber 102, by way of example. In some embodiments, the ceramic component of the surface-textured plasma process chamber component is formed of aluminum oxide. In some embodiments, the ceramic component of the surface-textured plasma process chamber component is formed of silicon carbide. It should be understood, however, that in various embodiments, the ceramic component of the surface-textured plasma process chamber component can be formed of a ceramic material other than aluminum oxide or silicon carbide.

The ceramic component includes at least one roughened surface oriented to be in exposure to plasma process byproduct material when the ceramic component is placed within the plasma process chamber during operation of the plasma process chamber. The at least one roughened surface is configured to promote adherence of the plasma process byproduct material to the ceramic component. The surface roughness average (Ra) of the at least one roughened surface is configured to promote adhesion of non-volatile and/or low-volatility plasma process byproduct materials to the at least one roughened surface. In some embodiments, the at least one roughened surface has a surface roughness average (Ra) within a range extending from about 150 microinches to about 500 microinches. In some embodiments, the at least one roughened surface has a surface roughness average (Ra) of about 500 microinches. Also, in some embodiments, a bare ceramic material of which the ceramic component is formed is exposed over the at least one roughened surface of the ceramic component.

In some embodiments, improved adhesion of non-volatile and/or low-volatility byproduct materials to the at least one roughened surface is affected on a molecular level through enhancement of van der Waals forces. In contrast to the at least one roughened surface, surfaces having low surface roughness, i.e., smooth component surfaces, create high surface tension energy that serves to reject adhesion of plasma process byproduct ions and/or molecules. In some embodiments, the at least one roughened surface that is configured to promote adherence of the plasma process byproduct material to the ceramic component can have high contact angles and lower surface tension to promote adhesion of plasma process byproduct ions and/or molecules. Also, the at least one roughened surface of the ceramic component provides for less flaking-off and/or peeling-off of the non-volatile and/or low-volatility byproduct materials from the ceramic component.

In some embodiments, the at least one roughened surface of the ceramic component is roughened by a media blasting process. In other words, the ceramic component is subjected to a media blasting process to form the at least one roughened surface on the ceramic component. In various embodiments, the media blasting process can be defined and performed to increase the surface roughness, create high contact angles over the surface, and increase an overall surface area of the surface of the component that is subjected to the media blasting process. In various embodiments, the media blasting process can be defined and performed to impact the ceramic component where the at least one roughened surface is to be created with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite, among other types of media. It should be understood that the media blasting process provides for substantially even application of a prescribed roughness/texture over a target surface area of a component. Also, in some embodiments, the media blasting process can be performed in conjunction with a patterned mask to produce a prescribed surface topography over a target surface area of a component. For example, the patterned mask can include a distribution of open areas through which the media blasting material can reach the surface of the component when the patterned mask is positioned over the component. The media blasting material will remove some of the component material within the open areas of the patterned mask, while not removing component material protected by the patterned mask, thereby producing the prescribed surface topography over the target surface area of the component.

It should be appreciated that use of components formed of non-coated ceramic having roughened/textured exterior surface(s) improves the ability to refurbish those components. For example, to refurbish such a component, a media blasting process can be performed (or re-performed) on the component to both clean the component and re-roughen/re-texture the exterior surface of the component. The ability to refurbish components by media blasting without re-coating of the component avoids the expense of having to apply the coating to the component, and avoids generation of coating-induced stresses in the component that could lead to mechanical failure of the component. Additionally, components can be refurbished many times, e.g., twenty or more times, by the media blasting process without compromising the mechanical integrity of the component through removal of too much component material. Also, in addition to the media blasting process or as an alternative to the media blasting process, the at least one roughened surface can be formed at least in part by performing a knurling process on the ceramic component prior to firing of the ceramic component.

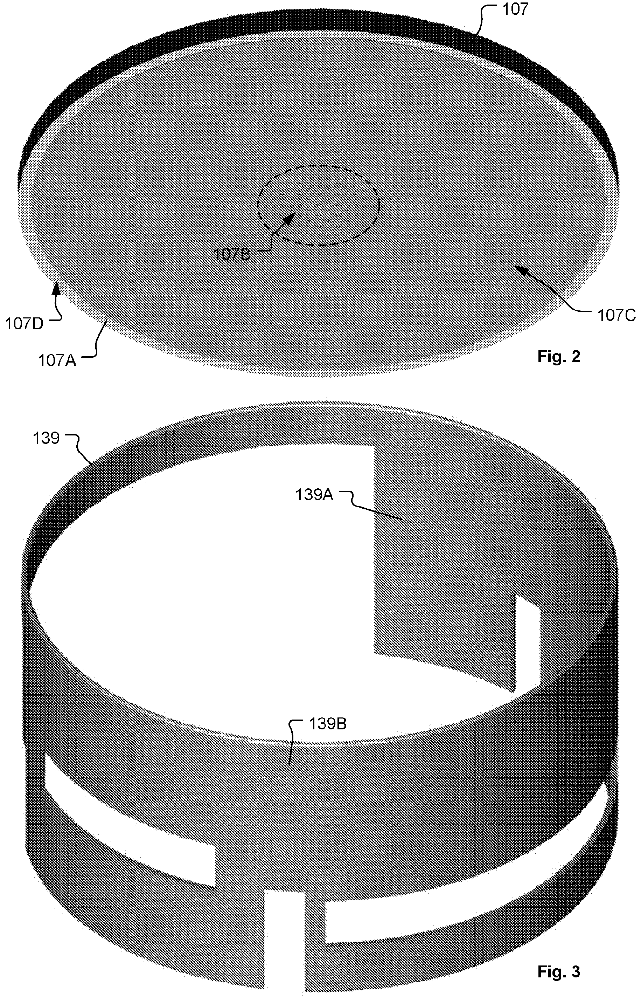

In some embodiments, the above-mentioned surface-textured plasma process chamber component is the top window structure 107 of the chamber 102. Figure 2 shows an isometric view of a bottom surface 107A of the top window structure 107, in accordance with some embodiments. The top window structure 107 is a ceramic component that is installed within the chamber 102 with the bottom surface 107A oriented to face the plasma processing region 109. As with the ceramic component discussed above, in various embodiments, the top window structure 107 can be formed of aluminum oxide, silicon carbide, or essentially any other ceramic material that is chemically, mechanically, thermally, and electrically compatible for service as the top window structure 107 during operation of the chamber 102. Also, in some embodiments, the top window structure 107 is configured to function as a gas distribution plate to provide for supply of process gas(es) to the plasma processing region 109. In these embodiments, the top window structure 107 can include an internal arrangement of gas supply channels configured to direct a flow of process gas(es) from one or more input ports located on the exterior of the top window structure 107, such as on a top surface or edge surface of the top window structure 107, to one or more output ports 107B located on the bottom surface 107A of the top window structure 107. In this manner, process gas(es) can be flowed through the top window structure 107 and into the plasma processing region 109, with the top window structure 107 functioning to spatially distribute the supply of process gas(es) into the plasma processing region 109 based on the spatial locations and flow states (open or closed) of the one or more output ports 107B.

The bottom surface 107A of the top window structure 107 includes at least one roughened surface 107C oriented to be in exposure to plasma process byproduct material when the top window structure 107 is placed within the chamber 102 during operation of the chamber 102. In some embodiments, the bottom surface 107A of the top window structure 107 includes an outer peripheral ring-shaped area 107D configured to engage with a seal component when the top window structure 107 is installed within the chamber 102. In some embodiments, the outer peripheral ring-shaped area 107D is smoothed to have a surface roughness average (Ra) of about 20 microinches. In some embodiments, the region of the bottom surface 107A inside of the outer peripheral ring-shaped area 107D is the at least one roughened surface 107C that is roughened/textured to have a surface roughness average (Ra) within a range extending from about 150 microinches to about 500 microinches. In some embodiments, the at least one roughened surface 107C is roughened/textured to have a surface roughness average (Ra) of about 500 microinches. In some embodiments, the top window structure 107 remains in the form of an uncoated, bare ceramic component after formation of the at least one roughened surface 107C on the bottom surface 107A and during use of the top window structure 107 within the chamber 102.

In some embodiments, the above-mentioned surface-textured plasma process chamber component is the liner structure 139. Figure 3 shows an isometric view of the liner structure 139, in accordance with some embodiments. The liner structure 139 is configured to extend around at least a portion of a plasma processing region 109 within the chamber 102. In some embodiments, the liner structure 139 has an inner surface 139A that is the at least one roughened surface oriented to be in exposure to plasma process byproduct material when the liner structure 139 is placed within the chamber 102 during operation of the chamber 102. In some embodiments, an entirety of the liner structure 139, including the inner surface 139A and an outer surface 139B is roughened/textured to promote adherence of the plasma process byproduct material to the liner structure 139.

In some embodiments, the liner structure 139 is a ceramic component that is installed within the chamber 102 to cover and protect the inner walls of the chamber 102. As with the ceramic component discussed above, in various embodiments, the liner structure 139 can be formed of aluminum oxide, silicon carbide, or essentially any other ceramic material that is chemically, mechanically, thermally, and electrically compatible for service as the liner structure 139 during operation of the chamber 102. In some embodiments, the liner structure 139 remains in the form of an uncoated, bare ceramic component after formation of the at least one roughened surface on the liner structure 139 and during use of the liner structure 139 within the chamber 102. In some embodiments, the liner structure 139 is roughened/textured to have a surface roughness average (Ra) within a range extending from about 150 microinches to about 500 microinches. In some embodiments, the liner structure 139 is roughened/textured to have a surface roughness average (Ra) of about 500 microinches.

In some embodiments, the above-mentioned surface-textured plasma process chamber component is a ring structure for installation within the chamber 102, where the ring structure is configured to circumscribe the substrate support structure 103 within the chamber 102.

In various embodiments, the ring structure can be one or both of the focus ring structure 135 and the edge ring structure 131, by way of example. The ring structure is characterized by having at least one process-exposed surface that is one or both of an inner surface of the ring structure and an upper surface of the ring structure. The at least one process-exposed surface is the at least one roughened surface oriented to be in exposure to plasma process byproduct material when the ring structure is placed within the chamber 102 during operation of the chamber 102.

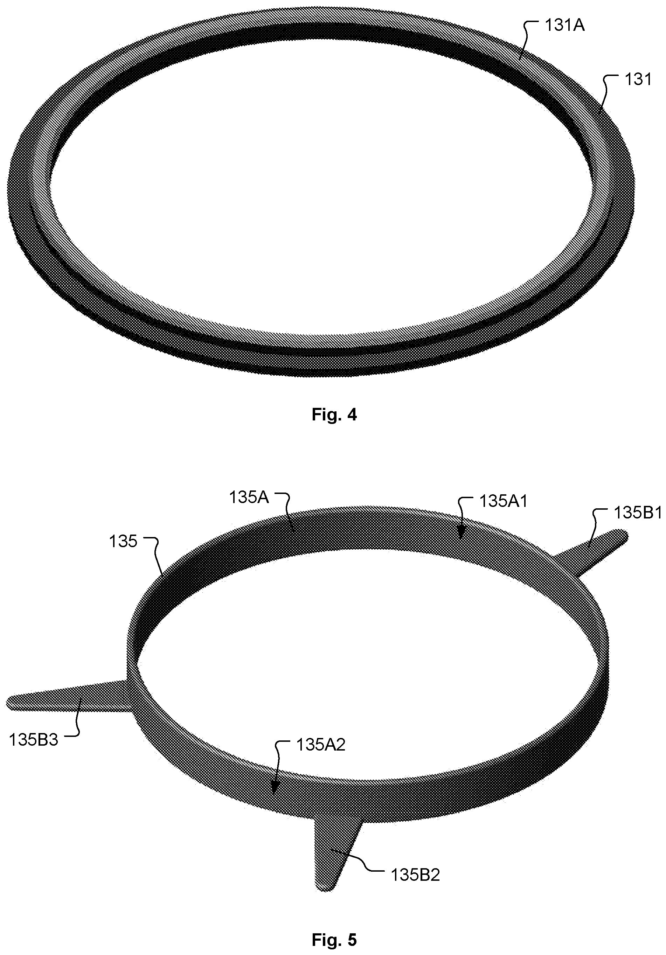

Figure 4 shows an isometric view of the edge ring structure 131, in accordance with some embodiments. The edge ring structure 131 is shown to have a process-exposed surface 131A (lighter gray color in Figure 4) that is the at least one roughened surface oriented to be in exposure to plasma process byproduct material when the edge ring structure 131 is placed within the chamber 102 during operation of the chamber 102. In some embodiments, just the process-exposed surface 131A of the edge ring structure 131 is roughened/textured. However, in some embodiments, portions of the edge ring structure 131 beyond the process-exposed surface 131A can also be roughened/textured to ease fabrication. In some embodiments, the edge ring structure 131 is a ceramic component. As with the ceramic component discussed above, in various embodiments, the edge ring structure 131 can be formed of aluminum oxide, silicon carbide, or essentially any other ceramic material that is chemically, mechanically, thermally, and electrically compatible for service as the edge ring structure 131 during operation of the chamber 102. In some embodiments, the edge ring structure 131 remains in the form of an uncoated, bare ceramic component after formation of the at least one roughened surface on the edge ring structure 131 and during use of the edge ring structure 131 within the chamber 102. In some embodiments, the process-exposed surface 131A of the edge ring structure 131 is roughened/textured to have a surface roughness average (Ra) within a range extending from about 150 microinches to about 500 microinches. In some embodiments, the process-exposed surface 131A of the edge ring structure 131 is roughened/textured to have a surface roughness average (Ra) of about 500 microinches.

Figure 5 shows an isometric view of the focus ring structure 135, in accordance with some embodiments. In some embodiments, an inner surface 135A1 of the ring portion 135A of the focus ring structure 135 is the at least one roughened surface oriented to be in exposure to plasma process byproduct material when the focus ring structure 135 is placed within the chamber 102 during operation of the chamber 102. In some embodiments, in addition to the inner surface 135A1 of the ring portion 135A, the top surfaces of the radial extension structures 135B1, 135B2, 135B3 are also some of the at least one roughened surface oriented to be in exposure to plasma process byproduct material when the focus ring structure 135 is placed within the chamber 102 during operation of the chamber 102. And, in some embodiments, an entirety of the ring portion 135A of the focus ring structure 135 (including both the inner surface 135A1 and an outer surface 135A2 of the ring portion 135A) and the top surfaces of the radial extension structures 135B1, 135B2, 135B3 are the at least one roughened surface oriented to be in exposure to plasma process byproduct material when the focus ring structure 135 is placed within the chamber 102 during operation of the chamber 102. And, in some embodiments, an entire outer surface of the focus ring structure 135, including the ring structure 135A and the radial extension structures 135B1, 135B2, 135B3 constitutes the at least one roughened surface oriented to be in exposure to plasma process byproduct material when the focus ring structure 135 is placed within the chamber 102 during operation of the chamber 102.

In some embodiments, the focus ring structure 135 is a ceramic component. As with the ceramic component discussed above, in various embodiments, the focus ring structure 135 can be formed of aluminum oxide, silicon carbide, or essentially any other ceramic material that is chemically, mechanically, thermally, and electrically compatible for service as the focus ring structure 135 during operation of the chamber 102. In some embodiments, the focus ring structure 135 remains in the form of an uncoated, bare ceramic component after formation of the at least one roughened surface on the focus ring structure 135 and during use of the focus ring structure 135 within the chamber 102. In some embodiments, the process-exposed surface(s) of the focus ring structure 135 is roughened/textured to have a surface roughness average (Ra) within a range extending from about 150 microinches to about 500 microinches. In some embodiments, the process-exposed surface(s) of the focus ring structure 135 is roughened/textured to have a surface roughness average (Ra) of about 500 microinches.

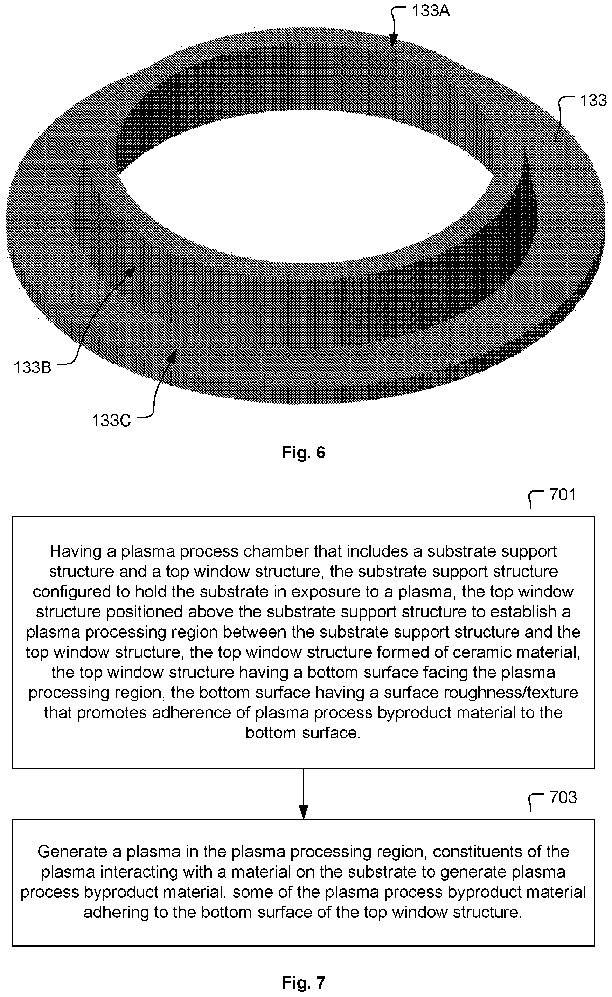

In some embodiments, the above-mentioned surface-textured plasma process chamber component can be a non-ceramic component, such as the ground ring structure 133. Figure 6 shows an isometric view of the ground ring structure 133, in accordance with some embodiments. The ground ring structure 133 includes several process-exposed surfaces 133A, 133B, 133C that are exposed to plasma process byproduct material during operation of the chamber 102. The process-exposed surfaces 133A, 133B, 133C can be roughened/textured in the same manner as described above for the ceramic components to enhance adhesion of the byproduct material to the ground ring structure 133. In some embodiments, the ground ring structure 133 is formed of aluminum, or stainless steel, or of another electrically conductive material that is chemically, mechanically, thermally, and electrically compatible with the plasma processing operations performed with the chamber 102. In some embodiments, the above-mentioned media blasting process can be used to roughen/texturize the process-exposed surfaces 133A, 133B, 133C of the ground ring structure 133. However, the type of media used for the ground ring structure 133 may differ from that used for the ceramic components. For example, media having greater hardness may be used in the media blasting process to roughen/texturize the process-exposed surfaces 133A, 133B, 133C of the ground ring structure 133. In some embodiments, the process-exposed surfaces 133A, 133B, 133C of the ground ring structure 133 is roughened/textured to have a surface roughness average (Ra) within a range extending from about 150 microinches to about 500 microinches. In some embodiments, the process-exposed surfaces 133A, 133B, 133C of the ground ring structure 133 is roughened/textured to have a surface roughness average (Ra) of about 500 microinches. In some embodiments, the process-exposed surfaces 133A, 133B, 133C of the ground ring structure 133 are left uncoated after being subjected to the roughening/texturizing process and during use of the ground ring structure 133 within the chamber 102. However, in some embodiments, the process-exposed surfaces 133A, 133B, 133C of the ground ring structure 133 are coated after being subjected to the roughening/texturizing process, and the coated ground ring structure 133 is then used within the chamber 102. Also, in the embodiments in which the process-exposed surfaces 133A, 133B, 133C of the ground ring structure 133 are to be coated, the roughening/texturizing of the process-exposed surfaces 133A, 133B, 133C that is performed prior to coating can be defined to ensure that a prescribed amount of surface average roughness (Ra) remains on the process-exposed surfaces 133A, 133B, 133C after coating. In some embodiments, the coating applied to the roughened/texturized process-exposed surfaces 133A, 133B, 133C of the ground ring structure 133 is either a yttria coating, or an anodization coating, or another type of coating that is chemically, mechanically, thermally, and electrically compatible with the plasma process performed within the chamber 102.

It should be understood that the embodiments disclosed herein include that of a plasma process chamber, e.g., chamber 102, that includes one or more components having at least one process-exposed surface configured to have a surface roughness/texture that promotes adherence of plasma process byproduct material to the process-exposed surface. Also, it should be understood that the embodiments disclosed herein include operation of the plasma process chamber, that includes the one or more components with roughened/texturized process-exposed surfaces, in a plasma process operation that generates non-volatile and/or low-volatility byproduct materials. For example, Figure 7 shows a flowchart of a method for plasma processing of a substrate, in accordance with some embodiments. The method includes an operation 701 for having a plasma process chamber, i.e., chamber 102, that includes the substrate support structure 103 and the top window structure 107. The substrate support structure 103 is configured to hold the substrate 101 in exposure to a plasma to be generated within the plasma processing region 109. The top window structure 107 is positioned above the substrate support structure 103 to establish the plasma processing region 109 between the substrate support structure 103 and the top window structure 107. The top window structure 107 is formed of ceramic material and has the bottom surface 107A facing the plasma processing region 109. In various embodiments, the top window structure 107 is formed of aluminum oxide, silicon carbide, or of another ceramic material that is chemically, mechanically, thermally, and electrically compatible with operation of the chamber 102. The bottom surface 107A of the top window structure 107 has a surface roughness/texture that promotes adherence of plasma process byproduct material to the bottom surface 107A. In some embodiments, the bottom surface 107A of the top window structure 107 has a surface roughness average (Ra) within a range extending from about 150 microinches to about 500 microinches. In some embodiments, the bottom surface 107A of the top window structure 107 has a surface roughness average (Ra) of about 500 microinches. In some embodiments, the bottom surface 107A of the top window structure 107 has a surface roughness average (Ra) greater than 500 microinches. In some embodiments, the bare ceramic material that forms the top window structure 107 is exposed at the bottom surface 107A of the top window structure 107.

The method also includes an operation 703 for generating the plasma in the plasma processing region 109, such that constituents of the plasma interacting with a material on the substrate 101 to generate plasma process byproduct material, and where some of the plasma process byproduct material adheres to the bottom surface 107A of the top window structure 107. In some embodiments, the material on the substrate 101 is a lead zirconate titanate (PZT) film. In some embodiments, the material on the substrate 101 is a platinum (Pt) film. In some embodiments, the material on the substrate 101 is a film that causes heavy byproduct deposition within the chamber 102 when exposed to the plasma generated in operation 703.

In some embodiments, generating the plasma in the operation 703 can include applying radiofrequency power to a process gas within the plasma processing region 109. In some embodiments, the applied radiofrequency power can be within a range extending from about 400 Watts (W) to about 1250 W. However, it should be understood that in various embodiments the applied radiofrequency power can be less than 400 W or greater than 1250 W. In some embodiments, the radiofrequency power is applied by radiofrequency signals having a frequency of about 13.56 MHz. However, it should be understood that in various embodiments the radiofrequency power can be applied by radiofrequency signals having a frequency other than 13.56 MHz. Also, in some embodiments, the method can include an operation for generating a bias voltage at the substrate support structure 103. In some embodiments, the bias voltage is generated within a range extending from about 100 Volts (V) to about 600 V. However, it should be understood that in various embodiments the bias voltage can be less than 100 V or greater than 600 V. Also, in some embodiments, the bias voltage can be generated by radiofrequency signals having a frequency of about 13.56 MHz. However, it should be understood that in various embodiments the bias voltage can be generated by radiofrequency signals having a frequency other than 13.56 MHz. Also, in various embodiments, the bias voltage can be generated by a direct current source.

Also, in some embodiments, the method can include an operation for maintaining a temperature of the substrate support structure 103 within a range extending from about 40° Celsius (C) to about 100° C. However, it should be understood that in various embodiments the temperature of the substrate support structure 103 can be maintained at less than 40° C or greater than 100° C. Also, in some embodiments, the method can include an operation for maintaining a pressure within the plasma processing region 109 within a range extending from about 5 milliTorr to about 50 milliTorr. However, it should be understood that in various embodiments the pressure within the plasma processing region 109 can be maintained at less that 5 milliTorr or greater than 50 milliTorr.

In some embodiments, generating the plasma in the operation 703 includes supplying process gas to the plasma processing region 109, where the process gas is one or more of chlorine ($Cl_2$), boron trichloride ($BCl_3$), argon (Ar), carbon tetrafluoride ($CF_4$), oxygen ($O_2$), trifluoromethane ($CHF_3$), and sulfur hexafluoride ($SF_6$). In some embodiments, generating the plasma in the operation 703 includes supplying chlorine ($Cl_2$) to the plasma processing region 109 at a flow rate within a range extending from about 20 standard cubic centimeters per minute (sccm) to about 300 sccm. In some embodiments, generating the plasma in the operation 703 includes supplying boron trichloride ($BCl_3$) to the plasma processing region 109 at a flow rate within a range extending from about 50 sccm to about 300 sccm. In some embodiments, generating the plasma in the operation 703 includes supplying argon (Ar) to the plasma processing region 109 at a flow rate within a range extending from about 50 sccm to about 300 sccm. In some embodiments, generating the plasma in the operation 703 includes supplying carbon tetrafluoride ($CF_4$) to the plasma processing region 109 at a flow rate within a range extending from about 50 sccm to about 200 sccm. In some embodiments, generating the plasma in the operation 703 includes supplying oxygen ($O_2$) to the plasma processing region 109 at a flow rate within a range extending from about 20 sccm to about 300 sccm. In some embodiments, generating the plasma in the operation 703 includes supplying trifluoromethane ($CHF_3$) to the plasma processing region 109 at a flow rate within a range extending from about 50 sccm to about 300 sccm. In some embodiments, generating the plasma in the operation 703 includes supplying sulfur hexafluoride ($SF_6$) to the plasma processing region 109 at a flow rate within a range extending from about 50 sccm to about 300 sccm.

The method for plasma processing of the substrate as shown in Figure 7 can also include using the liner structure 139 within the chamber 102, where the liner structure 139 is configured to extend around at least a portion of the plasma processing region 109 within the chamber 102. In this method, the liner structure 139 has the inner surface 139A that is oriented to be in exposure to the plasma process byproduct material. The inner surface 139A of the liner structure 139 has a surface roughness that promotes adherence of the plasma process byproduct material to the inner surface 139A of the liner structure 139. In various embodiments, the liner structure 139 is formed of aluminum oxide, silicon carbide, or of another ceramic material that is chemically, mechanically, thermally, and electrically compatible with operation of the chamber 102. In some embodiments, the inner surface 139A of the liner structure 139 has a surface roughness average (Ra) within a range extending from about 150 microinches to about 500 microinches. In some embodiments, the inner surface 139A of the liner structure 139 has a surface roughness average (Ra) of about 500 microinches. In some embodiments, the inner surface 139A of the liner structure 139 has a surface roughness average (Ra) greater than 500 microinches. In some embodiments, the bare ceramic material that forms the liner structure 139 is exposed at the inner surface 139A of the liner structure 139.

It should be appreciated that use of a non-coated ceramic liner structure 139 having an engineered surface roughness/texture that enables and promotes adherence of the plasma process byproduct material eliminates the difficulty and expense of having to refurbish a coated liner structure, such as hard anodized aluminum liner structure that has a yttria coating. Also, use of a non-coated ceramic liner structure 139 having an engineered surface roughness/texture that enables and promotes adherence of the plasma process byproduct material extends the lifetime of the liner structure 139 by eliminating the increased risk of mechanical failure that may be caused by stresses induced within the liner structure 139 during refurbishment and recoating processes, such as occur during the refurbishment and recoating processes used in conjunction with a hard anodized aluminum chamber liner structure having a yttria coating.

The method for plasma processing of the substrate as shown in Figure 7 can also include using a ring structure within the chamber 102, where the ring structure is configured to circumscribe the substrate support structure 103 within the chamber 102. The ring structure has at least one process-exposed surface that is one or both of an inner surface and an upper surface of the ring structure. The process-exposed surface is oriented to be in exposure to the plasma process byproduct material. Also, the process-exposed surface of the ring structure has a surface roughness that enables and promotes adherence of the plasma process byproduct material to the process-exposed surface of the ring structure. In some embodiments, the ring structure is the focus ring structure 135. In some embodiments, the ring structure is the edge ring structure 131. In some embodiments, the ring structure is the ground ring structure 133. In some embodiments, the ring structure is formed of aluminum oxide, silicon carbide, or of another ceramic material that is chemically, mechanically, thermally, and electrically compatible with operation of the chamber 102. In some embodiments where the ring structure is formed of ceramic material, a bare ceramic material of which the ring structure is formed is exposed at the roughened/texturized process-exposed surface of the ring structure. In some embodiments, the ring structure is formed of an electrically conductive material, such as aluminum or stainless steel or another metallic material that is chemically, mechanically, thermally, and electrically compatible with operation of the chamber 102. In some embodiments where the ring structure is formed of electrically conductive material, the roughened/texturized process-exposed surface of the ring structure may remain uncoated when used in the chamber 102. Or, in some embodiments where the ring structure is formed of electrically conductive material, the roughened/texturized process-exposed surface of the ring structure may be coated when used in the chamber 102. In some embodiments, the coating applied to the electrically conductive ring structure is a yttria coating, or an anodization, or another type of coating that is chemically, mechanically, thermally, and electrically compatible with operation of the chamber 102. In some embodiments, the process-exposed surface of the ring structure has a surface roughness average (Ra) within a range extending from about 150 microinches to about 500 microinches. In some embodiments, the process-exposed surface of the ring structure has a surface roughness average (Ra) of about 500 microinches. In some embodiments, the process-exposed surface of the ring structure has a surface roughness average (Ra) greater than 500 microinches.

The use of components having engineered surface roughness/texture within the chamber 102 to promote the adhesion of non-volatile and/or low-volatility plasma process byproduct materials to the components has been demonstrate to provide many process improvements. For example, in PZT and Pt etching processes where significant amounts of non-volatile and/or low-volatility plasma process byproduct materials are generated, the use of components having engineered surface roughness/texture within the chamber 102 has shown the following improvements:

- improved etch uniformity across the substrate 101,

- better etch control to reduce unwanted removal of landing layer (Pt) during either main etch step or overetch step,
- better etch repeatability for substrate-to-substrate and lot-to-lot,
- better etching results due to minimization of flaking-off and/or peeling-off of the non-volatile and/or low-volatility byproduct materials onto the substrate support structure 103, which helps avoid substrate 101 clamping problems,
- reduction in photoresist reticulation,
- better etch profile control due to better consistency of photoresist erosion,
- minimization of etch defects on the substrate 101 from micro-masking,
- prevention of substrate 101 clamping problems due to insufficient clamping force,
- better substrate 101 backside heat removal and cooling,
- prevention of hot spots on the etched substrate 101,
- better retention of the non-volatile and/or low-volatility etch byproduct materials on the top window structure 107, liner structure 139, ground ring structure 133, edge ring structure 131, which helps prevent flaking-off and/or peeling-off of the non-volatile and/or low-volatility etch byproduct materials onto the substrate support structure 101 and/or substrate 101, and
- reduction in cost by eliminating the exterior coating on the top window structure 107 and the liner structure 139.

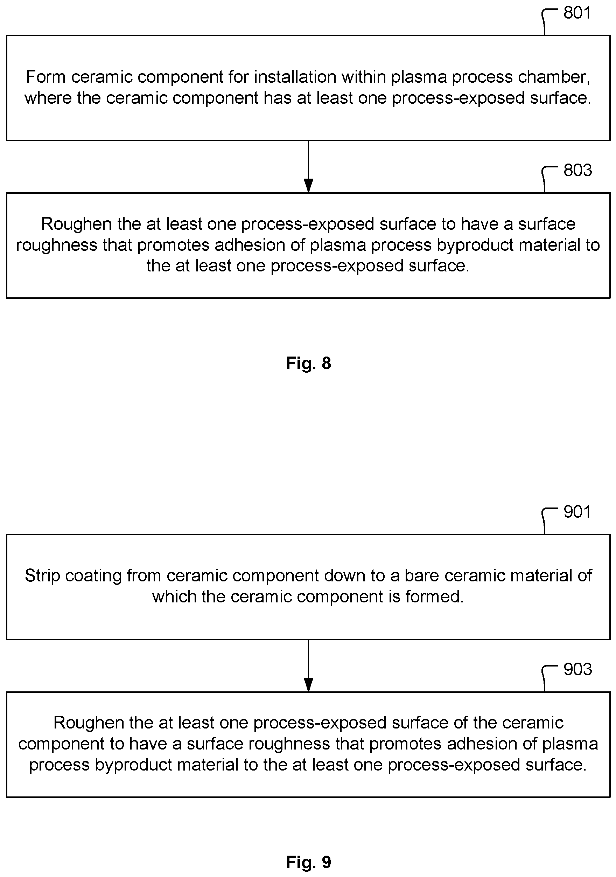

Figure 8 shows a flowchart of a method for manufacturing a surface-textured plasma process chamber component, in accordance with some embodiments. The method includes an operation 801 for forming a ceramic component for installation within a plasma process chamber, e.g., within the chamber 102, where the ceramic component has at least one process-exposed surface. In some embodiments, the ceramic component is formed of aluminum oxide, silicon carbide, or of another ceramic material that is chemically, mechanically, thermally, and electrically compatible with operation of the chamber 102. In various embodiments, the ceramic component is either the top window structure 107, the liner structure 139, the focus ring structure 135, or the edge ring structure 131.

The method also includes an operation 803 for roughening the at least one process-exposed surface to have a surface roughness that promotes adhesion of plasma process byproduct material to the at least one process-exposed surface. In some embodiments, the operation 803 is performed to impart a surface roughness average (Ra) within a range extending from about 150 microinches to about 500 microinches to the at least one process-exposed surface of the ceramic component. In some embodiments, the operation 803 is performed to impart a surface roughness average (Ra) greater than 500 microinches to the at least one process-exposed surface of the ceramic component. In some embodiments, the operation 803 for roughening the at least one process-exposed surface is done by a media blasting process. In some embodiments, the media blasting process impacts the at least one process-exposed surface with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite. In some embodiments, the operation 801 for forming the ceramic component includes performing a knurling process on the ceramic component prior to firing of the ceramic component, where the knurling process is defined to impart texture to the at least one process-exposed surface of the ceramic component. In some embodiments, a bare ceramic material of which the ceramic component is formed is exposed at the at least one process-exposed surface after roughening of the at least one process-exposed surface in the operation 803.

Figure 9 shows a flowchart of a method for converting a coated plasma process chamber component into a surface-textured plasma process chamber component, in accordance with some embodiments. The method includes an operation 901 for stripping a coating from a ceramic component down to a bare ceramic material of which the ceramic component is formed. The ceramic component is configured for installation within a plasma process chamber, e.g., within the chamber 102. Also, the ceramic component has at least one process-exposed surface. In some embodiments, the ceramic component is formed of aluminum oxide, silicon carbide, or of another ceramic material that is chemically, mechanically, thermally, and electrically compatible with operation of the chamber 102. In various embodiments, the ceramic component is either the top window structure 107, the liner structure 139, the focus ring structure 135, or the edge ring structure 131.

The method also includes an operation 903 for roughening the at least one process-exposed surface of the ceramic component to have a surface roughness that promotes adhesion of plasma process byproduct material to the at least one process-exposed surface. In some embodiments, the operation 903 is performed to impart a surface roughness average (Ra) within a range extending from about 150 microinches to about 500 microinches to the at least one process-exposed surface of the ceramic component. In some embodiments, the operation 903 is performed to impart a surface roughness average (Ra) greater than 500 microinches to the at least one process-exposed surface of the ceramic component.

In some embodiments, the operation 903 for roughening the at least one process-exposed surface is done by a media blasting process. In some embodiments, the media blasting process impacts the at least one process-exposed surface with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite. In some embodiments, a bare ceramic material of which the ceramic component is formed is exposed at the at least one process-exposed surface after roughening of the at least one process-exposed surface in the operation 903. Also, in some embodiments the operation 901 for stripping the coating from the ceramic component is done using a media blasting process. And, in some embodiments, both of operations 901 and 903 are performed simultaneously using a same media blasting process.

Prior to the surface roughening/texturizing embodiments disclosed herein, the focus ring structure 135 has conventionally been formed to have a relatively smooth, featureless surface on both the inner and outer surfaces of the ring portion 135A and on the radial extension structures 135B1, 135B2, 135B3. Plasma process byproduct materials that are non-volatile and/or have low-volatility adhere poorly to smooth, featureless surfaces. For example, in plasma-based etching of PZT film or Pt film on the substrate 101, significant amounts of non-volatile and/or low-volatility etch byproduct materials are generated and can have poor adhesion to the focus ring structure 135 that is conventionally formed to have smooth, featureless surfaces. As the plasma process byproduct materials build up on the focus ring structure 135 they can flake off and/or peel off and land on the substrate 101 and/or substrate support structure 103 due to the close proximity of the focus ring structure 135 to both the substrate 101 and the substrate support structure 103. Having plasma process byproduct material landing on the substrate 101 can damage the substrate 101 or cause formation of defects in the structures being formed on the substrate 101. Also, having plasma process byproduct material landing on the substrate support structure 103, especially when the substrate 101 is not present on the substrate support structure 103, can interfere with proper clamping of the substrate 101 on the substrate support structure 103 and can cause adversely high helium flow at the backside of the substrate 101, i.e., from the region between the substrate 101 and the substrate support structure 103, any of which can lead to formation of defects on the substrate 101.

As previously discussed, in various embodiments, the roughening/texturizing of the surface of the focus ring structure 135 can promote and substantially improve adhesion of plasma process byproduct materials to the focus ring structure 135, so as to accommodate a greater build up of plasma process byproduct material on the focus ring structure 135 before flaking-off and/or peeling-off of plasma process byproduct material from the focus ring structure 135 occurs. Therefore, roughening/texturizing of the surface of the focus ring structure 135 serves to delay the onset of flaking-off and/or peeling-off of plasma process byproduct material from the focus ring structure 135. However, continuing to further increase the roughness/texture of the focus ring structure 135 may have a diminishing effect on increasing the mean time until flaking-off and/or peeling-off of plasma process byproduct material from the focus ring structure 135 occurs.

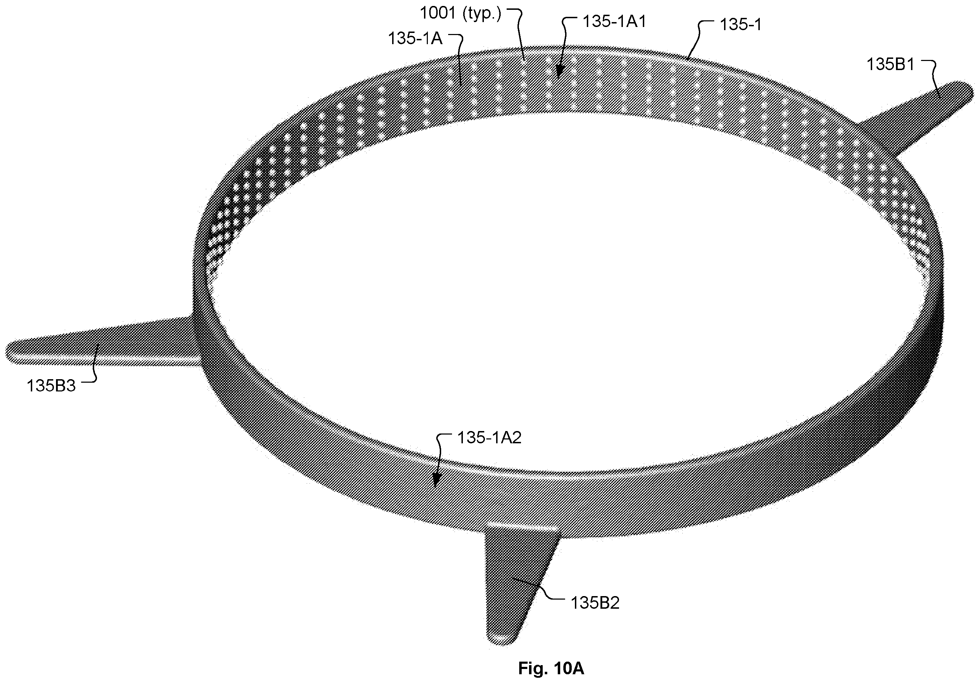

Because the focus ring structure 135 is close to and positioned above the substrate 101 and substrate support structure 103, it is of particular interest to prevent flaking-off and/or peeling-off of plasma process byproduct material from the focus ring structure 135. In this regard, Figure 10A shows an isometric view of a focus ring structure 135-1 that has a controlled surface topographical variation on an inner surface 135-1A1 of a ring portion 135-1A of the focus ring structure 135-1 to promote adherence of the plasma process byproduct material to the focus ring structure 135-1, in accordance with some embodiments. Like the focus ring structure 135 described with regard to Figures 1D, 1E, and 5, the focus ring structure 135-1 includes a ring portion 135-1A and the three radial extension structures 135B1, 135B2, 135B3. The ring portion 135-1A is configured as a right circular hollow cylinder to circumscribe the substrate support structure 103 within the chamber 102. The radial extension structures 135B1, 135B2, 135B3 are configured to extend radially outward from an outer surface 135-1A2 of the ring portion 135-1A. The radial extension structures 135B1, 135B2, 135B3 are configured to engage with the three respective lifting components 137A, 137B, 137C to enable raising and lowering of the focus ring structure 135-1 relative to the substrate support structure 103. The focus ring structure 135-1 is formed of ceramic material. In various embodiments, the focus ring structure 135 can be formed of aluminum oxide, silicon carbide, or essentially any other ceramic material that is chemically, mechanically, thermally, and electrically compatible for service as the focus ring structure 135 during operation of the chamber 102.

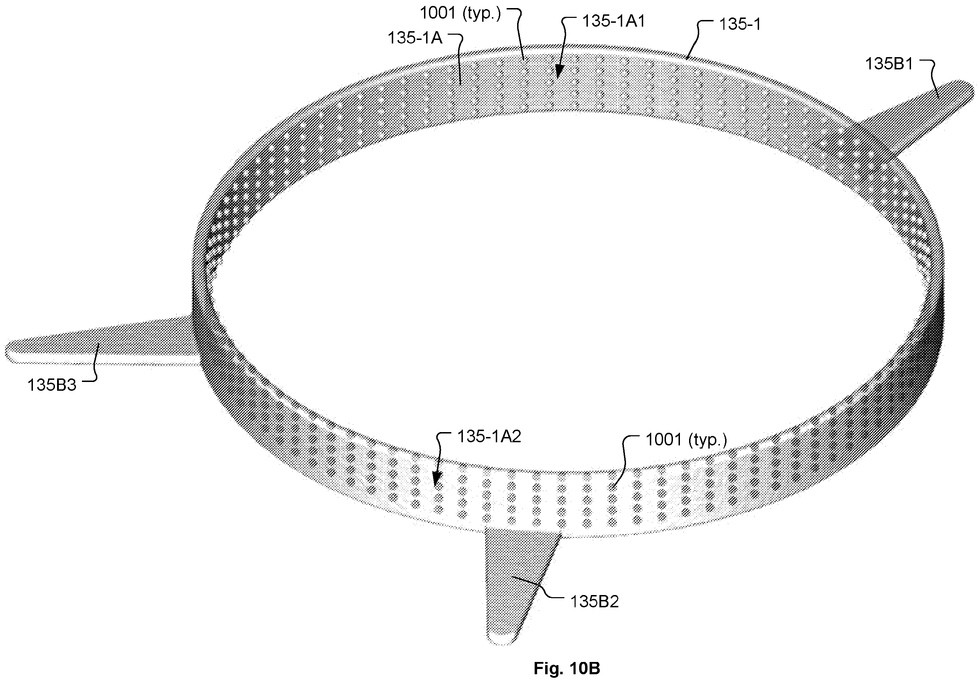

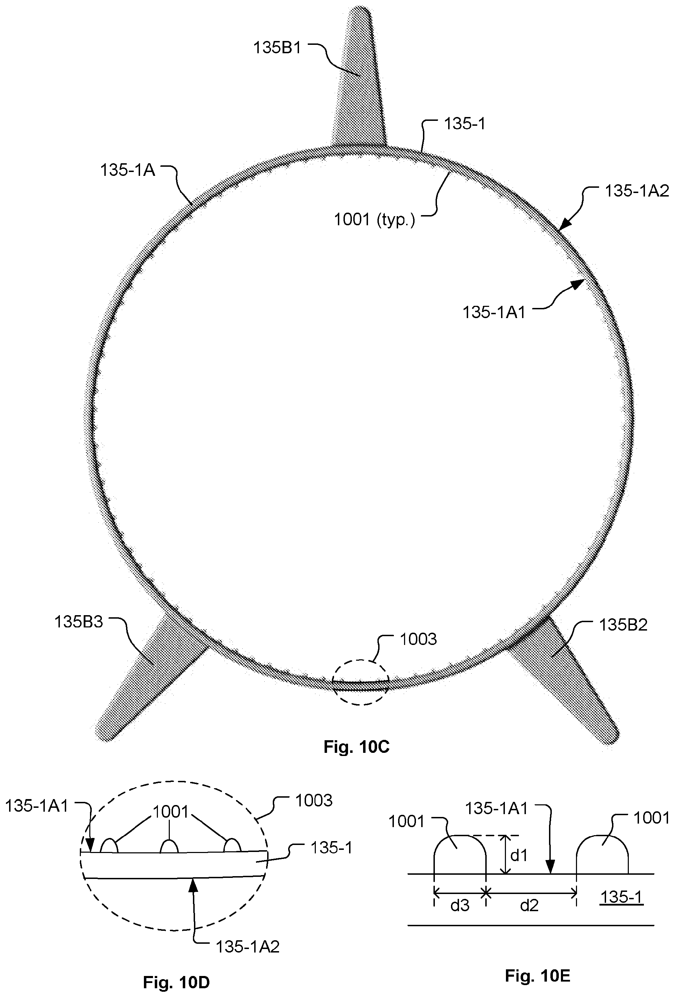

The inner surface 135-1A1 of the ring portion 135-1A is oriented to be in exposure to plasma process byproduct material within the plasma processing region 109 when the focus ring structure 135-1 is placed within the chamber 102 during operation of the chamber 102. The inner surface 135-1A1 of the ring portion 135-1A of the focus ring structure 135-1 is formed to have a controlled surface topographical variation that promotes adherence of the plasma process byproduct material to the inner surface 135-1A1. In some embodiments, the controlled surface topographical variation formed on the inner surface 135-1A1 of the ring portion 135-1A of the focus ring structure 135-1 includes a lattice of convex structures 1001 that extend inward toward an area circumscribed by the ring portion 135-1A, i.e., that extend inward toward the plasma processing region 109. In Figure 10A, the convex structures 1001 are shown as light-colored structures arranged in a lattice pattern. A typical convex structure 1001 is called out by reference number 1001 in Figure 10A. Figure 10B shows a transparent view of the focus ring structure 135-1 of Figure 10A, in accordance with some embodiments. Figure 10B shows how the lattice pattern of the convex structures 1001 extends around the full circumference of the inner surface 135-1A1 of the ring portion 135-1A of the focus ring structure 135-1. Figure 10C shows a top view of the focus ring structure 135-1 of Figure 10A, in accordance with some embodiments. Figure 10D shows a detailed view 1003 as referenced in Figure 10C, in accordance with some embodiments. As shown in Figure 10D, in some embodiments, the convex structures 1001 are formed to have a dome shape. However, it should be understood that in various embodiments, the convex structures 1001 can be formed to have essentially any geometric shape that is conducive to promoting and enhancing adhesion and retention of plasma process byproduct material on the inner surface 135-1A1 of the ring portion 135-1A of the focus ring structure 135-1.

Figure 10E shows a cross-section view through two adjacent convex structures 1001, in accordance with some embodiments. In some embodiments, each convex structure 1001 extends inward toward the area circumscribed by the ring portion 135-1A of the focus ring structure 135-1 by a distance (d1) within a range extending from about 0.5 millimeter (mm) to about 2 mm, or within a range extending from about 1 mm to about 2 mm, or of about 1 mm. In some embodiments, a distance (d2) between adjacent convex structures 1001 is within a range extending from about 0.5 mm to about 2 mm. In some embodiments, the distance (d2) between adjacent convex structures 1001 is about 1 mm. In some embodiments, each convex structure 1001 has a base width (d3) within a range extending from about 1 mm to about 3 mm, or within a range extending from about 2 mm to about 3 mm, or of about 2.5 mm, where the base width (d3) is measured diametrically across the convex structure 1001 at the inner surface 135-1A1 of the ring portion 135-1A of the focus ring structure 135-1. In some embodiments, a tolerance on the sizes and spacings of the convex structures 1001 is about 10% of a specified dimension.

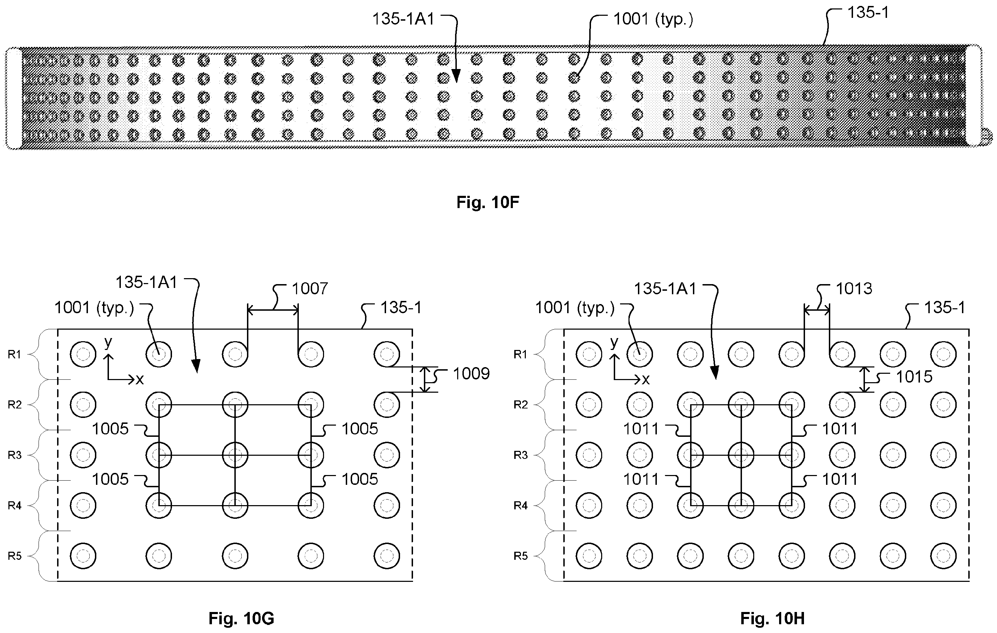

Figure 10F shows a vertical cross-section through a center of the focus ring structure 135-1, in accordance with some embodiments. In the example of Figure 10F, the convex structures 1001 are arranged in a rectangular lattice that includes five rows. In other embodiments, the convex structures 1001 can be arranged in a rectangular lattice that includes either less than five rows or more than five rows. Figure 10G shows a diagram for forming the convex structures 1001 in a rectangular lattice over the inner surface 135-1A1 of the ring portion 135-1A of the focus ring structure 135-1, in accordance with some embodiments. The rectangular lattice is characterized has having the convex structures 1001 positioned in a repeating rectangular pattern, as indicated by the rectangles 1005, in both a horizontal direction (x) around the circumference of the inner surface 135-1A1 of the ring portion 135-1A of the focus ring structure 135-1, and in a vertical direction (y). In the rectangular lattice, the convex structures 1001 are spaced apart in the horizontal direction (x) by a distance 1007, and are spaced apart in the vertical direction (y) by a distance 1009, where the distance 1007 is greater than the distance 1009. In some embodiments, the distances 1007 and 1009 are within a range extending from about 0.5 mm to about 2 mm. In some embodiments, the distance 1009 is about 1 mm. In the example of Figure 10G, the rectangular lattice of convex structures 1001 has five rows (R1 through R5). However, it should be understood that in various embodiments the rectangular lattice of convex structures 1001 can have two or more rows.

In addition to the rectangular lattice as shown in Figure 10G, in some embodiments, the convex structure 1001 can be arranged over the inner surface 135-1A1 of the ring portion 135-1A of the focus ring structure 135-1 in either a square lattice, a hexagonal lattice, a parallelogrammic lattice, or a rhombic lattice. Figure 10H shows a diagram for forming the convex structures 1001 in a square lattice over the inner surface 135-1A1 of the ring portion 135-1A of the focus ring structure 135-1, in accordance with some embodiments. The square lattice is characterized has having the convex structures 1001 positioned in a repeating square pattern, as indicated by the squares 1011, in both the horizontal direction (x) around the circumference of the inner surface 135-1A1 of the ring portion 135-1A of the focus ring structure 135-1, and in the vertical direction (y). In the square lattice, the convex structures 1001 are spaced apart in the horizontal direction (x) by a distance 1013, and are spaced apart in the vertical direction (y) by a distance 1015, where the distance 1013 is substantially equal to the distance 1015. In some embodiments, the distances 1013 and 1015 are within a range extending from about 0.5 mm to about 2 mm. In some embodiments, the distances 1013 and 1015 are about 1 mm. In the example of Figure 10H, the square lattice of convex structures 1001 has five rows (R1 through R5). However, it should be understood that in various embodiments the square lattice of convex structures 1001 can have two or more rows.

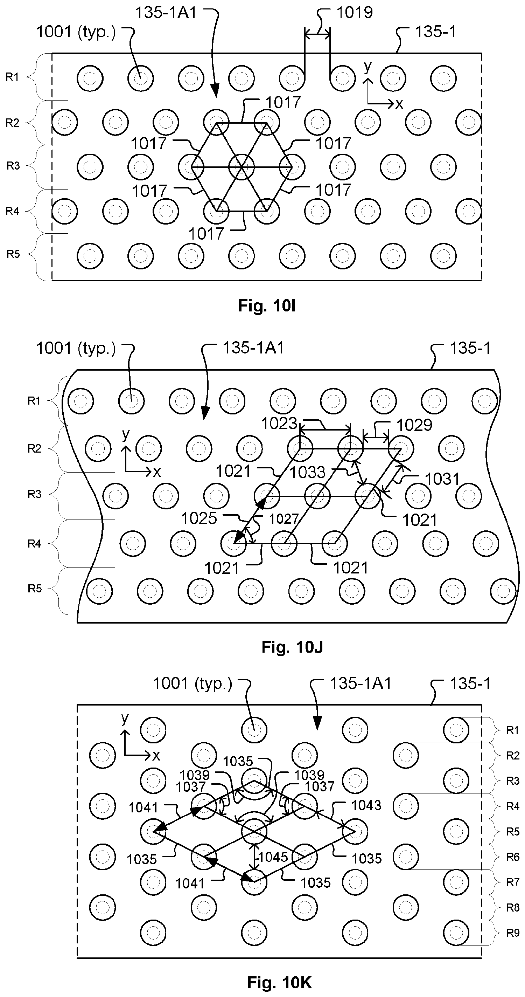

Figure 10I shows a diagram for forming the convex structures 1001 in a hexagonal lattice over the inner surface 135-1A1 of the ring portion 135-1A of the focus ring structure 135-1, in accordance with some embodiments. The hexagonal lattice is characterized has having the convex structures 1001 positioned in a repeating equilateral triangle pattern in both the horizontal direction (x) around the circumference of the inner surface 135-1A1 of the ring portion 135-1A of the focus ring structure 135-1 and in the vertical direction (y), with adjacent equilateral triangles of the pattern inverted in the vertical direction (y), as indicated by the equilateral triangles 1017. In the hexagonal lattice, adjacent convex structures 1001 are spaced apart from each other by a distance 1019. In some embodiments, the distance 1019 is within a range extending from about 0.5 mm to about 2 mm. In some embodiments, the distance 1019 is about 1 mm. In the example of Figure 10I, the hexagonal lattice of convex structures 1001 has five rows (R1 through R5). However, it should be understood that in various embodiments the hexagonal lattice of convex structures 1001 can have two or more rows.

Figure 10J shows a diagram for forming the convex structures 1001 in a parallelogrammic lattice over the inner surface 135-1A1 of the ring portion 135-1A of the focus ring structure 135-1, in accordance with some embodiments. The parallelogrammic lattice is characterized has having the convex structures 1001 positioned in a repeating parallelogram pattern in both the horizontal direction (x) around the circumference of the inner surface 135-1A1 of the ring portion 135-1A of the focus ring structure 135-1 and in the vertical direction (y), with adjacent parallelograms of the pattern having coincident vertices, as indicated by the parallelograms 1021. The parallelogram 1021 that defines the parallelogrammic lattice has two horizontal parallel sides of equal length 1023 oriented to extend substantially in the horizontal direction (x), and two skewed parallel sides of equal length 1025 oriented to extend at an angle 1027 between the two horizontal parallel sides. In the parallelogrammic lattice, adjacent convex structures 1001 are spaced apart from each other by three distances 1029, 1031, 1033. In some embodiments, the distances 1029, 1031, 1033 are within a range extending from about 0.5 mm to about 2 mm. In some embodiments, a smallest of the distances 1029, 1031, 1033 is about 1 mm. In the example of Figure 10J, the parallelogrammic lattice of convex structures 1001 has five rows (R1 through R5). However, it should be understood that in various embodiments the parallelogrammic lattice of convex structures 1001 can have two or more rows.

Figure 10K shows a diagram for forming the convex structures 1001 in a rhombic lattice over the inner surface 135-1A1 of the ring portion 135-1A of the focus ring structure 135-1, in accordance with some embodiments. The rhombic lattice is characterized has having the convex structures 1001 positioned in a repeating rhombus pattern, in both the horizontal direction (x) around the circumference of the inner surface 135-1A1 of the ring portion 135-1A of the focus ring structure 135-1 and in the vertical direction (y), with adjacent rhombuses of the pattern having coincident vertices, as indicated by the rhombuses 1035. The rhombus 1035 that defines the rhombic lattice is a parallelogram that has opposite equal acute angles 1037, and opposite equal obtuse angles 1039, and four sides of equal length 1041. In the rhombic lattice, adjacent convex structures 1001 are spaced apart from each other by two distances 1043 and 1045. In some embodiments, the distances 1043 and 1045 are within a range extending from about 0.5 mm to about 2 mm. In some embodiments, a smallest of the distances 1043 and 1045 is about 1 mm. In the example of Figure 10K, the rhombic lattice of convex structures 1001 has nine rows (R1 through R9). In some embodiments, the rhombus 1035 is configured such that convex structures 1001 in vertically adjacent ones of the rows, e.g., R1 through R9, do not overlap with each other in the vertical direction (y). However, in some embodiments, the rhombus 1035 is configured such that convex structures 1001 in vertically adjacent ones of the rows, e.g., R1 through R9, do have some amount of overlap with each other in the vertical direction (y). It should be understood that in various embodiments the rhombic lattice of convex structures 1001 can have three or more rows.

In some embodiments, the controlled surface topographical variation on the inner surface 135-1A1 of the ring portion 135-1A of the focus ring structure 135-1 is formed by a media blasting process. In some embodiments, a protective mask is applied to the inner surface 135-1A1 of the ring portion 135-1A of the focus ring structure 135-1 to cover the locations where the convex structures 1001 are to be formed. Then, the inner surface 135-1A1 of the ring portion 135-1A of the focus ring structure 135-1 is subjected to the media blasting process to remove, i.e., erode, a layer of ceramic material of which the focus ring structure 135-1 is formed from the inner surface 135-1A1, thereby forming the convex structures 1001 on the inner surface 135-1A1. Then, the protective mask is removed. In some embodiments, the media blasting process used to form the convex structures 1001 simultaneously roughens/texturizes the portions of the inner surface 135-1A1 between and around the convex structures 1001 to promote adherence of plasma process byproduct material to the inner surface 135-1A1. In various embodiments, the media used in the media blasting process to form the convex structures 1001 can include one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite, among other types of media. Also, in some embodiments, surfaces of the focus ring structure 135-1 beyond the inner surface 135-1A1 can be subjected to the media blasting process to receive a prescribed surface roughness average (Ra). For example, in some embodiments, an entirety of the ring portion 135-1A and the top surfaces of the radial extension structures 135B1, 135B2, 135B3 can be subjected to the media blasting process to receive a prescribed surface roughness average (Ra) within a range extending from about 150 microinch to about 500 microinch.

In some embodiments, the convex structures 1001 can be formed by performing a knurling process on the inner surface 135-1A1 of the ring portion 135-1A of the focus ring structure 135-1 when the ceramic material of the focus ring structure 135-1 is in a soft green state before firing of the ceramic. The knurling process is a manufacturing process in which a pattern of some depth is formed within a material in a soft malleable state. After the knurling and firing of the ceramic material of the focus ring structure 135-1, the convex structures 1001 will be present on the inner surface 135-1A1 of the ring portion 135-1A. Then, the focus ring structures 135-1 can be subjected to the above-mentioned media blasting process to impart a prescribed surface roughness average (Ra) to the ring portion 135-1A and radial extension structures 135B1, 135B2, 135B3 of the focus ring structure 135-1. The convex structures 1001 and surface roughness average (Ra) imparted to the bare ceramic material of the focus ring structure 135-1 allows for use of the focus ring structure 135-1 within the chamber 102 in a bare, uncoated form, which eliminates the cost and risks associated with coating and re-coating of the focus ring structure 135-1.

It should be appreciated that formation of the convex structures 1001 on the inner surface 135-1A1 of the ring portion 135-1A adds significant surface area to the focus ring structure 135-1 to which plasma process byproduct material can adhere. For example, in some embodiments, the arrangement of convex structures 1001 can be defined in a manner that increases a surface area of the inner surface 135-1A1 of the ring portion 135-1A by 400% or more, which provides a deliberate and highly contrasting surface topography upon which heavy plasma process byproduct material can deposit and adhere. Also, the surface roughness average (Ra) imparted to the focus ring structure 135-1 by the media blasting process provides a robust, highly-textured surface for better adhesion of non-volatile and/or low-volatility plasma process by product material to the focus ring structure 135-1. It should be understood and appreciated that the enhanced plasma process byproduct material adhesion and retention to the focus ring structure 135-1 provides for an increase in the mean time between cleaning (MTBC) of the chamber 102, which improves substrate 101 fabrication throughput. Also, the ability to use the focus ring structure 135-1 within the chamber 102 as a bare, uncoated ceramic component extends the service lifetime of the focus ring structure 135-1 by eliminating the need to remove coating material from the focus ring structure 135-1 during refurbishment of the focus ring structure 135-1.

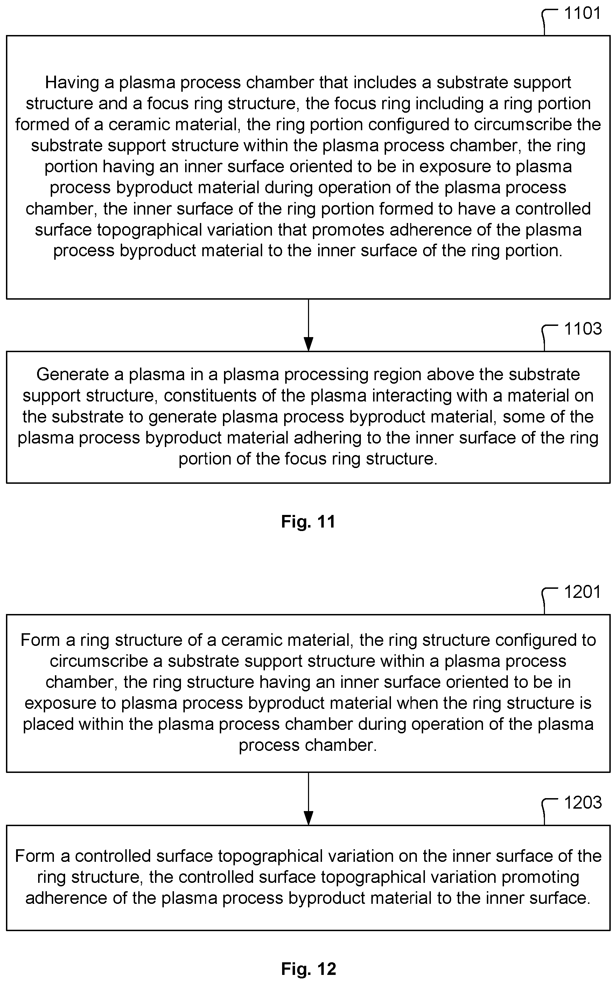

Figure 11 shows a flowchart of a method for plasma processing of a substrate, in accordance with some embodiments. The method includes an operation 1101 for having a plasma process chamber, i.e., chamber 102, that includes the substrate support structure 103 and the focus ring structure 135-1. The focus ring structure 135-1 includes the ring portion 135-1A formed of ceramic material. In various embodiments, the focus ring structure 135-1 is formed of aluminum oxide, silicon carbide, or of another ceramic material that is chemically, mechanically, thermally, and electrically compatible with operation of the chamber 102. The ring portion 135-1A is configured to circumscribe the substrate support structure 103 within the chamber 102. The ring portion 135-1A has the inner surface 135-1A1 oriented to be in exposure to the plasma processing region 109 in which plasma process byproduct material is generated during operation of the chamber 102. The inner surface 135-1A1 is formed to have a controlled surface topographical variation that promotes adherence of the plasma process byproduct material to the inner surface 135-1A1. In some embodiments, the focus ring structure 135-1 has a surface roughness average (Ra) within a range extending from about 150 microinches to about 500 microinches. In some embodiments, the focus ring structure 135-1 has a surface roughness average (Ra) of about 500 microinches. In some embodiments, the bare ceramic material that forms the focus ring structure 135-1 is exposed at the exterior surface of the focus ring structure 135-1, and particularly at the inner surface 135-1A1 of the ring portion 135-1A of the focus ring structure 135-1.

The method also includes an operation 1103 for generating the plasma in the plasma processing region 109, such that constituents of the plasma interact with a material on the substrate 101 to generate plasma process byproduct material, and where some of the plasma process byproduct material adheres to the focus ring structure 135-1. In some embodiments, the material on the substrate 101 is a lead zirconate titanate (PZT) film. In some embodiments, the material on the substrate 101 is a platinum (Pt) film. In some embodiments, the material on the substrate 101 is a film that causes heavy byproduct deposition within the chamber 102 when exposed to the plasma generated in operation 1103.

In some embodiments, generating the plasma in the operation 1103 can include applying radiofrequency power to a process gas within the plasma processing region 109. In some embodiments, the applied radiofrequency power can be within a range extending from about 400 W to about 1250 W. However, it should be understood that in various embodiments the applied radiofrequency power can be less than 400 W or greater than 1250 W. In some embodiments, the radiofrequency power is applied by radiofrequency signals having a frequency of about 13.56 MHz. However, it should be understood that in various embodiments the radiofrequency power can be applied by radiofrequency signals having a frequency other than 13.56 MHz. Also, in some embodiments, the method can include an operation for generating a bias voltage at the substrate support structure 103. In some embodiments, the bias voltage is generated within a range extending from about 100 V to about 600 V. However, it should be understood that in various embodiments the bias voltage can be less than 100 V or greater than 600 V. Also, in some embodiments, the bias voltage can be generated by radiofrequency signals having a frequency of about 13.56 MHz. However, it should be understood that in various embodiments the bias voltage can be generated by radiofrequency signals having a frequency other than 13.56 MHz. Also, in various embodiments, the bias voltage can be generated by a direct current source.

Also, in some embodiments, the method can include an operation for maintaining a temperature of the substrate support structure 103 within a range extending from about 40° C to about 100° C. However, it should be understood that in various embodiments the temperature of the substrate support structure 103 can be maintained at less than 40° C or greater than 100° C. Also, in some embodiments, the method can include an operation for maintaining a pressure within the plasma processing region 109 within a range extending from about 5 milliTorr to about 50 milliTorr. However, it should be understood that in various embodiments the pressure within the plasma processing region 109 can be maintained at less that 5 milliTorr or greater than 50 milliTorr.

In some embodiments, generating the plasma in the operation 1103 includes supplying process gas to the plasma processing region 109, where the process gas is one or more of chlorine ($Cl_2$), boron trichloride ($BCl_3$), argon (Ar), carbon tetrafluoride ($CF_4$), oxygen ($O_2$), trifluoromethane ($CHF_3$), and sulfur hexafluoride ($SF_6$). In some embodiments, generating the plasma in the operation 1103 includes supplying chlorine ($Cl_2$) to the plasma processing region 109 at a flow rate within a range extending from about 20 sccm to about 300 sccm. In some embodiments, generating the plasma in the operation 1103 includes supplying boron trichloride ($BCl_3$) to the plasma processing region 109 at a flow rate within a range extending from about 50 sccm to about 300 sccm. In some embodiments, generating the plasma in the operation 1103 includes supplying argon (Ar) to the plasma processing region 109 at a flow rate within a range extending from about 50 sccm to about 300 sccm. In some embodiments, generating the plasma in the operation 1103 includes supplying carbon tetrafluoride ($CF_4$) to the plasma processing region 109 at a flow rate within a range extending from about 50 sccm to about 200 sccm. In some embodiments, generating the plasma in the operation 1103 includes supplying oxygen ($O_2$) to the plasma processing region 109 at a flow rate within a range extending from about 20 sccm to about 300 sccm. In some embodiments, generating the plasma in the operation 1103 includes supplying trifluoromethane ($CHF_3$) to the plasma processing region 109 at a flow rate within a range extending from about 50 sccm to about 300 sccm. In some embodiments, generating the plasma in the operation 1103 includes supplying sulfur hexafluoride ($SF_6$) to the plasma processing region 109 at a flow rate within a range extending from about 50 sccm to about 300 sccm.

Figure 12 shows a flowchart of a method for manufacturing a focus ring structure for use in a plasma process chamber, in accordance with some embodiments. The method includes an operation 1201 for forming a ring structure of a ceramic material, such as the ring portion 135-1A of the focus ring structure 135-1, where the ring structure is configured to circumscribe a substrate support structure, e.g., the substrate support structure 103, within a plasma process chamber, e.g., within the chamber 102. The ring structure has an inner surface, e.g., the inner surface 135-1A1, oriented to be in exposure to a plasma processing region in which plasma process byproduct material is generated when the ring structure is placed within the plasma process chamber during operation of the plasma process chamber. In some embodiments, the ring structure is formed of aluminum oxide, silicon carbide, or of another ceramic material that is chemically, mechanically, thermally, and electrically compatible with operation of the plasma process chamber. In some embodiments, forming the ring structure in operation 1201 includes forming three structures to extend radially outward from an outer surface of the ring structure, e.g., the radial extension structures 135B1, 135B2, 135B3, where the three structures are configured to engage with three respective lifting components to enable raising and lowering of the ring structure relative to the substrate support structure when the ring structure is placed within the plasma process chamber. In some embodiments, top surfaces of the three structures that extend radially outward from the outer surface of the ring structure are roughened to have surface roughness average (Ra) within a range extending from about 150 microinches to about 500 microinches.

The method also includes an operation 1203 for forming a controlled surface topographical variation on the inner surface of the ring structure. The controlled surface topographical variation promotes adherence of the plasma process byproduct material to the inner surface of the ring structure. In some embodiments, the operation 1203 includes performing a media blasting process through a mask disposed over the inner surface of the ring structure. The mask is configured to expose portions of the inner surface of the ring structure for removal/erosion to form the controlled surface topographical variation on the inner surface of the ring structure. In some embodiments, the media blasting process impacts the inner surface of the ring structure with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite, among others. In some embodiments, the operation 1203 includes performing a knurling process on the inner surface of the ring structure prior to firing of the ceramic material of which the ring structure is formed. In some embodiments, the method can include roughening the inner surface of the ring structure to have a surface roughness average (Ra) within a range extending from about 150 microinches to about 500 microinches. In some embodiments, roughening of the inner surface of the ring structure is done by a media blasting process, which may or may not be the same media blasting process as used in operation 1203 to form the controlled surface topographical variation on the inner surface of the ring structure. In some embodiments, a bare ceramic material of which the ring structure is formed is left exposed at the inner surface of the ring structure.

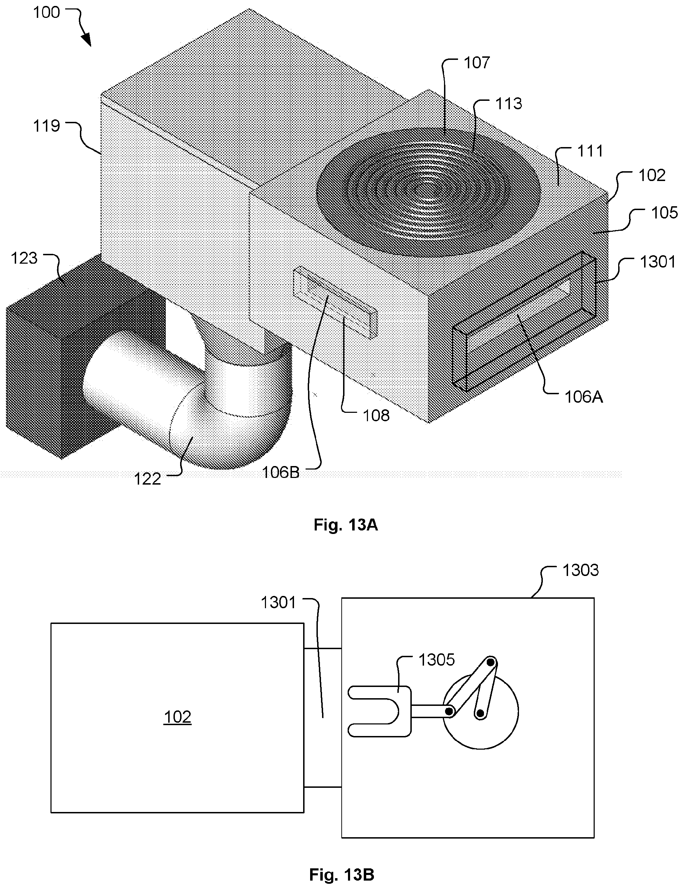

As previously mentioned, the walls 105 of the chamber 102 include the opening 106A for transfer of the substrate 101 into and out of the chamber 102. In some embodiments, the opening 106A is covered by an access control device, such as a slit-valve or gate valve or similar device, that provides for passage of a robotic substrate handling device into the chamber 102 through the opening 106A, and that provides for sealing of the opening 106A when the chamber 102 is in operation. Figure 13A shows the system 100 of Figure 1A with an access control device 1301 positioned to cover the opening 106A, in accordance with some embodiments. Figure 13B shows a diagram of the chamber 102 interfaced with a substrate handling module 1303 by way of the access control device 1301, in accordance with some embodiments. The substrate handling module 1303 can include a robotic substrate handling device 1305 configured to transfer the substrate 101 into and out of the chamber 102.

During plasma processing of the substrate 101 within the chamber 102, plasma process byproduct materials are free to move around in the chamber 102 in accordance with process gas flow patterns and/or existing pressure gradients. During plasma processing operations that generate non-volatile and/or low volatility byproduct materials, such as PZT etching processes or Pt etching processes, among others, it is possible for plasma process byproduct materials to travel into the opening 106A and to the access control device 1301. These plasma process byproduct materials can deposit on the chamber wall 105 within the opening 106A and on the inner surface(s) of the access control device 1301. Then, during subsequent operation of the access control device 1301 it is possible for some of the deposited plasma process byproduct materials to move into the access control device 1301 and possibly even into the substrate handling module 1303. It should be understood that movement of plasma process byproduct materials into and/or through the access control device 1301 spreads contaminants and is undesirable. Also, it should be appreciated that cleaning/removal of plasma process byproduct material that has deposited in the opening 106A and moved into the access control device 1301 is difficult, time-consuming, and expensive because it is often necessary to disassemble the chamber 102 and/or the access control device 1301 in order to perform the cleaning/removal of the plasma process byproduct material. Also, the proximity of the chamber 102 opening 106A to the substrate handling module 1303 increases the possibility of cross-contamination should any deposited byproduct material flake off onto the robotic substrate handling device 1305 and be transferred and carried to a different portion of the fabrication facility.

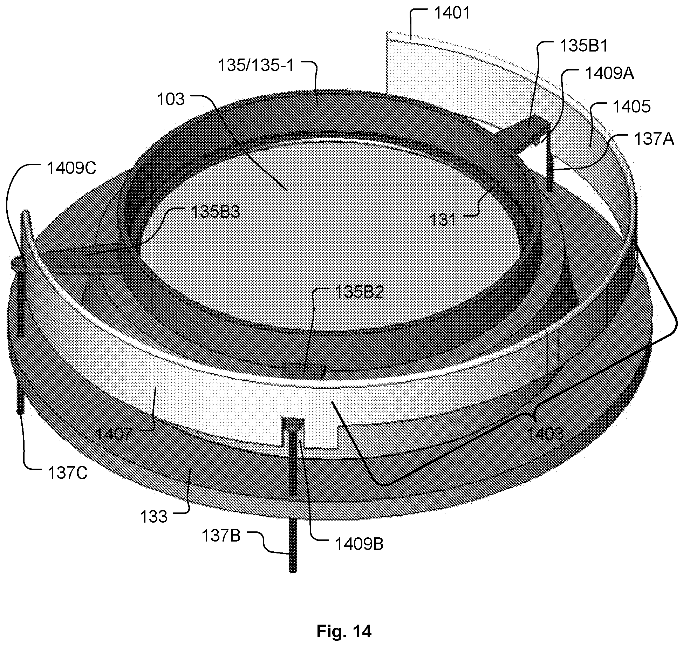

Figure 14 shows a substrate access port shield 1401 for use in the chamber 102, in accordance with some embodiments. The substrate access port shield 1401 includes a shield segment 1403 configured to be positioned over a portion of the opening 106A within the chamber 102. The substrate access port shield 1401 also includes a first support segment 1405 extending from a first end of the shield segment 1403. The substrate access port shield 1401 also includes a second support segment 1407 extending from a second end of the shield segment 1403. The shield segment 1403 and the first support segment 1405 and the second support segment 1407 form an integral shield structure that extends along an arc. In some embodiments, the arc of the substrate access port shield 1401 is conformal with an arc of the liner structure 139.

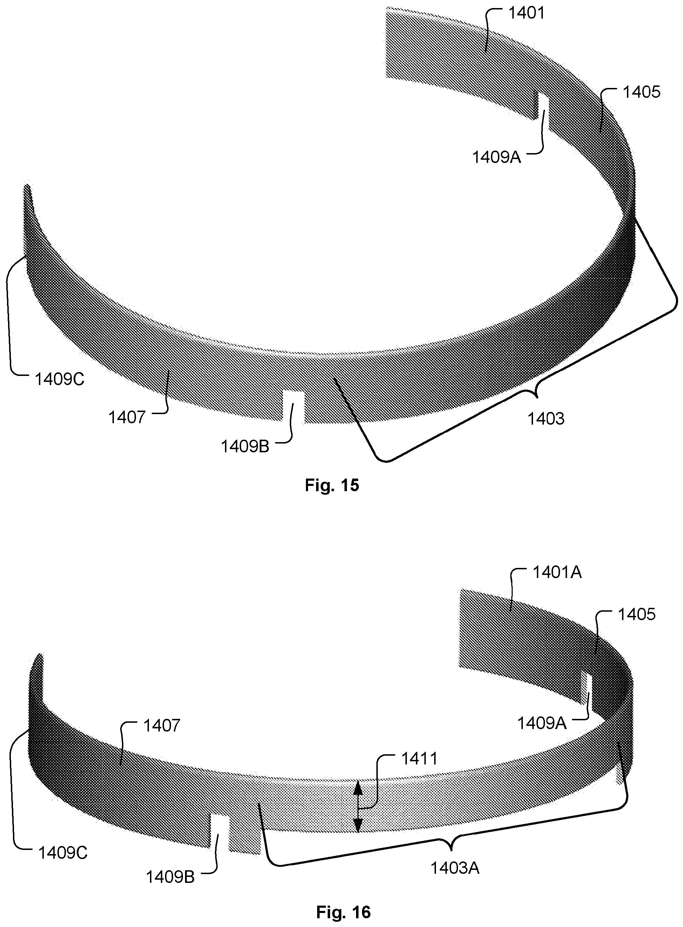

The first support segment 1405 is configured to engage with a vertically movable component within the chamber 102, and the second support segment 1407 is configured to engage with the vertically movable component within the chamber 102, such that vertical movement of the vertically movable component causes corresponding vertical movement of the substrate access port shield 1401. In some embodiments, such as shown in Figure 14, the vertically movable component within the chamber 102 is the focus ring structure 135/135-1. In some embodiments, the substrate access port shield 1401 includes a number of cutout areas 1409A, 1409B, 1409C corresponding to the radial extension structures 135B1, 135B2, 135B3 of the focus ring structure 135/135-1. Figure 15 shows an isometric view of the substrate access port shield 1401 showing the cutout areas 1409A, 1409B, 1409C, in accordance with some embodiments. The cutout areas 1409A, 1409B, 1409C are formed to enable the substrate access port shield 1401 to be vertically positioned on the radial extension structures 135B1, 135B2, 135B3 of the focus ring structure 135/135-1, such that the radial extension structures 135B1, 135B2, 135B3 are inserted into the cutout areas 1409A, 1409B, 1409C, respectively. In some embodiments, the cutout areas 1409A, 1409B, 1409C are also formed to enable the substrate access port shield 1401 to be held securely on the focus ring structure 135/135-1 by the force of gravity alone, i.e., without other fastening devices. However, in other embodiments, one or more fastening devices can be used to affix the substrate access port shield 1401 to the focus ring structure 135/135-1. Also, in some embodiments, the substrate access port shield 1401 can include one or more additional cutout areas to accommodate viewing of the plasma processing region 109, such as for optical endpoint spectrometry (OES) purposes or other purposes, when the focus ring structure 135/135-1 is in the plasma processing position.

In the embodiments in which the substrate access port shield 1401 is positioned on the focus ring structure 135/135-1, vertical movement of the focus ring structure 135/135-1 by way of the lifting components 137A, 137B, 137C causes corresponding vertical movement of the substrate access port shield 1401. Also, it should be understood that in some embodiments the substrate access port shield 1401 can be used within the chamber 102 when the focus ring structure 135/135-1 is not present within the chamber 102. In these embodiments, the substrate access port shield 1401 is configured to interface with one or more vertically movable component(s) within the chamber 102 other than the focus ring structure 135/135-1. For example, in some embodiments, the substrate access port shield 1401 is configured to connect directly to the lifting components 137A, 137B, 137C when the focus ring structure 135/135-1 is not present within the chamber 102. In this manner, vertical movement of the lifting components 137A, 137B, 137C causes corresponding vertical movement of the substrate access port shield 1401.

The shield segment 1403 is configured to at least partially cover the opening 106A of the chamber 102 when the first support segment 1405 and the second support segment 1407 are engaged with the vertically movable component, e.g., with the focus ring structure 135/135-1, and when the vertically movable component is in a lowered vertical position. Also, the shield segment 1403 is configured to uncover the opening 106A of the chamber 102 when the first support segment 1405 and the second support segment 1407 are engaged with the vertically movable component, e.g., with the focus ring structure 135/135-1, and when the vertically movable component is in a raised vertical position. In some embodiments, the configuration of the focus ring structure 135/135-1 and the vertical travel distance of the focus ring structure 135/135-1 may require the shield segment 1403 of the substrate access port shield 1401 to be shortened in the vertical direction to enable sufficient uncovering of the opening 106A of the chamber 102 when the focus ring structure 135/135-1 is in its fully raised vertical position. For example, Figure 16 shows a variation of the substrate access port shield 1401A in which a shield segment 1403A has a reduced vertical distance 1411 to enable sufficient uncovering of the opening 106A of the chamber 102 when the focus ring structure 135/135-1 is in its fully raised vertical position, in accordance with some embodiments.

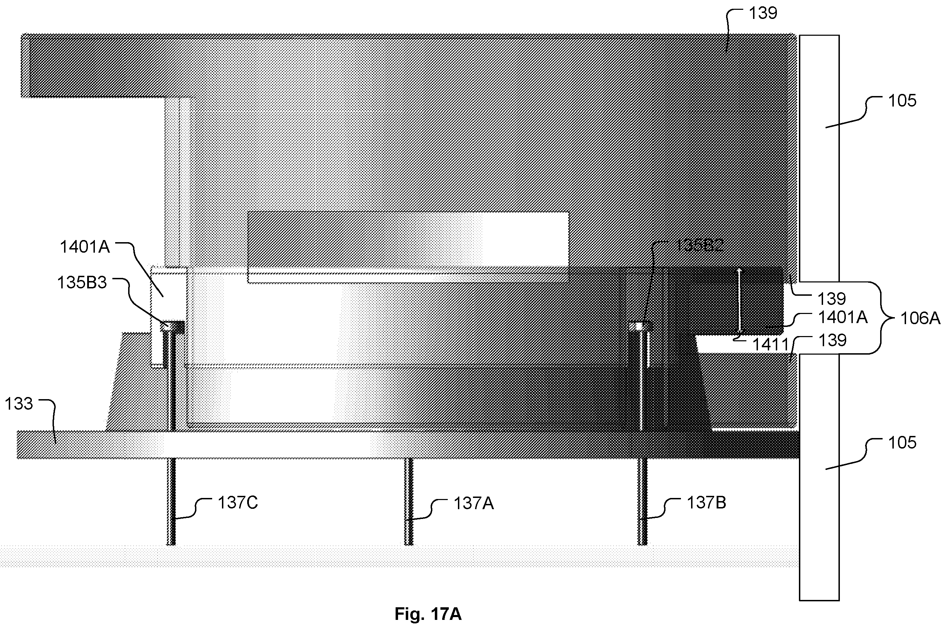

Figure 17A shows a side view of the example substrate access port shield 1401A positioned on the focus ring structure 135/135-1, with the focus ring structure 135/135-1 in the fully lowered position, in accordance with some embodiments. In the example of Figure 17A, the vertical distance 1411 of the shield segment 1403A of the substrate access port shield 1401A covers about 75% of the vertical extent of the opening 106A when the focus ring structure 135/135-1 is in the fully lowered position. In various embodiments, with substrate access port shield 1401A positioned on the focus ring structure 135/135-1 and with the focus ring structure 135/135-1 in the fully lowered position, the substrate access port shield 1401A is configured to cover at least about 50% of the vertical extent of the opening 106A. In some embodiments, with substrate access port shield 1401A positioned on the focus ring structure 135/135-1 and with the focus ring structure 135/135-1 in the fully lowered position, the substrate access port shield 1401A is configured to cover at least about two-thirds of the vertical extent of the opening 106A. In some embodiments, with substrate access port shield 1401A positioned on the focus ring structure 135/135-1 and with the focus ring structure 135/135-1 in the fully lowered position, the substrate access port shield 1401A is configured to cover an entire vertical extent of the opening 106A.

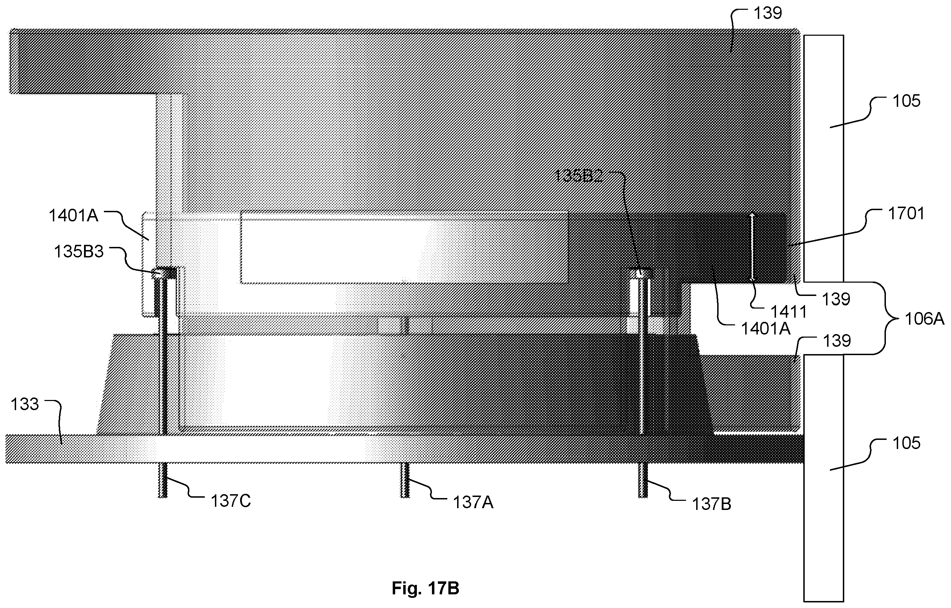

Figure 17B shows a side view of the example substrate access port shield 1401A positioned on the focus ring structure 135/135-1, with the focus ring structure 135/135-1 in the fully raised position, in accordance with some embodiments. In the example of Figure 17B, the vertical distance 1411 of the shield segment 1403A of the substrate access port shield 1401A is defined so that the shield segment 1403A is positioned vertically above the opening 106A. In some embodiments, the vertical distance 1411 of the shield segment 1403A of the substrate access port shield 1401A can be defined so that the shield segment 1403A still covers a portion of the vertical extent of the opening 106A, so long as an unobscured vertical extent of the opening 106A is large enough to provide for interference-free movement of the substrate 101 and the robotic substrate handling device 1305 through the opening 106A.

In various embodiments, the substrate access port shield 1401/1401A is configured as a portion of a right circular hollow cylinder. In some embodiments, a radial thickness of the substrate access port shield 1401/1401A is substantially uniform. In various embodiments, a radial thickness of the substrate access port shield 1401/1401A is within a range extending from about 0.125 inch to about 0.5 inch, or within a range extending from about 0.375 inch to about 0.5 inch, or about 0.217 inch, or about 0.375 inch. In some embodiments, the radial thickness of the substrate access port shield 1401/1401A is non-uniform. For example, in some embodiments, the first support segment 1405 and the second support segment 1407 can have a different radial thickness than that of the shield segment 1403/1403A. Additionally, because some plasma process operations are performed at low pressure, the diffusion of plasma process byproduct materials within the chamber 102 can be significant. Therefore, in some embodiments, it is of interest to have the substrate access port shield 1401/1401A positioned as radially close to the liner structure 139 as possible, without contacting the liner structure 139, so as to reduce the flow area through which byproduct materials can diffuse between the substrate access port shield 1401/1401A and the liner structure 139. In some embodiments, a radial spacing 1701 between the substrate access port shield 1401/1401A and the liner structure 139 is about 0.1 inch, by way of example.

In some embodiments, such as shown in Figures 15 and 16, the shield segment 1403/1403A of the substrate access port shield 1401/1401A is a first portion of the right circular hollow cylinder, and the first support segment 1405 is a second portion of the right circular hollow cylinder, and the second support segment 1407 is a third portion of the right circular hollow cylinder. Also, in some embodiments, the shield segment 1403/1403A has a first vertical height, i.e., the vertical distance 1411, measured in an axis direction of the right circular hollow cylinder, and the first support segment 1405 has a second vertical height measured in the axis direction of the right circular hollow cylinder, and the second support segment 1407 has a third vertical height measured in the axis direction of the right circular hollow cylinder. In some embodiments, the first vertical height of the shield segment 1403/1403A, the second vertical height of the first support segment 1405, and the third vertical height of the second support segment 1407 are substantially equal. In some embodiments, the first vertical height of the shield segment 1403/1403A is different than each of the second vertical height of the first support segment 1405 and the third vertical height of the second support segment 1407. In some embodiments, the second vertical height of the first support segment 1405 and third vertical height of the second support segment 1407 are substantially equal. In some embodiments, the first vertical height of the shield segment 1403/1403A is less than each of the second vertical height of the first support segment 1405 and the third vertical height of the second support segment 1407.

In some embodiments, the substrate access port shield 1401/1401A is formed as a monolithic ceramic part. In various embodiments, the substrate access port shield 1401/1401A can be formed of aluminum oxide, silicon carbide, or essentially any other ceramic material that is chemically, mechanically, thermally, and electrically compatible for use within the chamber 102. Also, in some embodiments, the substrate access port shield 1401/1401A can be formed of a non-ceramic material, so long as the material of which the substrate access port shield 1401/1401A is formed is chemically, mechanically, thermally, and electrically compatible with the plasma processing operations to be performed with chamber 102.

In some embodiments, the surface of the substrate access port shield 1401/1401A can be roughened/texturized to have a prescribed surface roughness average (Ra) that promotes adhesion and retention of plasma process byproduct materials on the substrate access port shield 1401/1401A. In some embodiments, at least an inner-radial surface of the substrate access port shield 1401/1401A has a surface roughness average (Ra) within a range extending from about 150 microinch to about 500 microinch, where the inner-radial surface faces toward the plasma processing region 109. In some embodiments, an entire exterior surface of the substrate access port shield 1401/1401A has a surface roughness average (Ra) within a range extending from about 150 microinch to about 500 microinch.

In some embodiments, the surface of the substrate access port shield 1401/1401A is roughened by a media blasting process. In various embodiments, the media blasting process can be defined and performed to increase the surface roughness, create high contact angles over the surface, and increase an overall surface area of the surface of the substrate access port shield 1401/1401A. In various embodiments, the media blasting process can be defined and performed to impact the surface of the substrate access port shield 1401/1401A with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite, among other types of media. It should be understood that in some embodiments the media blasting process can provide for substantially even application of a prescribed roughness/texture over the surface of the substrate access port shield 1401/1401A. Also, in some embodiments, the media blasting process can be performed in conjunction with a patterned mask to produce a prescribed surface topography over the surface of the substrate access port shield 1401/1401A. For example, the patterned mask can include a distribution of open areas through which the media blasting material can reach the surface of the substrate access port shield 1401/1401A. The media blasting material will remove some of the ceramic material within the open areas of the patterned mask, while not removing ceramic material protected by the patterned mask, thereby producing the prescribed surface topography over the surface of the substrate access port shield 1401/1401A. Also, in addition to the media blasting process or as an alternative to the media blasting process, a roughness/texture can be imparted to the surface of the substrate access port shield 1401/1401A by performing a knurling process on the ceramic of the substrate access port shield 1401/1401A prior to firing of the ceramic.

In some embodiments, a ceramic material of which the substrate access port shield 1401/1401A is formed is exposed at the inner-radial surface of the substrate access port shield 1401/1401A. More specifically, in some embodiments, the substrate access port shield 1401/1401A formed of ceramic material is left in an uncoated state for use within the chamber 102. Also, in some embodiments where the substrate access port shield 1401/1401A is formed of non-ceramic material, such as aluminum by way of example, the substrate access port shield 1401/1401A can be coated with an appropriate coating material such as a yttria coating or anodization coating, among others.

The substrate access port shield 1401/1401A is a passive component that provides for at least a partial blockage/covering of the opening 106A of the chamber 102 to which the access control device 1301 is connected. Although the substrate access port shield 1401/1401A is a passive component, the substrate access port shield 1401/1401A interfaces with an active component and thereby behaves as if it were an active component. For example, because the substrate access port shield 1401/1401A rests on the focus ring structure 135/135-1, the substrate access port shield 1401/1401A can be moved vertically by way of the controlled vertical movement of the focus ring structure 135/135-1. It should be appreciated that use of the substrate access port shield 1401/1401A within the chamber 102 does not require modification of any other component(s) within the chamber 102 and does not require installation of additional actuation/movement components within the chamber 102.

The substrate access port shield 1401/1401A can be configured to prevent a majority of non-volatile and/or low-volatility plasma process byproduct materials from entering the opening 106A and from depositing in or near the access control device 1301. The substrate access port shield 1401/1401A also provides additional surface area around the inside periphery of the chamber 102 to help trap and hold non-volatile and/or low-volatility plasma process byproduct materials, especially during plasma process operation that generate significant amounts of such byproduct materials, such as PZT etching processes and Pt etching processes. The substrate access port shield 1401/1401A provides a target surface upon which etch byproducts can deposit, rather than enter into the opening 106A and possibly into the access control device 1301 where cleaning is tedious and the chance of particle contamination is high. It should be appreciated that by reducing and/or preventing etch byproduct deposition within the opening 106A, the substrate access port shield 1401/1401A serves to reduce the mean time to clean (MTTC) the chamber 102.

In some embodiments, the substrate access port shield 1401/1401A is a consumable item that can be discarded and replaced during regularly scheduled chamber 102 openings. By catching non-volatile and/or low-volatility plasma process byproduct materials, the substrate access port shield 1401/1401A serves to reduce particle generation within the chamber 102 and within the opening 106A during transfer of the substrate 101 into and out of the chamber 102. Also, by reducing and/or preventing non-volatile and/or low-volatility plasma process byproduct materials from entering the access control device 1301, the substrate access port shield 1401/1401A serves to prevent premature damage of the access control device 1301 that could be caused when byproduct materials get trapped in the access control device 1301 or the seal, i.e., O-ring, area(s) of the access control device 1301. Therefore, the substrate access port shield 1401/1401A serves to extend the access control device 1301 lifetime. Also, the substrate access port shield 1401/1401A helps to prevent leaks in the access control device 1301 area that may be caused by deposition and/or entrapment of non-volatile and/or low-volatility plasma process byproduct materials, thereby providing the chamber 102 with better vacuum integrity. Moreover, by helping to keep byproduct materials out of the access control device 1301, the substrate access port shield 1401/1401A serves to reduce access control device 1301 malfunction during open and close operations, and serves to reduce both a frequency, duration, and difficulty of physical cleaning of the access control device 1301. In some cases, use of the substrate access port shield 1401/1401A can reduce the access control device 1301 cleaning time by 50% or more. Because the substrate access port shield 1401/1401A serves to reduce problems with the access control device 1301 caused by plasma process byproduct material intrusion into the access control device 1301, the substrate access port shield 1401/1401A serves to reduce chamber 102 downtime caused by problems with the access control device 1301.

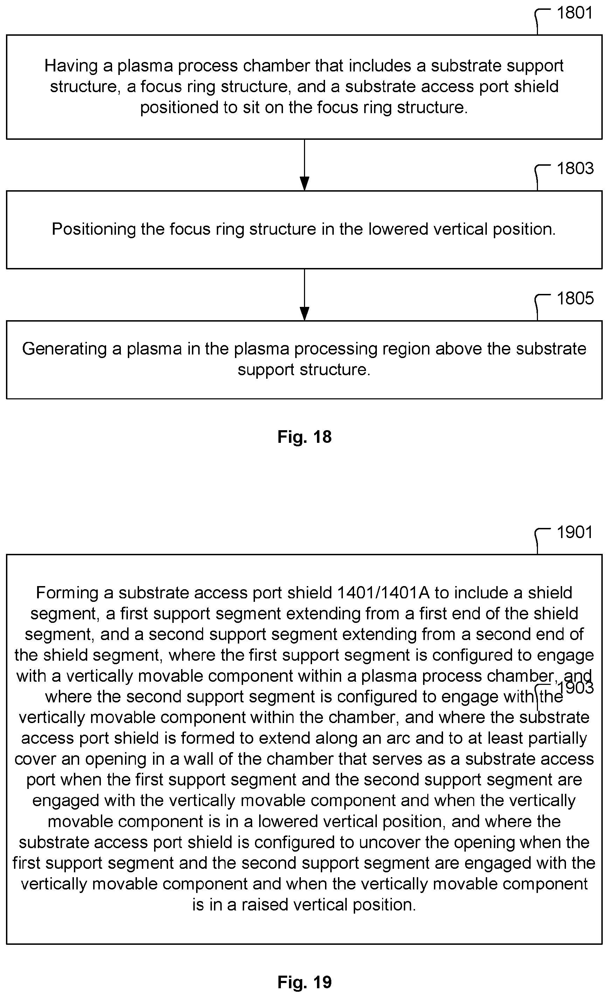

Figure 18 shows a flowchart of a method for plasma processing of a substrate, in accordance with some embodiments. The method includes an operation 1801 for having a plasma process chamber, i.e., chamber 102, that includes the substrate support structure 103, the focus ring structure 135/135-1, and the substrate access port shield 1401/1401A. The focus ring structure 135/135-1 is configured to circumscribe the substrate support structure 103. The focus ring structure 135/135-1 includes the ring portion 135A formed as a right circular hollow cylinder and the three radial extension structures 135B1, 135B2, 135B3 configured to extend radially outward from the outer surface 135A2 of the ring portion 135A. The substrate access port shield 1401/1401A includes a shield segment 1403, a first support segment 1405, and a second support segment 1407. The first support segment 1405 extends from a first end of the shield segment 1403. The first support segment 1405 is configured to engage with a first of the radial extension structures 135B1, 135B2, 135B3 of the focus ring structure 135/135-1. The second support segment 1407 extends from a second end of the shield segment 1403. The second support segment 1407 is configured to engage with a second of the radial extension structures 135B1, 135B2, 135B3 of the focus ring structure 135/135-1.

In some embodiments, the method includes connecting the substrate access port shield 1401/1401A to the focus ring structure 135/135-1 in a fastener-free manner. In some embodiments, the substrate access port shield 1401/1401A is secured to the focus ring structure 135/135-1 by gravity. In some embodiments, connecting the access port shield 1401/1401A to the focus ring structure 135/135-1 in the fastener-free manner includes inserting the first radial extension structure 135B 1 of the focus ring structure 135/135-1 into the cutout 1409A formed within the first support segment 1405 of the substrate access port shield 1401/1401A. Also, connecting the access port shield 1401/1401A to the focus ring structure 135/135-1 in the fastener-free manner includes inserting the second radial extension structure 135B2 of the focus ring structure 135/135-1 into the cutout 1409B formed within the second support segment 1407 of the substrate access port shield 1401/1401A. And, connecting the access port shield 1401/1401A to the focus ring structure 135/135-1 in the fastener-free manner includes inserting the third radial extension structure 135B3 of the focus ring structure 135/135-1 into the cutout 1409C formed within the second support segment 1407 of the substrate access port shield 1401/1401A.

The method also includes an operation 1803 for positioning the focus ring structure 135/135-1 in the lowered vertical position. In some embodiments, positioning the focus ring structure 135/135-1 in the lowered vertical position includes operating the three lifting components 137A, 137B, 137C that respectively engage with the three radial extension structures 135B1, 135B2, 135B3 of the focus ring structure 135/135-1. The method further includes an operation 1805 for generating a plasma in the plasma processing region 109 above the substrate support structure 103. In some embodiments, the plasma is generated in operation 1805 such that constituents of the plasma interact with a material on the substrate 101 to generate plasma process byproduct material, where some of the plasma process byproduct material is blocked by access port shield 1401/1401A from entering into the opening 106A. In some embodiments, the material on the substrate 101 is a lead zirconate titanate (PZT) film. In some embodiments, the material on the substrate 101 is a platinum (Pt) film. In some embodiments, the material on the substrate 101 is a film that causes heavy byproduct deposition within the chamber 102 when exposed to the plasma generated in operation 1805. The method can also include ceasing generation of the plasma in the plasma processing region 109 above the substrate support structure 103, and positioning the focus ring structure 135/135-1 in the raised vertical position, so as to vertical lift the substrate access port shield 1401/1401A to enable unobstructed passage of the substrate 101 and the robotic substrate handling device 1305 through the opening 106A.

In some embodiments, generating the plasma in the operation 1805 can include applying radiofrequency power to a process gas within the plasma processing region 109. In some embodiments, the applied radiofrequency power can be within a range extending from about 400 W to about 1250 W. However, it should be understood that in various embodiments the applied radiofrequency power can be less than 400 W or greater than 1250 W. In some embodiments, the radiofrequency power is applied by radiofrequency signals having a frequency of about 13.56 MHz. However, it should be understood that in various embodiments the radiofrequency power can be applied by radiofrequency signals having a frequency other than 13.56 MHz. Also, in some embodiments, the method can include an operation for generating a bias voltage at the substrate support structure 103. In some embodiments, the bias voltage is generated within a range extending from about 100 V to about 600 V. However, it should be understood that in various embodiments the bias voltage can be less than 100 V or greater than 600 V. Also, in some embodiments, the bias voltage can be generated by radiofrequency signals having a frequency of about 13.56 MHz. However, it should be understood that in various embodiments the bias voltage can be generated by radiofrequency signals having a frequency other than 13.56 MHz. Also, in various embodiments, the bias voltage can be generated by a direct current source.

Also, in some embodiments, the method can include an operation for maintaining a temperature of the substrate support structure 103 within a range extending from about 40° C to about 100° C. However, it should be understood that in various embodiments the temperature of the substrate support structure 103 can be maintained at less than 40° C or greater than 100° C. Also, in some embodiments, the method can include an operation for maintaining a pressure within the plasma processing region 109 within a range extending from about 5 milliTorr to about 50 milliTorr. However, it should be understood that in various embodiments the pressure within the plasma processing region 109 can be maintained at less that 5 milliTorr or greater than 50 milliTorr.

In some embodiments, generating the plasma in the operation 1805 includes supplying process gas to the plasma processing region 109, where the process gas is one or more of chlorine ($Cl_2$), boron trichloride ($BCl_3$), argon (Ar), carbon tetrafluoride ($CF_4$), oxygen ($O_2$), trifluoromethane ($CHF_3$), and sulfur hexafluoride ($SF_6$). In some embodiments, generating the plasma in the operation 1805 includes supplying chlorine ($Cl_2$) to the plasma processing region 109 at a flow rate within a range extending from about 20 sccm to about 300 sccm. In some embodiments, generating the plasma in the operation 1805 includes supplying boron trichloride ($BCl_3$) to the plasma processing region 109 at a flow rate within a range extending from about 50 sccm to about 300 sccm. In some embodiments, generating the plasma in the operation 1805 includes supplying argon (Ar) to the plasma processing region 109 at a flow rate within a range extending from about 50 sccm to about 300 sccm. In some embodiments, generating the plasma in the operation 1805 includes supplying carbon tetrafluoride ($CF_4$) to the plasma processing region 109 at a flow rate within a range extending from about 50 sccm to about 200 sccm. In some embodiments, generating the plasma in the operation 1805 includes supplying oxygen ($O_2$) to the plasma processing region 109 at a flow rate within a range extending from about 20 sccm to about 300 sccm. In some embodiments, generating the plasma in the operation 1805 includes supplying trifluoromethane ($CHF_3$) to the plasma processing region 109 at a flow rate within a range extending from about 50 sccm to about 300 sccm. In some embodiments, generating the plasma in the operation 1805 includes supplying sulfur hexafluoride ($SF_6$) to the plasma processing region 109 at a flow rate within a range extending from about 50 sccm to about 300 sccm.

Figure 19 shows a flowchart of a method for manufacturing a substrate access port shield 1401/1401A for use in a plasma process chamber, in accordance with some embodiments. The method includes an operation 1901 for forming the substrate access port shield 1401/1401A to include the shield segment 1403, the first support segment 1405 extending from a first end of the shield segment 1403, and a second support segment 1407 extending from a second end of the shield segment 1403. The first support segment 1405 is configured to engage with a vertically movable component, e.g., with the focus ring structure 135/135-1, within a plasma process chamber, e.g., within the chamber 102. The second support segment 1407 is configured to engage with the vertically movable component within the chamber 102. The substrate access port shield 1401/1401A is formed to extend along an arc and to at least partially cover the opening 106A in the wall 105 of the chamber 102 that serves as a substrate access port, when the first support segment 1405 and the second support segment 1407 are engaged with the vertically movable component and when the vertically movable component is in a lowered vertical position. The substrate access port shield 1401/1401A is configured to uncover the opening 106A when the first support segment 1405 and the second support segment 1407 are engaged with the vertically movable component and when the vertically movable component is in a raised vertical position.

In some embodiments, forming the substrate access port shield 1401/1401A includes forming the cutout 1409A within the first support segment 1405 to receive a first portion of the vertically movable component, e.g., to receive the radial extension structure 135B1. Also, forming the substrate access port shield 1401/1401A can include forming the cutout 1409B within the second support segment 1407 to receive a second portion of the vertically movable component, e.g., to receive the radial extension structure 135B2. Also, forming the substrate access port shield 1401/1401A can include forming the cutout 1409C within the second support segment 1407 to receive a third portion of the vertically movable component, e.g., to receive the radial extension structure 135B3.

In some embodiments, operation 1901 includes forming the substrate access port shield 1401/1401A of aluminum oxide, silicon carbide, or of another ceramic material that is chemically, mechanically, thermally, and electrically compatible with operation of the plasma process chamber. In some embodiments, the operation 1901 includes roughening an exterior surface of the substrate access port shield 1401/1401A to have surface roughness average (Ra) within a range extending from about 150 microinches to about 500 microinches. In some embodiments, roughening of the exterior surface of the substrate access port shield 1401/1401A is done by a media blasting process that impacts the exterior surface of the substrate access port shield 1401/1401A with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite, among others. In some embodiments, operation 1901 includes performing a knurling process on the exterior surface of the substrate access port shield 1401/1401A prior to firing of the ceramic material of which the substrate access port shield 1401/1401A is formed. In some embodiments, a bare ceramic material of which the substrate access port shield 1401/1401A is formed is left exposed at the exterior surface of the substrate access port shield 1401/1401A.

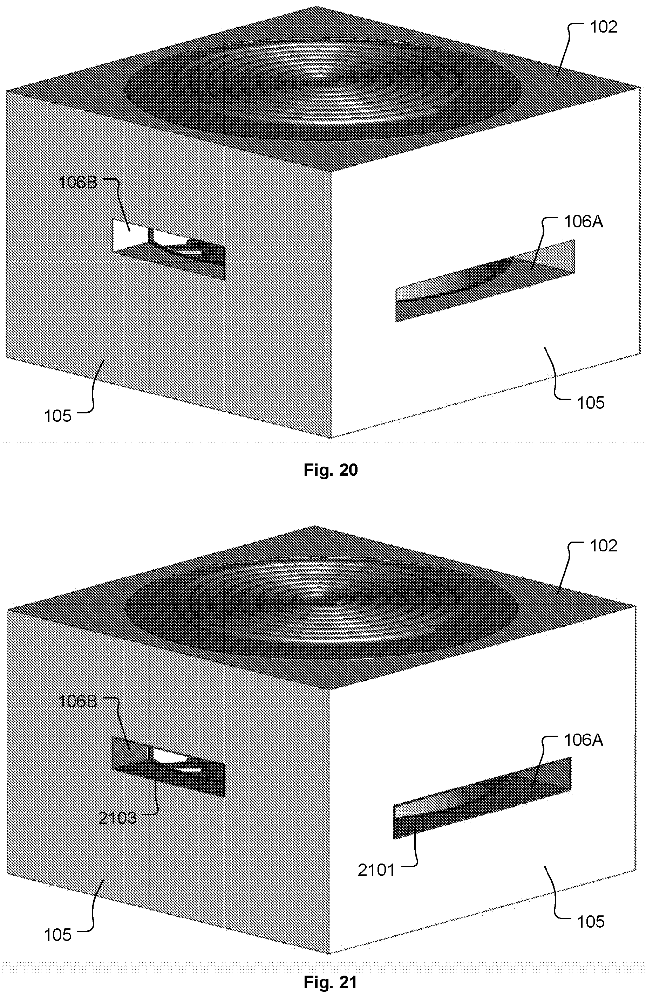

As discussed with regard to Figures 1A and 1B, the walls 105 of the chamber 102 can include openings for various purposes. For example, Figure 20 shows the chamber 102 with the opening 106A for transfer of the substrate 101 into and out of the chamber 102, in accordance with some embodiments. Also, Figure 20 shows the chamber 102 with the opening 106B that provides a viewport for viewing of a plasma processing region 109 within the chamber 102 either manually or by various equipment, in accordance with some embodiments. It should be understood that the openings 106A and 106B are provided by way of example. In various embodiments, the chamber 102 can include just the opening 106A, or the chamber 102 can include more openings than the openings 106A and 106B. Each opening, e.g., 106A, 106B, through the wall 105 of the chamber 102 forms a three-dimensional cavity, or passage, having a geometric configuration (depth and cross-section shape) defined by the geometry of the wall 105 at the location of the opening.

During plasma processing of the substrate 101 within the chamber 102, plasma process byproduct materials are free to move around in the chamber 102 in accordance with process gas flow patterns and/or existing pressure gradients. During plasma processing operations that generate non-volatile and/or low volatility byproduct materials, such as PZT etching processes or Pt etching processes, among others, it is possible for plasma process byproduct materials to travel into openings formed through the wall(s) 105 of the chamber 102, such as the openings 106A and 106B, and deposit on wall 105 surfaces within the openings. In low vacuum pressure plasma processes in which non-volatile and/or low-volatility plasma process byproduct materials are formed, such as in PZT etching processes and Pt etching processes, heavy byproduct deposition can buildup within the openings, e.g., 106A, 106B, formed through the walls 105 of the chamber 102. Due at least in part to the tight configuration of the openings, cleaning/removal of plasma process byproduct material that has deposited in the openings can be difficult, time-consuming, and expensive. Also, it is often necessary to clean/remove plasma process byproduct material that has deposited in the openings using physical/mechanical techniques, which adds to the difficulty, time, and expense of the cleaning process. The time required to clean plasma process byproduct material from within the wall 105 openings is added to the overall chamber cleaning time, thereby increasing the mean time to clean (MTTC) the chamber 102 and reduces the availability of the chamber 102 for semiconductor fabrication operations.

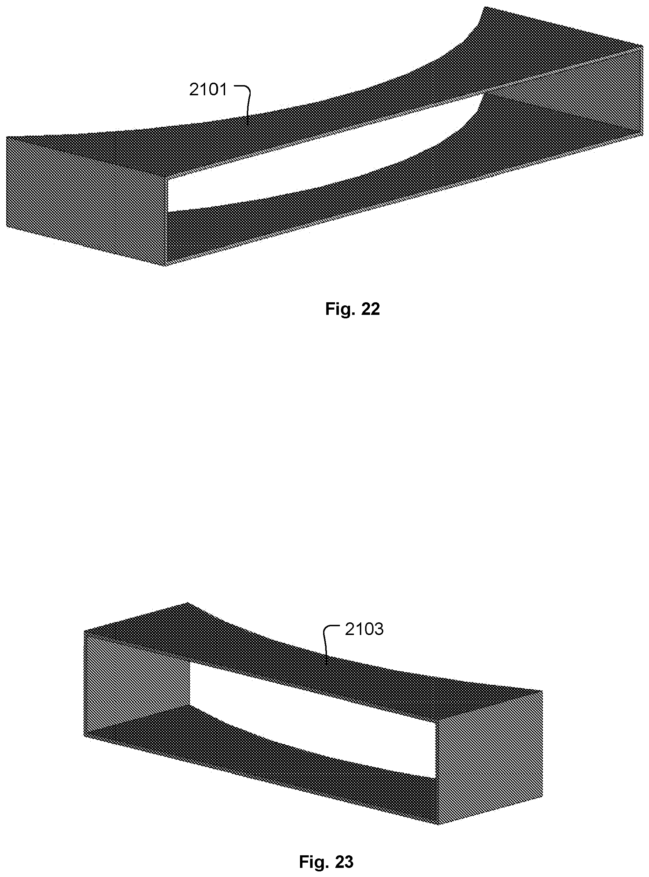

Various embodiments are disclosed herein for insert liners that can be inserted into openings, e.g., openings 106A, 106B, formed through the wall 105 of the chamber 102 to provide protection for the wall 105 surfaces within the openings and to provide sacrificial surfaces upon which plasma process by product material can deposit rather than depositing on the wall 105 surfaces within the openings. For example, Figure 21 shows an insert liner 2101 configured for insertion into the opening 106A and an insert liner 2103 configured for insertion into the opening 106B, in accordance with some embodiments. Figure 22 shows an isometric view of the insert liner 2101, in accordance with some embodiments. Figure 23 shows an isometric view of the insert liner 2103, in accordance with some embodiments.

In some embodiments, the insert liners 2101, 2103 can be fabricated from sheetmetal, such as from hard anodized aluminum sheetmetal, e.g., 5056 sheetmetal aluminum. The sheetmetal can be cut and bent into a configuration that is conformal with the opening 106A, 106B through chamber 102 wall 105 in which the insert liner is to be positioned. In some embodiments, the insert liners 2101, 2103 are formed from sheetmetal having a thickness within a range extending from about 0.030 inch to about 0.090 inch. In some embodiments, the inert liners 2101, 2103 can be formed from plate metal, such as from hard anodized aluminum plate, that is cut and welded into a configuration that is conformal with the opening 106A, 106B through chamber 102 wall 105 in which the insert liner is to be positioned. It should be appreciated that the insert liners 2101, 2103 are formed to substantially cover the wall 105 surfaces within the openings 106A, 106B.

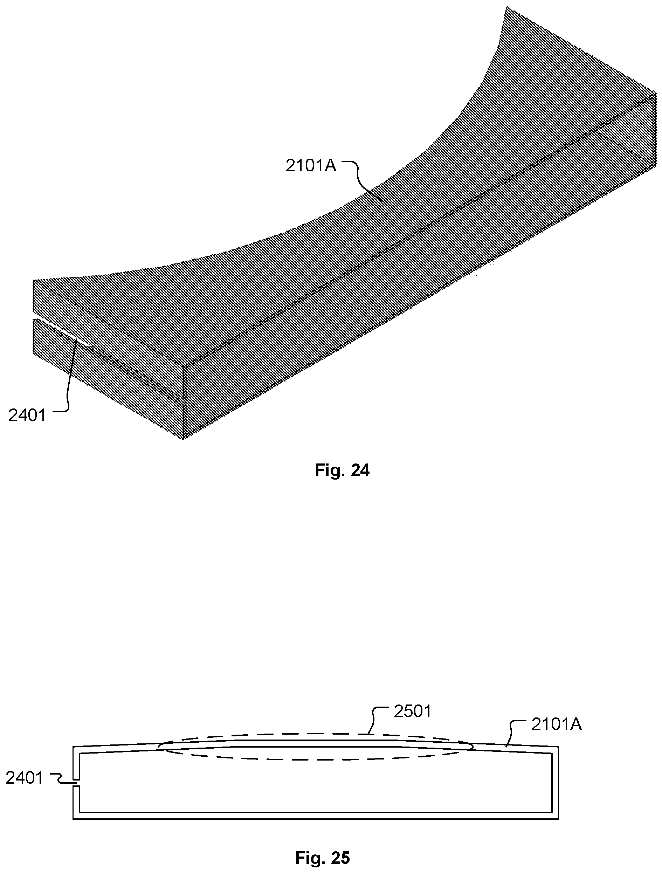

In some embodiments, such as shown in Figures 22 and 23, the insert liners 2101, 2103 can be formed to have a continuous structure, i.e., closed shape, that circumscribes a vertical cross-section of the opening 106A, 106B when inserted into the opening 106A, 106B. However, in some embodiments, the insert liners 2101, 2103 can be formed to have a non-continuous structure. For example, Figure 24 shows an insert liner 2101A that is a variation of the insert liner 2101, where the insert liner 2101A is cut through on a vertical side of the insert liner 2101A to form a gap 2401, in accordance with some embodiments. The gap 2401 separates a first edge of the insert liner 2101A from a second edge of the insert liner 2101A such that the gap 2401 forms a discontinuity in the outer surface profile of the insert liner 2101A. The gap 2401 provides mechanical flexibility to the insert liner 2101A for compression of the outer surface profile of the insert liner 2101A to enable insertion of the insert liner 2101A into the opening 106A.

In some embodiments, the insert liner 2101A has a spring property that allows the insert liner 2101A to push outward against the wall 105 surfaces when the insert liner 2101A is inserted into the opening 106A. For example, when the insert liner 2101A is made from sheetmetal, the sheetmetal can be bent so that the insert liner 2101A will exert a spring force against the wall 105 surfaces when the insert liner 2101A is inserted into the opening 106A. In these embodiments, the gap 2401 provides for compression of the insert liner 2101A to facilitate insertion of the insert liner 2101A into the opening 106A and removal of the insert liner 2101A from the opening 106A. In some embodiments, the insert liner 2101A having the gap 2401 can be compressed by hand. Also, in some embodiments, one or more outer surfaces of the insert liner 2101A can have a convex shape that enhances the spring force applied against the wall 105 surfaces when the insert liner 2101A is inserted into the opening 106A. For example, Figure 25 shows front view of an insert liner 2101B that is a variation of the insert liner 2101A that includes a convex region 2501 formed over an upper surface of the insert liner 2101B, in accordance with some embodiments. The example insert liner 2101B also includes the gap 2401. It should be understood that in some embodiments the insert liner 2103 can be configured to include a gap like the gap 2401 and/or include a convex region like the convex region 2501. In some embodiments the insert liner 2101, 2101A, 2101B, 2103 is configured to have mechanical flexibility sufficient for compression of an outer surface profile of the insert liner to enable insertion of the insert liner into the opening 106A, 106B.

The insert liners, e.g., 2101, 2101A, 2101B, 2103, are configured such that when installed within the openings 106A, 106B, required clearances are maintained through the openings 106A, 106B. It should be understood that the insert liners, e.g., 2101, 2101A, 2101B, 2103, can be installed within the openings 106A, 106B without use of hardware fasteners, adhesives, or other locking/fastening devices, because the insert liners are non-moving parts and the spring force applied by the insert liners against the wall 105 of the chamber 102 is sufficient to keep the insert liners within the openings 106A, 106B during operation of the chamber 102.

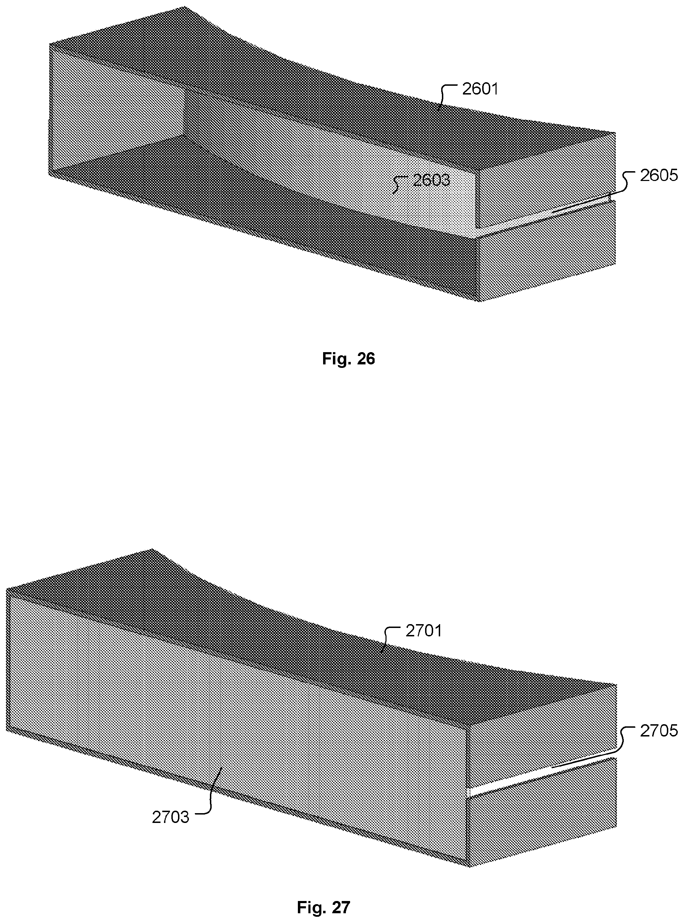

Also, in some plasma processing operations, an existing opening, e.g., 106B, formed through the wall 105 of the chamber 102 may not be needed. For this situation, an insert liner can be configured to completely block off the opening when the insert liner is inserted within the opening. For example, Figure 26 shows an insert liner 2601 that is configured to insert into the opening 106B and that includes a vertical surface 2603 that blocks off the opening 106B at the inner surface of the chamber 102 wall 105, in accordance with some embodiments. In some embodiments, the insert liner 2601 is formed of sheetmetal, as previously discussed with regard to the insert liners 2101, 2103. Also, in some embodiments, the insert liner 2601 can be formed to include a gap 2605 cut through a vertical side, similar to the gap 2401, to enable compression of the insert liner 2601 to facilitate insertion of the insert liner 2601 into the opening 106B and removal of the insert liner 2601 from the opening 106B. Also, in some embodiments, the insert liner 2601 can be formed to include one or more convex regions, like the convex region 2501, to provide/enhance a spring force applied by the insert liner 2601 against the wall 105 surfaces within the opening 106B.

Also, Figure 27 shows an insert liner 2701 that includes a vertical surface 2703 that substantially covers the surface of the window 108 that is exposed through the opening 106B, in accordance with some embodiments. The insert liner 2701 can be used when the opening 106B is not needed. In some embodiments, the insert liner 2701 is formed of sheetmetal, as previously discussed with regard to the insert liners 2101, 2103. Also, in some embodiments, the insert liner 2701 can be formed to include a gap 2705 cut through a vertical side, similar to the gap 2401, to enable compression of the insert liner 2701 to facilitate insertion of the insert liner 2701 into the opening 106B and removal of the insert liner 2701 from the opening 106B. Also, in some embodiments, the insert liner 2701 can be formed to include one or more convex regions, like the convex region 2501, to provide/enhance a spring force applied by the insert liner 2701 against the wall 105 surfaces within the opening 106B.

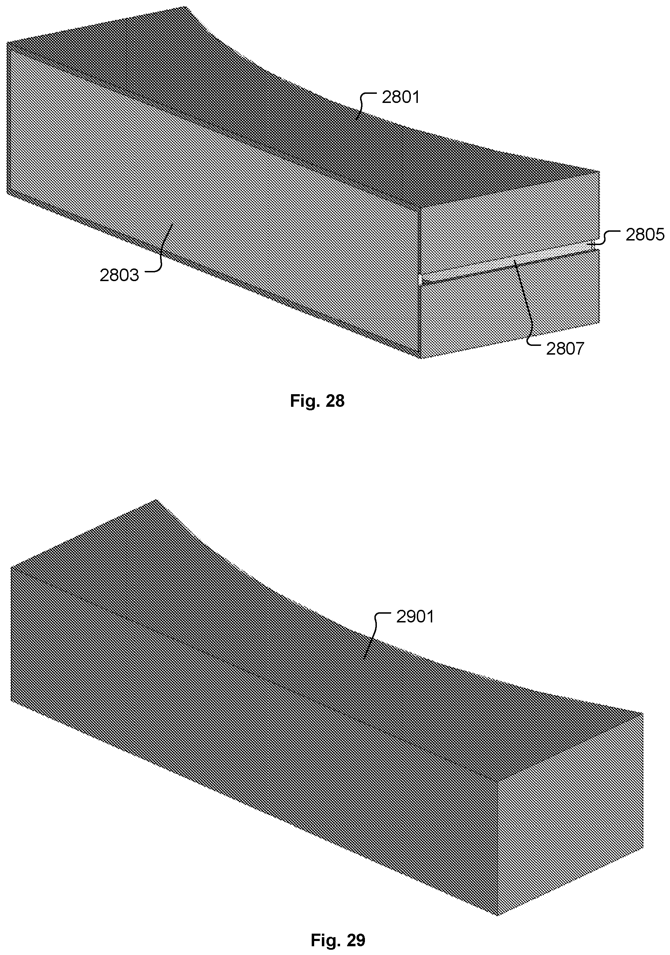

Additionally, Figure 28 shows an insert liner 2801 that includes a first vertical surface 2803 that substantially covers the surface of the window 108 that is exposed through the opening 106B, and that includes a second vertical surface 2805 that blocks off the opening 106B at the inner surface of the chamber 102 wall 105, in accordance with some embodiments. The insert liner 2801 can be used when the opening 106B is not needed. In some embodiments, the insert liner 2801 is formed of sheetmetal, as previously discussed with regard to the insert liners 2101, 2103. Also, in some embodiments, the insert liner 2801 can be formed to include a gap 2807 cut through a vertical side, similar to the gap 2801, to enable compression of the insert liner 2801 to facilitate insertion of the insert liner 2801 into the opening 106B and removal of the insert liner 2801 from the opening 106B. Also, in some embodiments, the insert liner 2801 can be formed to include one or more convex regions, like the convex region 2501, to provide/enhance a spring force applied by the insert liner 2801 against the wall 105 surfaces within the opening 106B.

In some embodiments, the insert for the opening 106A can be configured as a solid plug. Figure 29 shows an insert plug 2901 configured to just fit within the opening 106B and provide a continuation of a profile of the inner surface of the wall 105 of the chamber 102, in accordance with some embodiments. The insert plug 2901 can be used when the opening 106B is not needed. In some embodiments, the insert plug 2901 is machined from a block of aluminum or other suitable material that is chemically, mechanically, thermally, and electrically compatible for use within the chamber 102.

In some embodiments, the insert liners 2101, 2101A, 2101B, 2103, 2601, 2701, 2801 and/or the insert plug 2901 can be configured as a disposable component that can be removed and discarded during cleaning of the clamber 102. For example, when the insert liners 2101, 2101A, 2101B, 2103, 2601, 2701, 2801 are manufactured from low cost material, such as hard anodized aluminum sheetmetal, the insert liners 2101, 2101A, 2101B, 2103, 2601, 2701, 2801 can be considered a consumable component. However, in some embodiments, the insert liners 2101, 2101A, 2101B, 2103, 2601, 2701, 2801 and/or the insert plug 2901 can be cleaned and refurbished for re-use within the chamber 102.

Each of the insert liners 2101, 2101A, 2101B, 2103, 2601, 2701, 2801 and the insert plug 2901 has a process-exposed surface that is fluidly exposed to an interior region of the chamber 102 when the insert liner is inserted into the opening 106A, 106B. The process-exposed surface can be conditioned to promote adherence of plasma process byproduct material to the process-exposed surface. In some embodiments, the insert liners 2101, 2101A, 2101B, 2103, 2601, 2701, 2801 and/or the insert plug 2901 can be formed to have a prescribed surface roughness average (Ra) that promotes adhesion and retention of plasma process byproduct materials. In some embodiments, the surface of the insert liners 2101, 2101A, 2101B, 2103, 2601, 2701, 2801 and/or the insert plug 2901 has a surface roughness average (Ra) within a range extending from about 150 microinch to about 500 microinch. Also, in some embodiments, the insert liners 2101, 2101A, 2101B, 2103, 2601, 2701, 2801 and/or the insert plug 2901 can be formed to have a surface coating, such as a yttria coating or an anodization coating, among others.

It should be understood that use of the insert liners 2101, 2101A, 2101B, 2103, 2601, 2701, 2801 and/or the insert plug 2901 within a plasma etching chamber is of particular benefit due to the large amounts of non-volatile and/or low-volatility byproducts materials that are generated during etching processes, especially during PZT etching and Pt etching. The insert liners 2101, 2101A, 2101B, 2103, 2601, 2701, 2801 and the insert plug 2901 provide a low-cost and easy-to-maintain solution for management of plasma process byproduct material deposition within openings, e.g., 106A, 106B, formed through the walls 105 of the chamber 102. It should be appreciated that with use of the insert liners 2101, 2101A, 2101B, 2103, 2601, 2701, 2801 and/or the insert plug 2901, a technician no longer needs to spend a significant amount time cleaning the hard-to-reach wall 105 surfaces within the openings 106A, 106B during chamber 102 cleaning. Rather, the technician just needs to remove and replace the insert liners 2101, 2101A, 2101B, 2103, 2601, 2701, 2801 and/or the insert plug 2901. Therefore, the insert liners 2101, 2101A, 2101B, 2103, 2601, 2701, 2801 and/or the insert plug 2901 reduce operational cost and increase substrate 101 fabrication throughput by reducing the mean time to clean (MTTC) the chamber 102. In some embodiments, the time required to clean the wall 105 surfaces within the openings 106A, 106B is reduced by 50% or more. Also, use of the insert liners 2101, 2101A, 2101B, 2103, 2601, 2701, 2801 and/or the insert plug 2901 helps reduce particle generation within the chamber 102 because particles are not left trapped within the openings 106A, 106B for possible dislodgement during later chamber 102 operation. Additionally, use of the insert liners 2101, 2101A, 2101B helps prevent leaks through the access control device 1301 and maintain vacuum integrity within the chamber 102 by helping trap byproduct materials that deposit within the opening 106A.

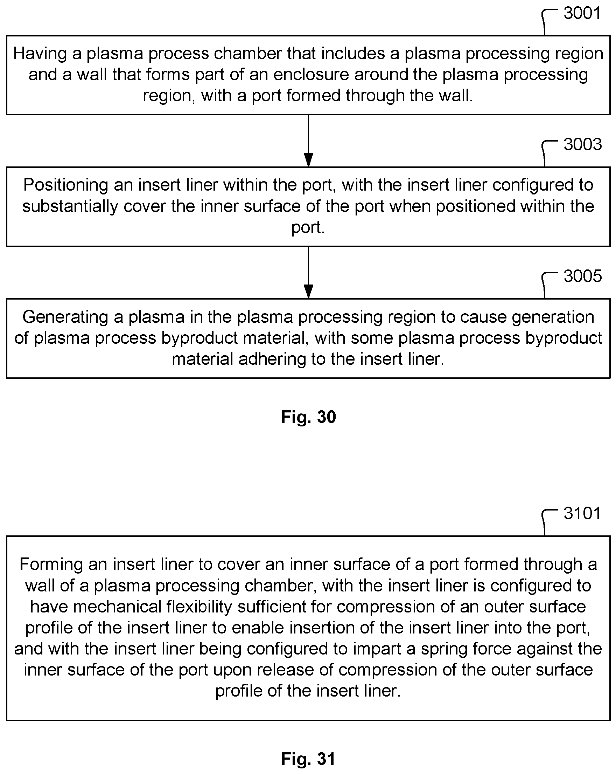

Figure 30 shows a flowchart of a method for plasma processing of a substrate, in accordance with some embodiments. The method includes an operation 3001 for having a plasma process chamber, i.e., chamber 102, that includes the plasma processing region 109 in which a plasma is generated during operation of the chamber 102. The chamber 102 includes the wall 105 that forms part of an enclosure around the plasma processing region 109. The wall 105 includes a port, e.g., opening 106A, 106B, formed through the wall 105. In some embodiment, the port is a substrate access port through which the substrate 101 is inserted into the chamber 102 and removed from the chamber 102. In some embodiments, the port is a viewport configured to provide for viewing of the plasma processing region 109.

The method includes an operation 3003 for positioning an insert liner, e.g., insert liner 2101, 2101A, 2101B, 2103, 2601, 2701, 2801, within the port. The insert liner is configured to cover an inner surface of the port. The insert liner is shaped to substantially cover the inner surface of the port when the insert liner is positioned within the port. In some embodiments, the insert liner includes a process-exposed surface that is fluidly exposed to the plasma processing region 109 when the insert liner is positioned in the port, with the process-exposed surface conditioned to promote adherence of plasma process byproduct material to the process-exposed surface. In some embodiments, the insert liner is configured to wrap around an open volume within the port and provide a view through the open volume within the port when the insert liner is positioned within the port. In some embodiments, the insert liner is configured to wrap around an open volume within the port and cover an outside boundary of the open volume within the port that is proximate to an outer surface of the wall 105 of the chamber 102 when the insert liner is positioned within the port. In some embodiments, the insert liner is configured to wrap around an open volume within the port and cover an inside boundary of the open volume within the port that is proximate to an inner surface of the wall 105 of the chamber 102 when the insert liner is positioned within the port. In some embodiments, the insert liner is configured to cover a portion of the inner surface of the wall 105 of the chamber 102 around the port when the insert liner is positioned within the port. In some embodiments, the operation 3003 includes positioning an insert plug, e.g., insert plug 2901, within the port.

The insert liner is configured to impart a spring force against the inner surface of the port to hold the insert liner in position within the port. In some embodiments, the spring force imparted by the insert liner against the inner surface of the port is sufficient to physically secure the insert liner within the port without use of an additional securing mechanism. In some embodiments, the operation 3003 includes applying compression to an outer surface profile of the insert liner to enable insertion of the insert liner into the port, and includes releasing compression of the outer surface profile of the insert liner so that the insert liner imparts the spring force against the inner surface of the port. In some embodiments, the insert liner includes a first edge separated from a second edge by a gap that forms a discontinuity in the outer surface profile of the insert liner. In these embodiments, the operation 3003 can include applying compression to an outer surface profile of the insert liner to close the gap to enable insertion of the insert liner into the port.

The method also includes an operation 3005 for generating a plasma in the plasma processing region 109 in exposure to the substrate 1001, such that constituents of the plasma interact with a material on the substrate 101 to generate plasma process byproduct material. In some embodiments, the material on the substrate 101 is a lead zirconate titanate (PZT) film. In some embodiments, the material on the substrate 101 is a platinum (Pt) film. In some embodiments, the material on the substrate 101 is a film that causes heavy byproduct deposition within the chamber 102 when exposed to the plasma generated in operation 3005. The insert liner prevents plasma process byproduct material from contacting the inner surface of the port. Also, in some embodiments, some of the plasma process byproduct material adheres to the insert liner.

In some embodiments, generating the plasma in the operation 3005 can include applying radiofrequency power to a process gas within the plasma processing region 109. In some embodiments, the applied radiofrequency power can be within a range extending from about 400 W to about 1250 W. However, it should be understood that in various embodiments the applied radiofrequency power can be less than 400 W or greater than 1250 W. In some embodiments, the radiofrequency power is applied by radiofrequency signals having a frequency of about 13.56 MHz. However, it should be understood that in various embodiments the radiofrequency power can be applied by radiofrequency signals having a frequency other than 13.56 MHz. Also, in some embodiments, the method can include an operation for generating a bias voltage at the substrate support structure 103. In some embodiments, the bias voltage is generated within a range extending from about 100 V to about 600 V. However, it should be understood that in various embodiments the bias voltage can be less than 100 V or greater than 600 V. Also, in some embodiments, the bias voltage can be generated by radiofrequency signals having a frequency of about 13.56 MHz. However, it should be understood that in various embodiments the bias voltage can be generated by radiofrequency signals having a frequency other than 13.56 MHz. Also, in various embodiments, the bias voltage can be generated by a direct current source.

Also, in some embodiments, the method can include an operation for maintaining a temperature of the substrate support structure 103 within a range extending from about 40° C to about 100° C. However, it should be understood that in various embodiments the temperature of the substrate support structure 103 can be maintained at less than 40° C or greater than 100° C. Also, in some embodiments, the method can include an operation for maintaining a pressure within the plasma processing region 109 within a range extending from about 5 milliTorr to about 50 milliTorr. However, it should be understood that in various embodiments the pressure within the plasma processing region 109 can be maintained at less that 5 milliTorr or greater than 50 milliTorr.

In some embodiments, generating the plasma in the operation 3005 includes supplying process gas to the plasma processing region 109, where the process gas is one or more of chlorine ($Cl_2$), boron trichloride ($BCl_3$), argon (Ar), carbon tetrafluoride ($CF_4$), oxygen ($O_2$), trifluoromethane ($CHF_3$), and sulfur hexafluoride ($SF_6$). In some embodiments, generating the plasma in the operation 3005 includes supplying chlorine ($Cl_2$) to the plasma processing region 109 at a flow rate within a range extending from about 20 sccm to about 300 sccm. In some embodiments, generating the plasma in the operation 3005 includes supplying boron trichloride ($BCl_3$) to the plasma processing region 109 at a flow rate within a range extending from about 50 sccm to about 300 sccm. In some embodiments, generating the plasma in the operation 3005 includes supplying argon (Ar) to the plasma processing region 109 at a flow rate within a range extending from about 50 sccm to about 300 sccm. In some embodiments, generating the plasma in the operation 3005 includes supplying carbon tetrafluoride ($CF_4$) to the plasma processing region 109 at a flow rate within a range extending from about 50 sccm to about 200 sccm. In some embodiments, generating the plasma in the operation 3005 includes supplying oxygen ($O_2$) to the plasma processing region 109 at a flow rate within a range extending from about 20 sccm to about 300 sccm. In some embodiments, generating the plasma in the operation 3005 includes supplying trifluoromethane ($CHF_3$) to the plasma processing region 109 at a flow rate within a range extending from about 50 sccm to about 300 sccm. In some embodiments, generating the plasma in the operation 3005 includes supplying sulfur hexafluoride ($SF_6$) to the plasma processing region 109 at a flow rate within a range extending from about 50 sccm to about 300 sccm.

Figure 31 shows a flowchart of a method for manufacturing an insert liner, e.g., insert liner 2101, 2101A, 2101B, 2103, 2601, 2701, 2801, for a plasma process chamber, e.g., chamber 102, in accordance with some embodiments. The method includes an operation 3101 for forming the insert liner to cover an inner surface of a port, e.g., opening 106A, 106B, formed through the wall 105 of the chamber 102. The insert liner is configured to have mechanical flexibility sufficient for compression of an outer surface profile of the insert liner to enable insertion of the insert liner into the port. The insert liner is configured to impart a spring force against the inner surface of the port upon release of compression of the outer surface profile of the insert liner.

With reference back to Figure 1B, during operation of the chamber 102, process gases are drawn by the pump 123 from the plasma processing region 109 through the exhaust channel 121 and ducting/tubing 122 to the pump 123. Non-volatile and/or low-volatility plasma process byproduct materials can be entrained within the flow of process gases moving through the exhaust channel 121 and ducting/tubing 122 to the pump 123. As the system 100 is operated, plasma process byproduct materials can deposit within the exhaust channel 121 and ducting/tubing 122 and pump 123. In some embodiments, the pump 123 is a turbo-molecular pump than include a rotor with turbine blades. Over time, the plasma process byproduct materials can clog up the turbine blades of the pump 123, which can cause elevated operating temperatures, higher power consumption, friction, wear, premature failure of the pump 123, and total pump 123 failure due to movement seizure of the rotor. It is therefore of interest to reduce an amount of non-volatile and/or low-volatility plasma process byproduct materials that reach the pump 123, especially in plasma processes that generate large amounts of such byproduct material, such as in PZT etching processes and Pt etching processes.

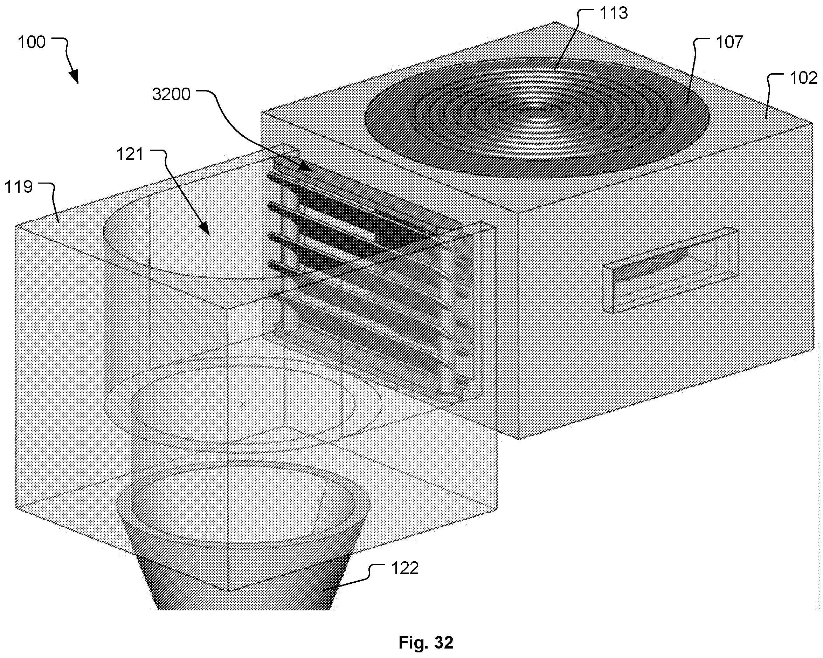

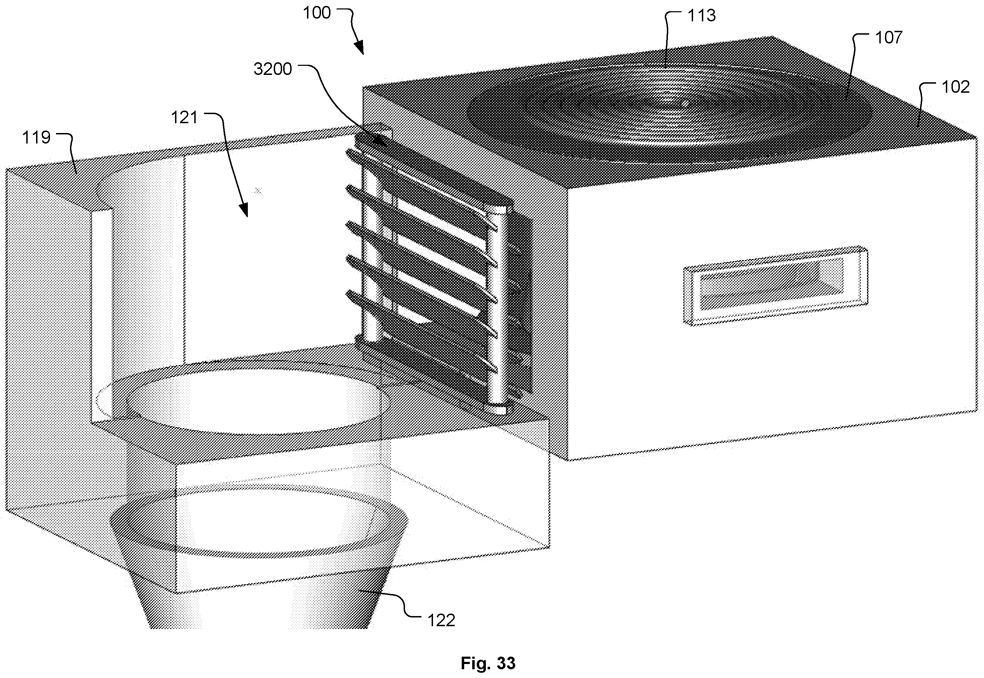

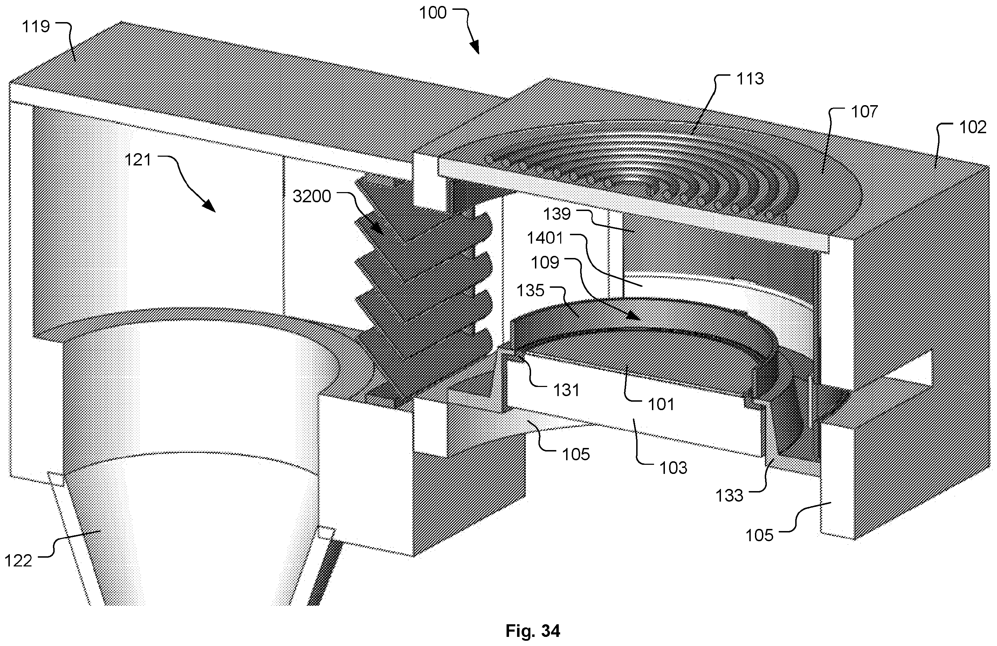

Figure 32 shows an example exhaust baffle assembly 3200 positioned within the exhaust channel 121 of the exhaust assembly 119, in accordance with some example embodiments. In Figure 32, the exhaust assembly 119 is shown in a transparent format to enable display of the exhaust baffle assembly 3200. Figure 33 shows the exhaust baffle assembly 3200 positioned within the exhaust channel 121 proximate to the chamber 102, in accordance with some embodiments. A cutaway view of the exhaust assembly 119 is shown in Figure 33 to enable display of the exhaust baffle assembly 3200. Figure 34 shows a vertical cross-section view through the chamber 102, the exhaust assembly 119, and the exhaust baffle assembly 3200, with the exhaust baffle assembly 3200 positioned at the exhaust exit from the chamber 102, in accordance with some embodiments.

Generally speaking, the exhaust baffle assembly 3200 serves to prolong the operational life of the pump 123 by mitigating risks associated by the downstream deposition of non-volatile and/or low-volatility plasma process byproduct materials. It should be understood that by installing the exhaust baffle assembly 3200 within the exhaust channel 121 between the chamber 102 and the pump 123 a tedious exhaust flow path is created, with the exhaust baffle assembly 3200 serving to contact and trap non-volatile and/or low-volatility plasma process byproduct materials that are entrained within the exhaust flow. Also, the surface texture and geometry of the exhaust baffle assembly 3200 can be configured to promote adherence and retention of the non-volatile and/or low-volatility plasma process byproduct materials to the exhaust baffle assembly 3200 until the chamber 102 cleaning process is performed. And, during chamber 102 cleaning, the exhaust baffle assembly 3200 can be removed for cleaning and a new/clean exhaust baffle assembly 3200 can be installed.

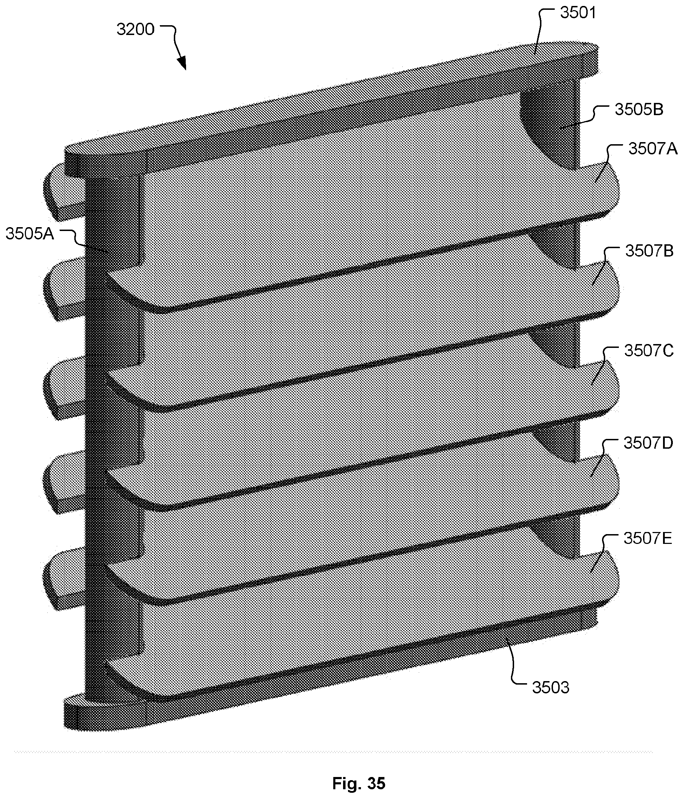

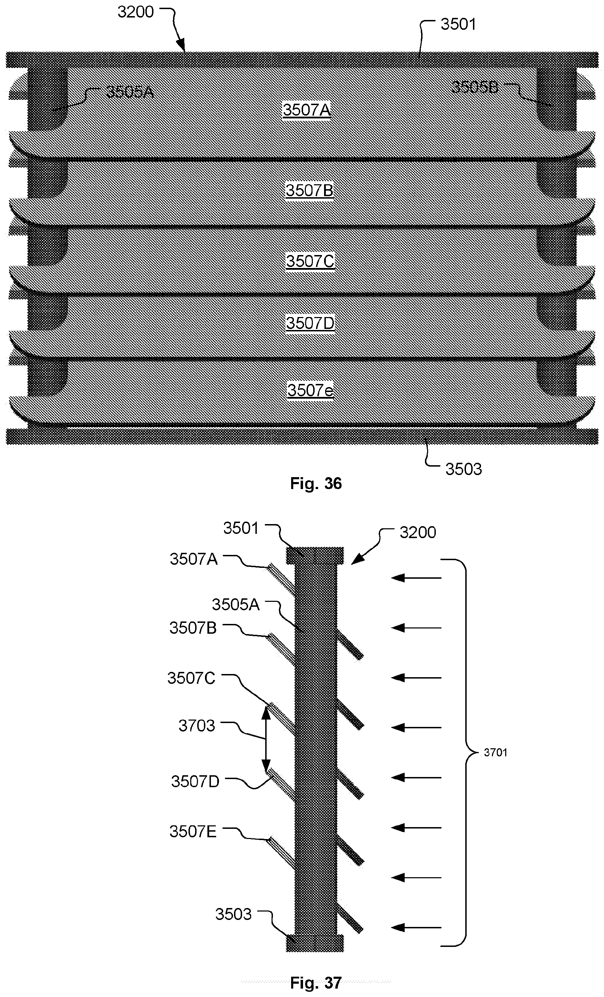

Figure 35 shows an isometric view of the example exhaust baffle assembly 3200, in accordance with some embodiments. The exhaust baffle assembly 3200 includes a top bar 3501, a bottom bar 3503, a first vertical support 3505A, a second vertical support 3505B, and five baffle members 3507A-3507E. Figure 36 shows a front view of the exhaust baffle assembly 3200, in accordance with some embodiments. Figure 37 shows a side view of the exhaust baffle assembly 3200, in accordance with some embodiments. In some embodiments, the exhaust baffle assembly 3200 is configured so that the baffle members 3507A-3507E insert into slots/cutouts formed within the first vertical support 3505A and the second vertical support 3505B, with each of the first vertical support 3505A and the second vertical support 3505B secured to both the top bar 3501 and the bottom bar 3503. In various embodiments, each of the first vertical support 3505A and the second vertical support 3505B can be secured to both the top bar 3501 and the bottom bar 3503 by welding or by fasteners, such as machine screws, or by a combination thereof. It should be understood from Figures 36 and 37 that essentially all of the exhaust flow from the plasma processing region 109 will be redirected by the combination of baffle members 3507A-3507E. Therefore, in some embodiments, the combination of baffle members 3507A-3507E is configured to extend across essentially all of the flow path through the exhaust channel 121 transverse to a primary exhaust flow direction 3701.

It should be understood that in various embodiments the exhaust baffle assembly 3200 can be configured to include one or more baffle members, e.g., 3507A-3507E. In various embodiments, the exhaust baffle assembly 3200 can have less than five or more than five baffle members, e.g., 3507A-3507E. The baffle members 3507A-3507E are configured to redirect the exhaust flow so that the plasma process byproduct materials within the exhaust flow will impact the baffle members 3507A-3507E. In some embodiments, the baffle members 3507A-3507E are oriented at an angle of about 45 degrees relative to the primary exhaust flow direction 3701, such as shown in Figure 37. However, it should be understood that in various embodiments, the baffle members 3507A-3507E can be oriented at an angle other than 45 degrees relative to the primary exhaust flow direction 3701. In some embodiments, the baffle members 3507A-3507E can be oriented at an angle relative to the primary exhaust flow direction 3701 within a range extending from about 25 degrees to about 75 degrees. Additionally, in some embodiments, each baffle member 3507A-3507E is oriented at substantially the same angle relative to the primary exhaust flow direction 3701. However, in some embodiments, different baffle members 3507A-3507E can be oriented at different angles relative to the primary exhaust flow direction 3701. Also, in some embodiments, the angle(s) of the baffle members 3507A-3507E is adjustable.

Also, as shown in Figure 37, in some embodiments, adjacent ones of the baffle members 3507A-3507E can be positioned in accordance with a vertical separation distance 3703 that is substantially equal. However, in some embodiments, the vertical separation distance 3703 can be different between different adjacent ones of the baffle members 3507A-3507E. Also, as shown in Figure 35, in some embodiments, each baffle member 3507A-3507E has substantially same shape and size. However, in some embodiments, the shape and/or size of different baffle members 3507A-3507E can be different. It should be understood that the shape, size, and relative positioning of the baffle members 3507A-3507E can be defined to optimize the interception of the exhaust flow and byproduct materials entrained therein by the exhaust baffle assembly 3200, while ensuring that a sufficient exhaust flow rate is maintained and that the pump 123 is not overburdened by a restriction in exhaust flow area caused by the exhaust baffle assembly 3200. In some embodiments, the exhaust baffle assembly 3200 is configured to reduce the normal, open cross-sectional flow area within the exhaust channel 121 by an amount within a range extending from about 20% to about 30%.

In some embodiments, the exhaust baffle assembly 3200 is formed of aluminum or of hard anodized aluminum. However, it should be understood that in various embodiments, the exhaust baffle assembly 3200 can be formed of essentially any material that is chemically, mechanically, thermally, and electrically suitable for exposure to the exhaust flow within the exhaust channel 121. Also, in some embodiments, the surfaces of the exhaust baffle assembly 3200 can be conditioned to promote adherence of plasma process byproduct material to the exhaust baffle assembly 3200 surfaces. In some embodiments, the exhaust baffle assembly 3200 can be formed to have a prescribed surface roughness average (Ra) that promotes adhesion and retention of plasma process byproduct materials. In some embodiments, the surfaces of the exhaust baffle assembly 3200 have a surface roughness average (Ra) within a range extending from about 150 microinches to about 500 microinches. Also, in some embodiments, the exhaust baffle assembly 3200 can be formed to have a surface coating, such as a yttria coating or an anodization coating, among others.

In some embodiments, the surfaces of the exhaust baffle assembly 3200 are roughened by a media blasting process. In various embodiments, the media blasting process can be defined and performed to increase the surface roughness, create high contact angles over the surface, and increase an overall surface area of the exhaust baffle assembly 3200. In various embodiments, the media blasting process can be defined and performed to impact the surfaces of the exhaust baffle assembly 3200 with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite, among other types of media. It should be understood that in some embodiments the media blasting process can provide for substantially even application of a prescribed roughness/texture over the surfaces of the exhaust baffle assembly 3200.

In various embodiments, the exhaust baffle assembly 3200 can configured for installation within the exhaust channel 121 with or without use of fastening devices. In some embodiments, the exhaust baffle assembly 3200 is configured to mate with one or more corresponding structures within the exhaust channel 121 so that the exhaust baffle assembly 3200 is held in place by the one or more corresponding structures within the exhaust channel 121 without the use of fastening devices. For example, in some embodiments, the bottom bar 3503 can include a number of protrusions that key into corresponding holes within the bottom of the exhaust channel 121 at a location just downstream from the chamber 102, and/or the top bar 3501 can include a number of protrusions that key into corresponding holes within the top of the exhaust channel 121 at a location just downstream from the chamber 102.

The exhaust baffle assembly 3200 provides for physical catching and retention of non-volatile and/or low-volatility plasma process byproduct materials that are entrained within the exhaust flow that proceeds from the plasma processing region 109 to the exhaust pump 123. Because the exhaust baffle assembly 3200 reduces the amount of non-volatile and/or low-volatility plasma process byproduct materials that move through the exhaust channel 121 and ducting/tubing 122, the exhaust baffle assembly 3200 serves to reduce the MTTC for the system 100 and thereby reduces chamber 102 downtime and correspondingly increases substrate 101 fabrication throughput. Also, in some embodiments, the exhaust baffle assembly 3200 can be quickly removed and replaced with a clean exhaust baffle assembly 3200 during chamber 102 cleaning, which helps achieve a lower MTTC for the chamber 102. In some embodiments, the exhaust baffle assembly 3200 can be cleaned and refurbished for re-use, which provides for reduced operation cost of the system 100.

Also, because the exhaust baffle assembly 3200 reduces the amount of non-volatile and/or low-volatility plasma process byproduct materials that enter the pump 123, the exhaust baffle assembly 3200 serves to extend the in-service lifetime of the pump 123 and reduce the probability of premature failure of the pump 123 due to byproduct material intrusion and buildup within the pump 123, especially with regard to byproduct material buildup on blades within the pump 123 and intrusion of byproduct material into bearing areas within the pump 123. Additionally, it should be appreciated that with less byproduct material buildup on the blades of the pump 123, due to the exhaust baffle assembly 3200 serving to capture some of the byproduct material, a high rotational speed of the pump 123 can be maintained over a longer operational time, which assists with maintaining a target exhaust flow rate from the plasma processing region 109, thereby reducing process impact/drift due to inadequate and/or varying exhaust flow rate from the plasma processing region 109. Additionally, the exhaust baffle assembly 3200 serves to extend the mean time between cleaning (MTBC) for the chamber 102. Because an operational problem with the pump 123 is often a reason for taking the chamber 102 out of service, use of the exhaust baffle assembly 3200 to help protect the pump 123 from byproduct material corruption can significantly increase the chamber availability, e.g., by more than 90%, and reduce the replacement rate of the pump 123, which serves to reduce operation costs of the system 100.

In some embodiments, an exhaust baffle assembly, e.g., 3200, includes at least one baffle member, e.g., 3507A-3507E, configured to fit within an exhaust channel, e.g., 121, of a plasma process chamber, e.g., 102. The at least one baffle member is shaped to deflect a flow of process exhaust gas when positioned within the exhaust channel. An outer surface of the at least one baffle member is conditioned to promote adherence of plasma process byproduct material present within the flow of process exhaust gas to the at least one baffle member. In some embodiments, the at least one baffle member has a substantially planar surface oriented at an angle transverse to a flow direction through the exhaust channel when the at least one baffle member is positioned within the exhaust channel. In some embodiments, the angle of the at least one baffle member is about 45 degrees relative to the flow direction. In some embodiments, the angle of the baffle member is adjustable. In some embodiments, the at least one baffle member is formed of anodized aluminum. In some embodiments, the at least one baffle member has a surface roughness average within a range extending from about 150 microinches to about 500 microinches.

In some embodiments, the exhaust baffle assembly, e.g., 3200, includes a frame configured to hold the at least one baffle member. In some embodiments, the frame includes a bottom bar, e.g., 3503, a top bar, e.g., 3501, a first end bar, e.g., 3505A, and a second end bar, e.g., 3505B. The first end bar extends between the top bar and the bottom bar. And, the second end bar extends between the top bar and the bottom bar. The at least one baffle member extends from the first end bar to the second end bar. In some embodiments, the frame is formed of anodized aluminum. In some embodiments, the frame has a surface roughness average (Ra) within a range extending from about 150 microinches to about 500 microinches.

In some embodiments, a plasma process system, e.g., system 100, includes a plasma process chamber, e.g., chamber 102, that includes a plasma processing region, e.g., 109, in which a plasma is generated during operation of the plasma process chamber. Also, the plasma process system includes an exhaust channel, e.g., exhaust channel 121, for the plasma process chamber. The exhaust channel fluidly connects to the plasma processing region. The exhaust channel is configured to direct a flow of process exhaust gas from the plasma processing region. The plasma process system also includes a pump, e.g., pump 123, connected to the exhaust channel. The pump is configured to apply a negative pressure to an interior of the exhaust channel. The plasma process system also includes an exhaust baffle assembly, e.g., exhaust baffle assembly 3200, positioned within the exhaust channel. The exhaust baffle assembly includes at least one baffle member, e.g., 3507A-3507E, shaped to deflect the flow of process exhaust gas within the exhaust channel. An outer surface of the at least one baffle member is conditioned to promote adherence of plasma process byproduct material present within the flow of process exhaust gas to the at least one baffle member. In some embodiments, the exhaust baffle assembly is configured to extend across essentially an entire cross-sectional flow area within the exhaust channel, such that the flow of process exhaust gas from the plasma processing region is required to flow through the exhaust baffle assembly.

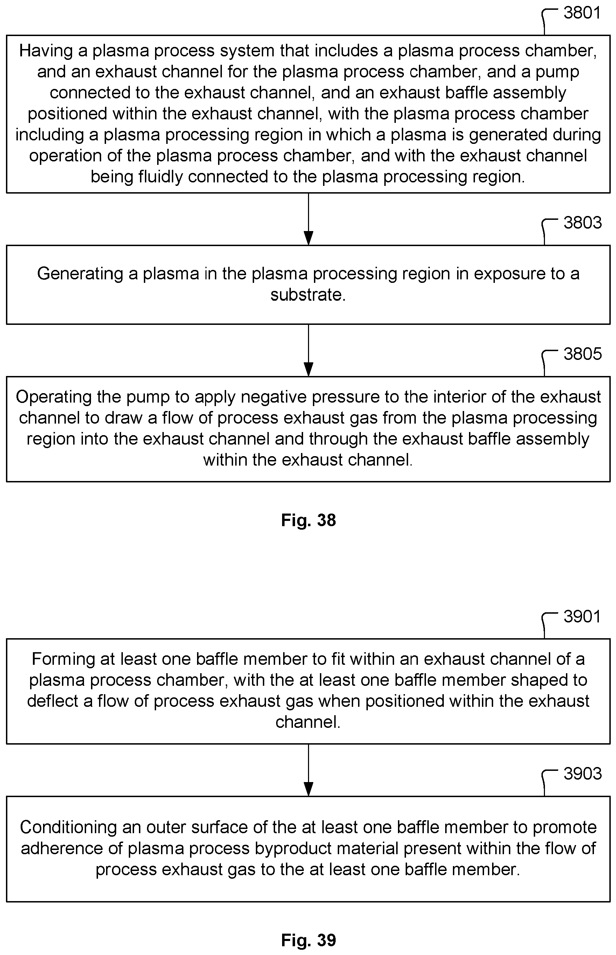

Figure 38 shows a flowchart of a method for plasma processing of a substrate, in accordance with some embodiments. The method includes an operation 3801 for having a plasma process system, e.g., system 100, that includes a plasma process chamber, e.g., chamber 102, and an exhaust channel, e.g., exhaust channel 121, for the plasma process chamber. The plasma process chamber includes a plasma processing region, e.g., 109, in which a plasma is generated during operation of the plasma process chamber. The exhaust channel is fluidly connected to the plasma processing region. The exhaust channel is configured to direct a flow of process exhaust gas from the plasma processing region. The plasma process system includes a pump, e.g., pump 123, connected to the exhaust channel. The pump is configured to apply a negative pressure to an interior of the exhaust channel. The plasma process system includes an exhaust baffle assembly, e.g., exhaust baffle assembly 3200, positioned within the exhaust channel. The exhaust baffle assembly includes at least one baffle member shaped to deflect the flow of process exhaust gas within the exhaust channel. An outer surface of the at least one baffle member is conditioned to promote adherence of plasma process byproduct material present within the flow of process exhaust gas to the at least one baffle member.

In some embodiments, the exhaust baffle assembly is configured to extend across essentially an entire cross-sectional flow area within the exhaust channel, such that the flow of process exhaust gas from the plasma processing region is required to flow through the exhaust baffle assembly. In some embodiments, the at least one baffle member has a substantially planar surface oriented at an angle transverse to a primary exhaust flow direction through the exhaust channel. In some embodiments, the angle of the at least one baffle member is about 45 degrees relative to the primary exhaust flow direction. In some embodiments, the angle of the at least one baffle member is adjustable. In some embodiments, the at least one baffle member is formed of anodized aluminum. In some embodiments, the at least one baffle member has a surface roughness average within a range extending from about 150 microinches to about 500 microinches.

The method also includes an operation 3803 for generating a plasma in the plasma processing region in exposure to a substrate. The method also includes an operation 3805 for operating the pump to apply the negative pressure to the interior of the exhaust channel to draw the flow of process exhaust gas from the plasma processing region into the exhaust channel and through the exhaust baffle assembly within the exhaust channel. Constituents of the plasma interact with a material on the substrate to generate plasma process byproduct material, with some of the plasma process byproduct material adhering to the at least one baffle member of the exhaust baffle assembly. In some embodiments, the material on the substrate is one or both of a lead zirconate titanate (PZT) film and a platinum (Pt) film.

Figure 39 shows a flowchart of a method for manufacturing an exhaust baffle assembly, e.g., exhaust baffle assembly 3200, for use in a plasma process system, e.g., system 100, in accordance with some embodiments. The method includes an operation 3901 for forming at least one baffle member, e.g., 3507A-3507E, to fit within an exhaust channel, e.g., 121, of a plasma process chamber, e.g., 102. The at least one baffle member is shaped to deflect a flow of process exhaust gas when positioned within the exhaust channel. The method also includes an operation 3903 for conditioning an outer surface of the at least one baffle member to promote adherence of plasma process byproduct material present within the flow of process exhaust gas to the at least one baffle member. In some embodiments, the at least one baffle member is formed to have a substantially planar surface oriented at an angle transverse to a primary exhaust flow direction through the exhaust channel when the at least one baffle member is positioned within the exhaust channel. In some embodiments, the at least one baffle member has a substantially planar surface oriented at an angle transverse to the primary exhaust flow direction through the exhaust channel. In some embodiments, the angle of the at least one baffle member is about 45 degrees relative to the primary exhaust flow direction. In some embodiments, the angle of the at least one baffle member is adjustable. In some embodiments, the at least one baffle member is formed of anodized aluminum. In some embodiments, the at least one baffle member has a surface roughness average within a range extending from about 150 microinches to about 500 microinches.

In some embodiments, the method includes forming a frame to hold the at least one baffle member. The frame includes a bottom bar, e.g., 3503, a top bar, e.g., 3501, a first end bar, e.g., 3505A, and a second end bar, e.g., 3505B. The first end bar extends between the top bar and the bottom bar. The second end bar extends between the top bar and the bottom bar. The at least one baffle member extends from the first end bar to the second end bar. In some embodiments, the frame is formed of anodized aluminum. In some embodiments, the frame has a surface roughness average within a range extending from about 150 microinches to about 500 microinches.

Although the foregoing invention has been described in some detail for purposes of clarity of understanding, it will be apparent that certain changes and modifications can be practiced within the scope of the appended claims. Accordingly, the present embodiments are to be considered as illustrative and not restrictive, and the invention is not to be limited to the details given herein, but may be modified within the scope and equivalents of the described embodiments.

The following paragraphs, describing aspects of the invention, are part of the description:

1. A surface-textured plasma process chamber component, comprising:
a ceramic component configured for placement within a plasma process chamber, the ceramic component including at least one roughened surface oriented to be in exposure to plasma process byproduct material when the ceramic component is placed within the plasma process chamber during operation of the plasma process chamber, the at least one roughened surface configured to promote adherence of the plasma process byproduct material to the ceramic component.

2. The surface-textured plasma process chamber component as recited in para. 1, wherein the ceramic component is formed of aluminum oxide.

3. The surface-textured plasma process chamber component as recited in para. 1, wherein the at least one roughened surface has a surface roughness average within a range extending from about 150 microinches to about 500 microinches.

4. The surface-textured plasma process chamber component as recited in para. 1, wherein a bare ceramic material of which the ceramic component is formed is exposed over the at least one roughened surface.

5. The surface-textured plasma process chamber component as recited in para. 1, wherein the at least one roughened surface is roughened by a media blasting process.

6. The surface-textured plasma process chamber component as recited in para. 5 , wherein the media blasting process impacts the at least one roughened surface with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite.

7. The surface-textured plasma process chamber component as recited in para. 1, wherein the at least one roughened surface is formed in part by a knurling process prior to firing of the ceramic component.

8. The surface-textured plasma process chamber component as recited in para. 1, wherein the ceramic component is a top window structure for installation within the plasma process chamber, the top window structure having a bottom surface, the bottom surface including the at least one roughened surface area oriented to be in exposure to plasma process byproduct material when the top window structure is placed within the plasma process chamber during operation of the plasma process chamber.

9. The surface-textured plasma process chamber component as recited in para. 8 , wherein the bottom surface includes an outer peripheral ring-shaped area configured to engage with a seal component, wherein the at least one roughened surface area is surrounded by the outer peripheral ring-shaped area, wherein the at least one roughened surface area is roughened to have a surface roughness average within a range extending from about 150 microinches to about 500 microinches, and wherein the outer peripheral ring-shaped area is smoothed to have a surface roughness average of about 20 microinches.

10. The surface-textured plasma process chamber component as recited in para. 1, wherein the ceramic component is a liner structure for installation within the plasma process chamber, the liner structure configured to extend around at least a portion of a plasma processing region within the plasma process chamber, the liner structure having an inner surface that is the at least one roughened surface oriented to be in exposure to plasma process byproduct material when the liner structure is placed within the plasma process chamber during operation of the plasma process chamber.

11. The surface-textured plasma process chamber component as recited in para. 1, wherein the ceramic component is a ring structure for installation within the plasma process chamber, the ring structure configured to circumscribe a substrate support structure within the plasma process chamber, the ring structure having at least one process-exposed surface that is one or both of an inner surface and an upper surface of the ring structure, wherein the at least one process-exposed surface is the at least one roughened surface oriented to be in exposure to plasma process byproduct material when the ring structure is placed within the plasma process chamber during operation of the plasma process chamber.

12. The surface-textured plasma process chamber component as recited in para. 11, wherein the ring structure is either a focus ring structure or an edge ring structure.

13. A plasma process chamber, comprising:

a substrate support structure configured to hold a substrate in exposure to a plasma during operation of the plasma process chamber; and a top window structure positioned above the substrate support structure to establish a plasma processing region between the substrate support structure and the top window structure, the top window structure formed of ceramic material, the top window structure having a bottom surface facing the plasma processing region, the bottom surface having a surface roughness that promotes adherence of plasma process byproduct material to the bottom surface.

14. The plasma process chamber as recited in para. 13, wherein the top window structure is formed of aluminum oxide.

15. The plasma process chamber as recited in para. 13, wherein the bottom surface of the top window structure has a surface roughness average within a range extending from about 150 microinches to about 500 microinches.

16. The plasma process chamber as recited in para. 13, wherein a bare ceramic material of which the top window structure is formed is exposed at the bottom surface of the top window structure.

17. The plasma process chamber as recited in para. 13, further comprising:
a liner structure configured to extend around at least a portion of the plasma processing region within the plasma process chamber, the liner structure formed of ceramic material, the liner structure having an inner surface facing the plasma processing region, the inner surface having a surface roughness that promotes adherence of plasma process byproduct material to the inner surface.

18. The plasma process chamber as recited in para. 17, wherein the liner structure is formed of aluminum oxide.

19. The plasma process chamber as recited in para. 17, wherein the inner surface of the liner structure has a surface roughness average within a range extending from about 150 microinches to about 500 microinches.

20. The plasma process chamber as recited in para. 17, wherein a bare ceramic material of which the liner structure is formed is exposed at the inner surface of the liner structure.

21. The plasma process chamber as recited in para. 13, further comprising:

a ring structure configured to circumscribe the substrate support structure within the plasma process chamber, the ring structure having at least one process-exposed surface that is one or both of an inner surface and an upper surface of the ring structure facing the plasma processing region, the at least one process-exposed surface having a surface roughness that promotes adherence of plasma process byproduct material to the at least one process-exposed surface.

22. The plasma process chamber as recited in para. 21, wherein the ring structure is either a focus ring structure, a ground ring structure, or an edge ring structure.

23. The plasma process chamber as recited in para. 21, wherein the ring structure is formed of aluminum oxide.

24. The plasma process chamber as recited in para. 21, wherein the at least one process-exposed surface of the ring structure has a surface roughness average within a range extending from about 150 microinches to about 500 microinches.

25. The plasma process chamber as recited in para. 21, wherein a bare ceramic material of which the ring structure is formed is exposed at the process-exposed surface of the ring structure.

26. The plasma process chamber as recited in para. 13, further comprising:

a coil assembly positioned above the top window structure, the coil assembly configured to transmit radiofrequency power through the top window structure to the plasma processing region.

27. A method for plasma processing of a substrate, comprising:

having a plasma process chamber that includes a substrate support structure and a top window structure, the substrate support structure configured to hold the substrate in exposure to a plasma, the top window structure positioned above the substrate support structure to establish a plasma processing region between the substrate support structure and the top window structure, the top window structure formed of ceramic material, the top window structure having a bottom surface facing the plasma processing region, the bottom surface having a surface roughness that promotes adherence of plasma process byproduct material to the bottom surface; and

generating a plasma in the plasma processing region, constituents of the plasma interacting with a material on the substrate to generate plasma process byproduct material, some of the plasma process byproduct material adhering to the bottom surface of the top window structure.

28. The method as recited in para. 27, wherein the material on the substrate is one or both of a lead zirconate titanate film and a platinum film.

29. The method as recited in para. 28, wherein generating the plasma includes applying radiofrequency power to a process gas within the plasma processing region, the radiofrequency power within a range extending from about 400 Watts (W) to about 1250 W.

30. The method as recited in para. 29, wherein the radiofrequency power is applied by radiofrequency signals having a frequency of about 13.56 MHz.

31. The method as recited in para. 29, further comprising:

generating a bias voltage at the substrate support structure, the bias voltage within a range extending from about 100 V to about 600 V.

32. The method as recited in para. 29, wherein the process gas is one or more of chlorine ($Cl_2$), boron trichloride ($BCl_3$), argon (Ar), carbon tetrafluoride ($CF_4$), oxygen ($O_2$), trifluoromethane ($CHF_3$), and sulfur hexafluoride ($SF_6$).

33. The method as recited in para. 32, further comprising:

maintaining a temperature of the substrate support structure within a range extending from about 40° Celsius (C) to about 80° C.

34. The method as recited in para. 32, further comprising:

maintaining a pressure within the plasma processing region within a range extending from about 5 milliTorr to about 50 milliTorr.

35. The method as recited in para. 29, wherein the process gas includes one or more of chlorine ($Cl_2$) supplied to the plasma processing region at a flow rate within a range extending from about 20 standard cubic centimeters per minute (sccm) to about 300 sccm, boron trichloride ($BCl_3$) supplied to the plasma processing region at a flow rate within a range extending from about 50 sccm to about 300 sccm, argon (Ar) supplied to the plasma processing region at a flow rate within a range extending from about 50 sccm to about 300 sccm, carbon tetrafluoride ($CF_4$) supplied to the plasma processing region at a flow rate within a range extending from about 50 sccm to about 200 sccm, oxygen ($O_2$) supplied to the plasma processing region at a flow rate within a range extending from about 20 sccm to about 300 sccm, trifluoromethane ($CHF_3$) supplied to the plasma processing region at a flow rate within a range extending from about 50 sccm to about 300 sccm, and sulfur hexafluoride ($SF_6$) supplied to the plasma processing region at a flow rate within a range extending from about 50 sccm to about 300 sccm.

36. The method as recited in para. 27, wherein the top window structure is formed of aluminum oxide.

37. The method as recited in para. 27, wherein the bottom surface of the top window structure has a surface roughness average within a range extending from about 150 microinches to about 500 microinches.

38. The method as recited in para. 27, wherein a bare ceramic material of which the top window structure is formed is exposed at the bottom surface of the top window structure.

39. The method as recited in para. 27, further comprising:

using a liner structure within the plasma process chamber, the liner structure configured to extend around at least a portion of the plasma processing region within the plasma process chamber, the liner structure having an inner surface that is oriented to be in exposure to the plasma process byproduct material, the inner surface of the liner structure having a surface roughness that promotes adherence of the plasma process byproduct material to the inner surface of the liner structure.

40. The method as recited in para. 39, wherein the liner structure is formed of aluminum oxide.

41. The method as recited in para. 39, wherein the inner surface of the liner structure has a surface roughness average within a range extending from about 150 microinches to about 500 microinches.

42. The method as recited in para. 39, wherein a bare ceramic material of which the liner structure is formed is exposed at the inner surface of the liner structure.

43. The method as recited in para. 27, further comprising:

using a ring structure within the plasma process chamber, the ring structure configured to circumscribe the substrate support structure within the plasma process chamber, the ring structure having at least one process-exposed surface that is one or both of an inner surface and an upper surface of the ring structure, wherein the at least one process-exposed surface is oriented to be in exposure to the plasma process byproduct material, the process-exposed surface of the ring structure having a surface roughness that promotes adherence of the plasma process byproduct material to the process-exposed surface of the ring structure.

44. The method as recited in para. 43, wherein the ring structure is either a focus ring structure, a ground ring structure, or an edge ring structure.

45. The method as recited in para. 43, wherein the ring structure is formed of aluminum oxide.

46. The method as recited in para. 43, wherein the process-exposed surface of the ring structure has a surface roughness average within a range extending from about 150 microinches to about 500 microinches.

47. The method as recited in para. 43, wherein a bare ceramic material of which the ring structure is formed is exposed at the process-exposed surface of the ring structure.

48. A method for manufacturing a component for use within a plasma process chamber, comprising:

forming a ceramic component for installation within a plasma process chamber, the ceramic component having at least one process-exposed surface; and
roughening the at least one process-exposed surface to have a surface roughness average within a range extending from about 150 microinches to about 500 microinches.

49. The method as recited in para. 48, wherein roughening the at least one process-exposed surface is done by a media blasting process.

50. The method as recited in para. 49, wherein the media blasting process impacts the at least one process-exposed surface with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite.

51. The method as recited in para. 48, wherein roughening the at least one process-exposed surface is done by a knurling process prior to firing of the ceramic component.

52. The method as recited in para. 48, wherein the ceramic component is formed of aluminum oxide.

53. The method as recited in para. 48, wherein a bare ceramic material of which the ceramic component is formed is exposed at the at least one process-exposed surface after roughening of the at least one process-exposed surface.

54. The method as recited in para. 48, wherein the ceramic component is either a top window structure, a liner structure, a focus ring structure, or an edge ring structure.

55. A method for converting a coated component for use within a plasma process chamber into a surface-roughened component for use within the plasma process chamber, comprising:

stripping a coating from a ceramic component down to a bare ceramic material of which the ceramic component is formed, the ceramic component configured for installation within a plasma process chamber, the ceramic component having at least one process-exposed surface; and

roughening the at least one process-exposed surface to have a surface roughness average within a range extending from about 150 microinches to about 500 microinches.

56. The method as recited in para. 55, wherein roughening the at least one process-exposed surface is done by a media blasting process.

57. The method as recited in para. 56, wherein the media blasting process impacts the at least one process-exposed surface with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite.

58. The method as recited in para. 55, wherein the ceramic component is formed of aluminum oxide.

59. The method as recited in para. 55, wherein the bare ceramic material of which the ceramic component is formed is exposed at the at least one process-exposed surface after roughening of the at least one process-exposed surface.

60. The method as recited in para. 55, wherein the ceramic component is either a top window structure, a liner structure, a focus ring structure, or an edge ring structure.

61. A focus ring for use in a plasma process chamber, comprising:

a ring structure formed of a ceramic material, the ring structure configured to circumscribe a substrate support structure within a plasma process chamber, the ring structure having an inner surface oriented to be in exposure to plasma process byproduct material when the ring structure is placed within the plasma process chamber during operation of the plasma process chamber, the inner surface formed to have a controlled surface topographical variation that promotes adherence of the plasma process byproduct material to the inner surface.

62. The focus ring as recited in para. 61, wherein the controlled surface topographical variation includes a lattice of convex structures that extend inward toward an area circumscribed by the ring structure.

63. The focus ring as recited in para. 62, wherein the lattice of convex structures is one or more of a square lattice, a hexagonal lattice, a rectangular lattice, a parallelogrammic lattice, and a rhombic lattice.

64. The focus ring as recited in para. 62, wherein each convex structure has a dome shape.

65. The focus ring as recited in para. 62, wherein a spacing between adjacent convex structures is within a range extending from about 0.5 millimeter to about 2 millimeters.

66. The focus ring as recited in para. 62, wherein a spacing between adjacent convex structures is about 1 millimeter.

67. The focus ring as recited in para. 62, wherein each convex structure extends inward toward the area circumscribed by the ring structure by a distance within a range extending from about 0.5 millimeter to about 2 millimeters, or by a distance within a range extending from about 1 millimeter to about 2 millimeters, or by a distance of about 1 millimeter.

68. The focus ring as recited in para. 62, wherein each convex structure has a base width within a range extending from about 1 millimeter to about 3 millimeters, or within a range extending from about 2 millimeters to about 3 millimeters, or of about 2.5 millimeters.

69. The focus ring as recited in para. 62, wherein the inner surface has a surface roughness average within a range extending from about 150 microinches to about 500 microinches.

70. The focus ring as recited in para. 61, wherein the ring structure is formed of aluminum oxide.

71. The focus ring as recited in para. 61, wherein the ring structure is a right circular hollow cylinder.

72. The focus ring as recited in para. 71, further comprising:

three radial extension structures configured to extend radially outward from an outer surface of the ring structure, the three radial extension structures spaced apart along an outer perimeter of the ring structure, the three radial extension structures configured to engage with three respective lifting components to enable raising and lowering of the ring structure relative to the substrate support structure when the ring structure is placed within the plasma process chamber.

73. The focus ring as recited in para. 72, wherein the inner surface of the ring structure and a top surface of the ring structure and top surfaces of the three radial extension structures have a surface roughness average within a range extending from about 150 microinches to about 500 microinches.

74. A plasma process chamber, comprising:

a substrate support structure configured to hold a substrate in exposure to a plasma during operation of the plasma process chamber; and a focus ring including a ring structure formed of a ceramic material, the ring structure configured to circumscribe the substrate support structure within the plasma process chamber, the ring structure having an inner surface oriented to be in exposure to plasma process byproduct material during operation of the plasma process chamber, the inner surface formed to have a controlled surface topographical variation that promotes adherence of the plasma process byproduct material to the inner surface.

75. The plasma process chamber as recited in para. 74, wherein the controlled surface topographical variation includes a lattice of convex structures that extend inward toward an area circumscribed by the ring structure.

76. The plasma process chamber as recited in para. 75, wherein the lattice of convex structures is one or more of a square lattice, a hexagonal lattice, a rectangular lattice, a parallelogrammic lattice, and a rhombic lattice.

77. The plasma process chamber as recited in para. 75, wherein each convex structure has a dome shape.

78. The plasma process chamber as recited in para. 75, wherein a spacing between adjacent convex structures is within a range extending from about 0.5 millimeter to about 2 millimeters.

79. The plasma process chamber as recited in para. 75, wherein a spacing between adjacent convex structures is about 1 millimeter.

80. The plasma process chamber as recited in para. 75, wherein each convex structure extends inward toward the area circumscribed by the ring structure by a distance within a range extending from about 0.5 millimeter to about 2 millimeters, or by a distance within a range extending from about 1 millimeter to about 2 millimeters, or by a distance of about 1 millimeter.

81. The plasma process chamber as recited in para. 75, wherein each convex structure has a base width within a range extending from about 1 millimeter to about 3 millimeters, or within a range extending from about 2 millimeters to about 3 millimeters, or of about 2.5 millimeters.

82. The plasma process chamber as recited in para. 75, wherein the inner surface has a surface roughness average within a range extending from about 150 microinches to about 500 microinches.

83. The plasma process chamber as recited in para. 74, wherein the ring structure is formed of aluminum oxide.

84. The plasma process chamber as recited in para. 74, wherein the ring structure is a right circular hollow cylinder.

85. The plasma process chamber as recited in para. 84, further comprising:

three radial extension structures configured to extend radially outward from an outer surface of the ring structure, the three radial extension structures spaced apart along an outer perimeter of the ring structure, the three radial extension structures configured to engage with three respective lifting components to enable raising and lowering of the ring structure relative to the substrate support structure.

86. The plasma process chamber as recited in para. 85, wherein the inner surface of the ring structure and a top surface of the ring structure and top surfaces of the three radial extension structures have a surface roughness average within a range extending from about 150 microinches to about 500 microinches.

87. A method for plasma processing of a substrate, comprising:

having a plasma process chamber that includes a substrate support structure and a focus ring, the focus ring including a ring structure formed of a ceramic material, the ring structure configured to circumscribe the substrate support structure within the plasma process chamber, the ring structure having an inner surface oriented to be in exposure to plasma process byproduct material during operation of the plasma process chamber, the inner surface formed to have a controlled surface topographical variation that promotes adherence of the plasma process byproduct material to the inner surface; and

generating a plasma in a plasma processing region above the substrate support structure, constituents of the plasma interacting with a material on the substrate to generate plasma process byproduct material, some of the plasma process byproduct material adhering to the inner surface of the ring structure.

88. The method as recited in para. 87, wherein the material on the substrate is one or both of a lead zirconate titanate film and a platinum film.

89. The method as recited in para. 88, wherein generating the plasma includes applying radiofrequency power to a process gas within the plasma processing region, the radiofrequency power within a range extending from about 400 Watts (W) to about 1250 W.

90. The method as recited in para. 89, wherein the radiofrequency power is applied by radiofrequency signals having a frequency of about 13.56 MHz.

91. The method as recited in para. 89, further comprising:

generating a bias voltage at the substrate support structure, the bias voltage within a range extending from about 100 V to about 600 V.

92. The method as recited in para. 89, wherein the process gas is one or more of chlorine ($Cl_2$), boron trichloride ($BCl_3$), argon (Ar), carbon tetrafluoride ($CF_4$), oxygen ($O_2$), trifluoromethane ($CHF_3$), and sulfur hexafluoride ($SF_6$).

93. The method as recited in para. 92, further comprising:

maintaining a temperature of the substrate support structure within a range extending from about 40° Celsius (C) to about 80° C.

94. The method as recited in para. 92, further comprising:

maintaining a pressure within the plasma processing region within a range extending from about 5 milliTorr to about 50 milliTorr.

95. The method as recited in para. 89, wherein the process gas includes one or more of chlorine ($Cl_2$) supplied to the plasma processing region at a flow rate within a range extending from about 20 standard cubic centimeters per minute (sccm) to about 300 sccm, boron trichloride ($BCl_3$) supplied to the plasma processing region at a flow rate within a range extending from about 50 sccm to about 300 sccm, argon (Ar) supplied to the plasma processing region at a flow rate within a range extending from about 50 sccm to about 300 sccm, carbon tetrafluoride ($CF_4$) supplied to the plasma processing region at a flow rate within a range extending from about 50 sccm to about 200 sccm, oxygen ($O_2$) supplied to the plasma processing region at a flow rate within a range extending from about 20 sccm to about 300 sccm, trifluoromethane ($CHF_3$) supplied to the plasma processing region at a flow rate within a range extending from about 50 sccm to about 300 sccm, and sulfur hexafluoride ($SF_6$) supplied to the plasma processing region at a flow rate within a range extending from about 50 sccm to about 300 sccm.

96. The method as recited in para. 87, wherein the ring structure is formed of aluminum oxide.

97. The method as recited in para. 87, wherein the inner surface of the ring structure has a surface roughness average within a range extending from about 150 microinches to about 500 microinches.

98. The method as recited in para. 87, wherein a bare ceramic material of which the ring structure is formed is exposed at the inner surface of the ring structure.

99. The method as recited in para. 87, wherein the ring structure is a right circular hollow cylinder.

100. The method as recited in para. 99, wherein the focus ring structure includes three radial extension structures configured to extend radially outward from an outer surface of the ring structure, the three radial extension structures equally spaced apart along an outer perimeter of the ring structure, the three radial extension structures configured to engage with three respective lifting components to enable raising and lowering of the ring structure relative to the substrate support structure.

101. The method as recited in para. 100, wherein the inner surface of the ring structure and a top surface of the ring structure and top surfaces of the three radial extension structures have a surface roughness average within a range extending from about 150 microinches to about 500 microinches.

102. A method for manufacturing a focus ring for use in a plasma process chamber, comprising:

forming a ring structure of a ceramic material, the ring structure configured to circumscribe a substrate support structure within a plasma process chamber, the ring structure having an inner surface oriented to be in exposure to plasma process byproduct material when the ring structure is placed within the plasma process chamber during operation of the plasma process chamber; and
forming a controlled surface topographical variation on the inner surface of the ring structure, the controlled surface topographical variation promoting adherence of the plasma process byproduct material to the inner surface.

103. The method as recited in para. 102, wherein forming the controlled surface topographical variation on the inner surface of the ring structure includes performing a media blasting process through a mask disposed over the inner surface of the ring structure, the mask exposing portions of the inner surface of the ring structure for erosion to form the controlled surface topographical variation.

104. The method as recited in para. 103, wherein the media blasting process impacts the inner surface with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite.

105. The method as recited in para. 103, further comprising:

roughening the inner surface of the ring structure after forming the controlled surface topographical variation on the inner surface of the ring structure, the roughening performed to give the inner surface of the ring structure a surface roughness average within a range extending from about 150 microinches to about 500 microinches.

106. The method as recited in para. 105, wherein roughening the inner surface is done by the media blasting process.

107. The method as recited in para. 102, wherein forming the controlled surface topographical variation on the inner surface of the ring structure includes performing a knurling process on the inner surface prior to firing of the ceramic material.

108. The method as recited in para. 102, wherein the ceramic material is aluminum oxide.

109. The method as recited in para. 102, wherein the ceramic material of which the ring structure is formed is exposed at the inner surface after forming the controlled surface topographical variation on the inner surface of the ring structure.

110. The method as recited in para. 102, wherein the ring structure is a right circular hollow cylinder.

111. The method as recited in para. 110, wherein forming the ring structure includes forming three radial extension structures to extend radially outward from an outer surface of the ring structure, the three radial extension structures spaced apart along an outer perimeter of the ring structure, the three radial extension structures configured to engage with three respective lifting components to enable raising and lowering of the ring structure relative to the substrate support structure when the ring structure is placed within the plasma process chamber.

112. The method as recited in para. 111, further comprising:

roughening the inner surface of the ring structure after forming the controlled surface topographical variation on the inner surface of the ring structure, the roughening performed to give the inner surface of the ring structure a surface roughness average within a range extending from about 150 microinches to about 500 microinches; and

roughening top surfaces of the three radial extension structures to have a surface roughness average within a range extending from about 150 microinches to about 500 microinches.

113. A substrate access port shield for use in a plasma process chamber, comprising:

a shield segment;

a first support segment extending from a first end of the shield segment, the first support segment configured to engage with a vertically movable component within a plasma process chamber; and

a second support segment extending from a second end of the shield segment, the second support segment configured to engage with the vertically movable component within the plasma process chamber, the shield segment and the first and second support segments forming an integral shield structure that extends along an arc, wherein vertical movement of the vertically movable component causes corresponding vertical movement of the integral shield structure, the shield segment configured to at least partially cover a substrate access port opening of the plasma process chamber when the first and second support segments are engaged with the vertically movable component and the vertically movable component is in a lowered vertical position, the shield segment configured to uncover the substrate access port opening of the plasma process chamber when the first and second support segments are engaged with the vertically movable component and the vertically movable component is in a raised vertical position.

114. The substrate access port shield for use in the plasma process chamber as recited in para. 113, wherein the shield segment is configured as a portion of a right circular hollow cylinder.

115. The substrate access port shield for use in the plasma process chamber as recited in para. 114, wherein the shield segment has a vertical height measured in an axis direction of the right circular hollow cylinder, the vertical height of the shield segment enabling the shield segment to cover at least one-half of a vertical extent of the substrate access port opening of the plasma chamber when the first and second support segments are engaged with the vertically movable component and the vertically movable component is in the lowered vertical position.

116. The substrate access port shield for use in the plasma process chamber as recited in para. 114, wherein the shield segment has a vertical height measured in an axis direction of the right circular hollow cylinder, the vertical height of the shield segment enabling the shield segment to cover at least two-thirds of a vertical extent of the substrate access port opening of the plasma chamber when the first and second support segment are engaged with the vertically movable component and the vertically movable component is in the lowered vertical position.

117. The substrate access port shield for use in the plasma process chamber as recited in para. 114, wherein the shield segment has a vertical height measured in an axis direction of the right circular hollow cylinder, the vertical height of the shield segment enabling the shield segment to fully cover a vertical extent of the substrate access port opening of the plasma chamber when the first and second support segments are engaged with the vertically movable component and the vertically movable component is in the lowered vertical position.

118. The substrate access port shield for use in the plasma process chamber as recited in para. 113, wherein the shield segment is configured as a first portion of a right circular hollow cylinder, and the first support segment is configured as a second portion of the right circular hollow cylinder, and the second support segment is configured as a third portion of the right circular hollow cylinder, the shield segment having a first vertical height measured in an axis direction of the right circular hollow cylinder, the first support segment having a second vertical height measured in the axis direction of the right circular hollow cylinder, the second support segment having a third vertical height measured in the axis direction of the right circular hollow cylinder.

119. The substrate access port shield for use in the plasma process chamber as recited in para. 118, wherein the first vertical height, the second vertical height, and the third vertical height are substantially equal.

120. The substrate access port shield for use in the plasma process chamber as recited in para. 118, wherein the first vertical height is different than each of the second vertical height and the third vertical height.

121. The substrate access port shield for use in the plasma process chamber as recited in para. 120, wherein the second vertical height and the third vertical height are substantially equal.

122. The substrate access port shield for use in the plasma process chamber as recited in para. 118, wherein the first vertical height is less than each of the second vertical height and the third vertical height.

123. The substrate access port shield for use in the plasma process chamber as recited in para. 113, wherein the integral shield structure is formed of a ceramic material.

124. The substrate access port shield for use in the plasma process chamber as recited in para. 123, wherein the ceramic material is aluminum oxide.

125. The substrate access port shield for use in the plasma process chamber as recited in para. 123, wherein at least an inner surface of the integral shield structure has a surface roughness average within a range extending from about 150 microinches to about 500 microinches.

126. The substrate access port shield for use in the plasma process chamber as recited in para. 125, wherein the ceramic material of which the integral shield structure is formed is exposed at the inner surface of the integral shield structure.

127. The substrate access port shield for use in the plasma process chamber as recited in para. 113, wherein the vertically movable component is a focus ring structure.

128. The substrate access port shield for use in the plasma process chamber as recited in para. 127, wherein the focus ring structure is configured to circumscribe a substrate support structure within the plasma process chamber, the focus ring structure including a ring portion formed as a right circular hollow cylinder and three radial extension structures configured to extend radially outward from an outer surface of the ring portion, the three radial extension structures spaced apart along an outer perimeter of the ring portion, the first support segment configured to engage with a first of the three radial extension structures, the second support segment configured to engage with a second of the three radial extension structures.

129. The substrate access port shield for use in the plasma process chamber as recited in para. 128, wherein the three radial extension structures are configured to engage with three respective lifting components to enable raising and lowering of a combination of the focus ring structure and the integral shield structure relative to the substrate support structure.

130. The substrate access port shield for use in the plasma process chamber as recited in para. 128, wherein the first support segment is configured to engage with a third of the three radial extension structures.

131. A plasma process chamber, comprising:

a substrate support structure configured to hold a substrate in exposure to a plasma during operation of the plasma process chamber; a focus ring structure configured to circumscribe the substrate support structure within the plasma process chamber, the focus ring structure including a ring portion formed as a right circular hollow cylinder and three radial extension structures configured to extend radially outward from an outer surface of the ring portion, the three radial extension structures spaced apart along an outer perimeter of the ring portion; and an integral shield structure including a shield segment, a first support segment, and a second support segment, the first support segment extending from a first end of the shield segment, the first support segment configured to engage with a first of the three radial extension structures of the focus ring structure, the second support segment extending from a second end of the shield segment, the second support segment configured to engage with a second of the three radial extension structures of the focus ring structure, the integral shield structure formed to extend along an arc, the shield segment configured to at least partially cover a substrate access port opening of the plasma process chamber when the focus ring structure is in a lowered vertical position, the shield segment configured to uncover the substrate access port opening of the plasma process chamber when the focus ring structure is in a raised vertical position.

132. The plasma process chamber as recited in para. 131, wherein the integral shield structure is removable from the focus ring structure.

133. The plasma process chamber as recited in para. 131, wherein the integral shield structure is secured to the focus ring structure by gravity.

134. The plasma process chamber as recited in para. 131, wherein the integral shield structure connects to the focus ring structure in a fastener-free manner.

135. The plasma process chamber as recited in para. 131, wherein the first support segment includes a slot configured to receive the first of the three radial extension structures of the focus ring structure, and the second support segment includes a slot configured to receive the second of the three radial extension structures of the focus ring structure.

136. The plasma process chamber as recited in para. 131, wherein either the first support segment or the second support segment is configured to engage with a third of the three radial extension structures of the focus ring structure.

137. The plasma process chamber as recited in para. 136, wherein the first support segment includes a slot configured to receive the first of the three radial extension structures of the focus ring structure, and the second support segment includes a slot configured to receive the second of the three radial extension structures of the focus ring structure, and either the first support segment or the second support segment includes a slot configured to receive the third of the three radial extension structures of the focus ring structure.

138. The plasma process chamber as recited in para. 131, further comprising:

three lifting components configured to respectively engage with the three radial extension structures of the focus ring structure, the three lifting components configured to provide controlled vertical movement of a combination of the focus ring structure and the integral shield structure relative to the substrate support structure.

139. The plasma process chamber as recited in para. 131, wherein the shield segment of the integral shield structure is configured as a portion of a right circular hollow cylinder, the shield segment having a vertical height measured in an axis direction of the right circular hollow cylinder.

140. The plasma process chamber as recited in para. 139, wherein the vertical height of the shield segment enables the shield segment to cover at least one-half of a vertical extent of the substrate access port opening of the plasma chamber when the focus ring structure is in the lowered vertical position.

141. The plasma process chamber as recited in para. 139, wherein the vertical height of the shield segment enables the shield segment to cover at least two-thirds of a vertical extent of the substrate access port opening of the plasma chamber when the focus ring structure is in the lowered vertical position.

142. The plasma process chamber as recited in para. 139, wherein the vertical height of the shield segment enables the shield segment to fully cover a vertical extent of the substrate access port opening of the plasma chamber when the focus ring structure is in the lowered vertical position.

143. The plasma process chamber as recited in para. 131, wherein the integral shield structure is formed of a ceramic material.

144. The plasma process chamber as recited in para. 143, wherein the ceramic material is aluminum oxide.

145. The plasma process chamber as recited in para. 143, wherein at least an inner surface of the integral shield structure has a surface roughness average within a range extending from about 150 microinches to about 500 microinches.

146. The plasma process chamber as recited in para. 145, wherein the ceramic material of which the integral shield structure is formed is exposed at the inner surface of the integral shield structure.

147. A method for plasma processing of a substrate, comprising:

having a plasma process chamber that includes a substrate support structure, a focus ring structure, and an integral shield structure, the focus ring structure configured to circumscribe the substrate support structure, the focus ring structure including a ring portion formed as a right circular hollow cylinder and three radial extension structures configured to extend radially outward from an outer surface of the ring portion, the three radial extension structures spaced apart along an outer perimeter of the ring portion, the integral shield structure including a shield segment, a first support segment, and a second support segment, the first support segment extending from a first end of the shield segment, the first support segment configured to engage with a first of the three radial extension structures of the focus ring structure, the second support segment extending from a second end of the shield segment, the second support segment configured to engage with a second of the three radial extension structures of the focus ring structure, the integral shield structure formed to extend along an arc, the shield segment configured to at least partially cover a substrate access port opening of the plasma process chamber when the focus ring structure is in a lowered vertical position, the shield segment configured to uncover the substrate access port opening of the plasma process chamber when the focus ring structure is in a raised vertical position;

positioning the focus ring structure in the lowered vertical position; and

generating a plasma in a plasma processing region above the substrate support structure.

148. The method as recited in para. 147, wherein the shield segment of the integral shield structure covers at least one-half of a vertical extent of the substrate access port opening when the focus ring structure is positioned in the lowered vertical position.

149. The method as recited in para. 147, wherein the shield segment of the integral shield structure covers at least two-thirds of a vertical extent of the substrate access port opening when the focus ring structure is positioned in the lowered vertical position.

150. The method as recited in para. 147, wherein the shield segment of the integral shield structure fully covers a vertical extent of the substrate access port opening when the focus ring structure is positioned in the lowered vertical position.

151. The method as recited in para. 147, further comprising:

connecting the integral shield structure to the focus ring structure in a fastener-free manner.

152. The method as recited in para. 151, wherein the integral shield structure is secured to the focus ring structure by gravity.

153. The method as recited in para. 151, wherein connecting the integral shield structure to the focus ring structure in the fastener-free manner includes inserting the first of the three radial extension structures of the focus ring structure into a slot formed within the first support segment of the integral shield structure, and inserting the second of the three radial extension structures of the focus ring structure into a slot formed within the second support segment of the integral shield structure.

154. The method as recited in para. 153, wherein connecting the integral shield structure to the focus ring structure in the fastener-free manner further includes inserting a third of the three radial extension structures of the focus ring structure into a slot formed within either the first support segment or the second support segment of the integral shield structure.

155. The method as recited in para. 147, wherein positioning the focus ring structure in the lowered vertical position includes operating three lifting components that respectively engage with the three radial extension structures of the focus ring structure.

156. The method as recited in para. 147, further comprising:

ceasing generation of the plasma in the plasma processing region above the substrate support structure; and
positioning the focus ring structure in the raised vertical position.

157. The method as recited in para. 147, wherein the integral shield structure is formed of a ceramic material.

158. The method as recited in para. 157, wherein the ceramic material is aluminum oxide.

159. The method as recited in para. 157, wherein at least an inner surface of the integral shield structure has a surface roughness average within a range extending from about 150 microinches to about 500 microinches.

160. The method as recited in para. 159, wherein the ceramic material of which the integral shield structure is formed is exposed at the inner surface of the integral shield structure.

161. The method as recited in para. 147, wherein constituents of the plasma interact with a material on the substrate to generate plasma process byproduct material, some of the plasma process byproduct material adhering to the shield segment of the integral shield structure.

162. The method as recited in para. 161, wherein the material on the substrate is one or both of a lead zirconate titanate film and a platinum film.

163. The method as recited in para. 162, wherein generating the plasma includes applying radiofrequency power to a process gas within the plasma processing region, the radiofrequency power within a range extending from about 400 Watts (W) to about 1250 W.

164. The method as recited in para. 163, wherein the radiofrequency power is applied by radiofrequency signals having a frequency of about 13.56 MHz.

165. The method as recited in para. 163, further comprising:

generating a bias voltage at the substrate support structure, the bias voltage within a range extending from about 100 V to about 600 V.

166. The method as recited in para. 163, wherein the process gas is one or more of chlorine ($Cl_2$), boron trichloride ($BCl_3$), argon (Ar), carbon tetrafluoride ($CF_4$), oxygen ($O_2$), trifluoromethane ($CHF_3$), and sulfur hexafluoride ($SF_6$).

167. The method as recited in para. 166, further comprising:

maintaining a temperature of the substrate support structure within a range extending from about 40° Celsius (C) to about 80° C.

168. The method as recited in para. 166, further comprising:

maintaining a pressure within the plasma processing region within a range extending from about 5 milliTorr to about 50 milliTorr.

169. The method as recited in para. 163, wherein the process gas includes one or more of chlorine ($Cl_2$) supplied to the plasma processing region at a flow rate within a range extending from about 20 standard cubic centimeters per minute (sccm) to about 300 sccm, boron trichloride ($BCl_3$) supplied to the plasma processing region at a flow rate within a range extending from about 50 sccm to about 300 sccm, argon (Ar) supplied to the plasma processing region at a flow rate within a range extending from about 50 sccm to about 300 sccm, carbon tetrafluoride ($CF_4$) supplied to the plasma processing region at a flow rate within a range extending from about 50 sccm to about 200 sccm, oxygen ($O_2$) supplied to the plasma processing region at a flow rate within a range extending from about 20 sccm to about 300 sccm, trifluoromethane ($CHF_3$) supplied to the plasma processing region at a flow rate within a range extending from about 50 sccm to about 300 sccm, and sulfur hexafluoride ($SF_6$) supplied to the plasma processing region at a flow rate within a range extending from about 50 sccm to about 300 sccm.

170. A method for manufacturing a substrate access port shield for use in a plasma process chamber, comprising:

forming an integral shield structure to include a shield segment, a first support segment extending from a first end of the shield segment, and a second support segment extending from a second end of the shield segment, the first support segment configured to engage with a vertically movable component within a plasma process chamber, the second support segment configured to engage with the vertically movable component within the plasma process chamber, the integral shield structure formed to extend along an arc, the shield segment configured to at least partially cover a substrate access port opening of the plasma process chamber when the first and second support segments are engaged with the vertically movable component and the vertically movable component is in a lowered vertical position, the shield segment configured to uncover the substrate access port opening of the plasma process chamber when the first and second support segments are engaged with the vertically movable component and the vertically movable component is in a raised vertical position.

171. The method as recited in para. 170, wherein the integral shield structure is formed of a ceramic material.

172. The method as recited in para. 171, wherein the integral shield structure is formed of aluminum oxide.

173. The method as recited in para. 171, further comprising:

roughening at least an inner surface of the integral shield structure to have a surface roughness average within a range extending from about 150 microinches to about 500 microinches.

174. The method as recited in para. 173, wherein the roughening is done by a media blasting process.

175. The method as recited in para. 174, wherein the media blasting process impacts the inner surface of the integral shield structure with media including one or more of aluminum oxide, silicon carbide, crushed glass grit, glass beads, ceramic, glass, walnut shell, pumice, steel grit, steel shot, aluminum shot, zinc shot, copper shot, cut wire, garnet, silica sand, and staurolite.

176. The method as recited in para. 173, wherein the roughening includes performing a knurling process prior to firing of the ceramic material.

177. The method as recited in para. 173, wherein the ceramic material is exposed at the inner surface after the roughening.

178. The method as recited in para. 170, wherein forming the integral shield structure includes forming a slot within the first support segment to receive a first portion of the vertically movable component, and includes forming a slot within the second support segment to receive a second portion of the vertically movable component.

179. The method as recited in para. 178, wherein forming the integral shield structure includes forming a slot within either the first support segment or the second support segment to receive a third portion of the vertically movable component.

180. An insert liner for a port of a plasma process chamber, comprising:

an insert liner configured to cover an inner surface of a port formed through a wall of a plasma process chamber, the insert liner configured to have mechanical flexibility sufficient for compression of an outer surface profile of the insert liner to enable insertion of the insert liner into the port, the insert liner configured to impart a spring force against the inner surface of the port upon release of compression of the outer surface profile of the insert liner.

181. The port shield for the plasma process chamber as recited in para. 180, wherein the insert liner includes a first edge separated from a second edge by a gap that forms a discontinuity in the outer surface profile of the insert liner.

182. The port shield for the plasma process chamber as recited in para. 180, wherein the gap provides mechanical flexibility of the insert liner for compression of the outer surface profile of the insert liner to enable insertion of the insert liner into the port.

183. The port shield for the plasma process chamber as recited in para. 180, wherein the insert liner is formed of sheetmetal.

184. The port shield for the plasma process chamber as recited in para. 180, wherein the insert liner is formed of anodized aluminum sheetmetal.

185. The port shield for the plasma process chamber as recited in para. 180, wherein the insert liner is shaped to substantially cover the inner surface of the port.

186. The port shield for the plasma process chamber as recited in para. 180, wherein the insert liner is configured to wrap around an open volume within the port and provide a view through the open volume within the port.

187. The port shield for the plasma process chamber as recited in para. 180, wherein the insert liner is configured to wrap around an open volume within the port and cover an outside boundary of the open volume within the port that is proximate to an outer surface of the wall of the plasma process chamber.

188. The port shield for the plasma process chamber as recited in para. 180, wherein the insert liner is configured to wrap around an open volume within the port and cover an inside boundary of the open volume within the port that is proximate to an inner surface of the wall of the plasma process chamber.

189. The port shield for the plasma process chamber as recited in para. 188, wherein the insert liner is configured to cover a portion of the inner surface of the wall of the plasma process chamber around the port.

190. The port shield for the plasma process chamber as recited in para. 180, wherein the port is a viewport configured to provide for viewing of an interior region of the plasma process chamber.

191. The port shield for the plasma process chamber as recited in para. 180, wherein the spring force imparted by the insert liner against the inner surface of the port is sufficient to physically secure the insert liner within the port.

192. The port shield for the plasma process chamber as recited in para. 180, wherein the insert liner includes a process-exposed surface that is fluidly exposed to an interior region of the plasma process chamber when the insert liner is inserted into the port, the process-exposed surface conditioned to promote adherence of plasma process byproduct material to the process-exposed surface.

193. The port shield for the plasma process chamber as recited in para. 192, wherein the process-exposed surface has a surface roughness average within a range extending from about 150 microinches to about 500 microinches.

194. A plasma process system, comprising:

a plasma process chamber including a plasma processing region in which a plasma is generated during operation of the plasma process chamber, the plasma process chamber including a wall that forms part of an enclosure around the plasma processing region, the wall including a port formed through the wall; and

an insert liner positioned within the port, the insert liner configured to cover an inner surface of the port, the insert liner configured to impart a spring force against the inner surface of the port to hold the insert liner in position within the port.

195. The plasma process system as recited in para. 194, wherein the insert liner is configured to have mechanical flexibility sufficient for compression of an outer surface profile of the insert liner to enable insertion of the insert liner into the port.

196. The plasma process system as recited in para. 195, wherein the insert liner is configured to impart the spring force against the inner surface of the port upon release of compression of the outer surface profile of the insert liner.

197. The plasma process system as recited in para. 196, wherein the insert liner includes a first edge separated from a second edge by a gap that forms a discontinuity in the outer surface profile of the insert liner.

198. The plasma process system as recited in para. 197, wherein the gap provides mechanical flexibility of the insert liner for compression of the outer surface profile of the insert liner to enable insertion of the insert liner into the port.

199. The plasma process system as recited in para. 194, wherein the insert liner is formed of sheetmetal.

200. The plasma process system as recited in para. 194, wherein the insert liner is formed of anodized aluminum sheetmetal.

201. The plasma process system as recited in para. 194, wherein the insert liner is shaped to substantially cover the inner surface of the port.

202. The plasma process system as recited in para. 194, wherein the insert liner is configured to wrap around an open volume within the port and provide a view through the open volume within the port.

203. The plasma process system as recited in para. 194, wherein the insert liner is configured to wrap around an open volume within the port and cover an outside boundary of the open volume within the port that is proximate to an outer surface of the wall of the plasma process chamber.

204. The plasma process system as recited in para. 194, wherein the insert liner is configured to wrap around an open volume within the port and cover an inside boundary of the open volume within the port that is proximate to an inner surface of the wall of the plasma process chamber.

205. The plasma process system as recited in para. 204, wherein the insert liner is configured to cover a portion of the inner surface of the wall of the plasma process chamber around the port.

206. The plasma process system as recited in para. 194, wherein the port is a viewport configured to provide for viewing of the plasma processing region.

207. The plasma process system as recited in para. 194, wherein the spring force imparted by the insert liner against the inner surface of the port is sufficient to physically secure the insert liner within the port.

208. The plasma process system as recited in para. 194, wherein the insert liner includes a process-exposed surface that is fluidly exposed to the plasma processing region when the insert liner is inserted into the port, the process-exposed surface conditioned to promote adherence of plasma process byproduct material to the process-exposed surface.

209. The plasma process system as recited in para. 208, wherein the process-exposed surface has a surface roughness average within a range extending from about 150 microinches to about 500 microinches.

210. A method for plasma processing of a substrate, comprising:

having a plasma process chamber that includes a plasma processing region in which a plasma is generated during operation of the plasma process chamber, the plasma process chamber including a wall that forms part of an enclosure around the plasma processing region, the wall including a port formed through the wall;

positioning an insert liner within the port, the insert liner configured to cover an inner surface of the port, the insert liner configured to impart a spring force against the inner surface of the port to hold the insert liner in position within the port; and

generating a plasma in the plasma processing region in exposure to a substrate, wherein constituents of the plasma interact with a material on the substrate to generate plasma process byproduct material, the insert liner preventing plasma process byproduct material from contacting the inner surface of the port.

211. The method as recited in para. 210, wherein some of the plasma process byproduct material adheres to the insert liner.

212. The method as recited in para. 210, wherein the material on the substrate is one or both of a lead zirconate titanate film and a platinum film.

213. The method as recited in para. 210, wherein generating the plasma includes applying radiofrequency power to a process gas within the plasma processing region, the radiofrequency power within a range extending from about 400 Watts (W) to about 1250 W.

214. The method as recited in para. 213, wherein the radiofrequency power is applied by radiofrequency signals having a frequency of about 13.56 MHz.

215. The method as recited in para. 213, further comprising:

generating a bias voltage at a substrate support structure upon which the substrate is positioned, the bias voltage within a range extending from about 100 Volts (V) to about 600 V.

216. The method as recited in para. 213, wherein the process gas is one or more of chlorine ($Cl_2$), boron trichloride ($BCl_3$), argon (Ar), carbon tetrafluoride ($CF_4$), oxygen ($O_2$), trifluoromethane ($CHF_3$), and sulfur hexafluoride ($SF_6$).

217. The method as recited in para. 216, further comprising:

maintaining a temperature of a substrate support structure upon which the substrate is positioned within a range extending from about 40° Celsius (C) to about 80° C.

218. The method as recited in para. 216, further comprising:

maintaining a pressure within the plasma processing region within a range extending from about 5 milliTorr to about 50 milliTorr.

219. The method as recited in para. 213, wherein the process gas includes one or more of chlorine ($Cl_2$) supplied to the plasma processing region at a flow rate within a range extending from about 20 standard cubic centimeters per minute (sccm) to about 300 sccm, boron trichloride ($BCl_3$) supplied to the plasma processing region at a flow rate within a range extending from about 50 sccm to about 300 sccm, argon (Ar) supplied to the plasma processing region at a flow rate within a range extending from about 50 sccm to about 300 sccm, carbon tetrafluoride ($CF_4$) supplied to the plasma processing region at a flow rate within a range extending from about 50 sccm to about 200 sccm, oxygen ($O_2$) supplied to the plasma processing region at a flow rate within a range extending from about 20 sccm to about 300 sccm, trifluoromethane ($CHF_3$) supplied to the plasma processing region at a flow rate within a range extending from about 50 sccm to about 300 sccm, and sulfur hexafluoride ($SF_6$) supplied to the plasma processing region at a flow rate within a range extending from about 50 sccm to about 300 sccm.

220. The method as recited in para. 210, further comprising:

applying compression to an outer surface profile of the insert liner to enable insertion of the insert liner into the port.

221. The method as recited in para. 220, further comprising:

releasing compression of the outer surface profile of the insert liner so that the insert liner imparts the spring force against the inner surface of the port.

222. The method as recited in para. 210, wherein the insert liner includes a first edge separated from a second edge by a gap that forms a discontinuity in the outer surface profile of the insert liner, wherein the method includes applying compression to an outer surface profile of the insert liner to close the gap to enable insertion of the insert liner into the port.

223. The method as recited in para. 210, wherein the insert liner is formed of sheetmetal.

224. The method as recited in para. 210, wherein the insert liner is formed of anodized aluminum sheetmetal.

225. The method as recited in para. 210, wherein the insert liner is shaped to substantially cover the inner surface of the port when the insert liner is positioned within the port.

226. The method as recited in para. 210, wherein the insert liner is configured to wrap around an open volume within the port and provide a view through the open volume within the port when the insert liner is positioned within the port.

227. The method as recited in para. 210, wherein the insert liner is configured to wrap around an open volume within the port and cover an outside boundary of the open volume within the port that is proximate to an outer surface of the wall of the plasma process chamber when the insert liner is positioned within the port.

228. The method as recited in para. 210, wherein the insert liner is configured to wrap around an open volume within the port and cover an inside boundary of the open volume within the port that is proximate to an inner surface of the wall of the plasma process chamber when the insert liner is positioned within the port.

229. The method as recited in para. 228, wherein the insert liner is configured to cover a portion of the inner surface of the wall of the plasma process chamber around the port when the insert liner is positioned within the port.

230. The method as recited in para. 210, wherein the port is a viewport configured to provide for viewing of the plasma processing region.

231. The method as recited in para. 210, wherein the spring force imparted by the insert liner against the inner surface of the port is sufficient to physically secure the insert liner within the port.

232. The method as recited in para. 210, wherein the insert liner includes a process-exposed surface that is fluidly exposed to the plasma processing region when the insert liner is positioned in the port, the process-exposed surface conditioned to promote adherence of plasma process byproduct material to the process-exposed surface.

233. The method as recited in para. 232, wherein the process-exposed surface has a surface roughness average within a range extending from about 150 microinches to about 500 microinches.

234. A method for manufacturing an insert liner for a port of a plasma process chamber, comprising: forming an insert liner to cover an inner surface of a port formed through a wall of a plasma process chamber, the insert liner configured to have mechanical flexibility sufficient for compression of an outer surface profile of the insert liner to enable insertion of the insert liner into the port, the insert liner configured to impart a spring force against the inner surface of the port upon release of compression of the outer surface profile of the insert liner.

235. The method as recited in para. 234, wherein the insert liner is formed to include a first edge separated from a second edge by a gap that forms a discontinuity in the outer surface profile of the insert liner.

236. The method as recited in para. 235, wherein the gap is configured to provide mechanical flexibility of the insert liner for compression of the outer surface profile of the insert liner to enable insertion of the insert liner into the port.

237. The method as recited in para. 234, wherein the insert liner is formed of sheetmetal.

238. The method as recited in para. 234, wherein the insert liner is formed of anodized aluminum sheetmetal.

239. The method as recited in para. 234, wherein the insert liner is shaped to substantially cover the inner surface of the port.

240. The method as recited in para. 234, wherein the insert liner is formed to wrap around an open volume within the port and provide a view through the open volume within the port when the insert liner is inserted into the port.

241. The method as recited in para. 234, wherein the insert liner is formed to wrap around an open volume within the port and cover an outside boundary of the open volume within the port that is proximate to an outer surface of the wall of the plasma process chamber when the insert liner is inserted into the port.

242. The method as recited in para. 234, wherein the insert liner is formed to wrap around an open volume within the port and cover an inside boundary of the open volume within the port that is proximate to an inner surface of the wall of the plasma process chamber when the insert liner is inserted into the port.

243. The method as recited in para. 242, wherein the insert liner is formed to cover a portion of the inner surface of the wall of the plasma process chamber around the port when the insert liner is inserted into the port.

244. The method as recited in para. 234, wherein the port is a viewport configured to provide for viewing of an interior region of the plasma process chamber.

245. The method as recited in para. 234, wherein the spring force imparted by the insert liner against the inner surface of the port is sufficient to physically secure the insert liner within the port.

246. The method as recited in para. 234, wherein the insert liner includes a process-exposed surface that is fluidly exposed to an interior region of the plasma process chamber when the insert liner is inserted into the port, wherein the method includes conditioning the process-exposed surface to promote adherence of plasma process byproduct material to the process-exposed surface.

247. The method as recited in para. 246, wherein the process-exposed surface is conditioned to have a surface roughness average within a range extending from about 150 microinches to about 500 microinches.

248. An exhaust baffle assembly for use in a plasma process chamber, comprising: at least one baffle member configured to fit within an exhaust channel of a plasma process chamber, the at least one baffle member shaped to deflect a flow of process exhaust gas when positioned within the exhaust channel, wherein an outer surface of the at least one baffle member is conditioned to promote adherence of plasma process byproduct material present within the flow of process exhaust gas to the at least one baffle member.

249. The exhaust baffle assembly as recited in para. 248, wherein the at least one baffle member has a substantially planar surface oriented at an angle transverse to a primary exhaust flow direction through the exhaust channel when the at least one baffle member is positioned within the exhaust channel.

250. The exhaust baffle assembly as recited in para. 249, wherein the angle is about 45 degrees relative to the primary exhaust flow direction.

251. The exhaust baffle assembly as recited in para. 249, wherein the angle is adjustable.

252. The exhaust baffle assembly as recited in para. 248, wherein the at least one baffle member is formed of anodized aluminum.

253. The exhaust baffle assembly as recited in para. 248, wherein the at least one baffle member has a surface roughness average within a range extending from about 150 microinches to about 500 microinches.

254. The exhaust baffle assembly as recited in para. 248, further comprising:

a frame configured to hold the at least one baffle member, the frame including a bottom bar, a top bar, a first end bar, and a second end bar, the first end bar extending between the top bar and the bottom bar, the second end bar extending between the top bar and the bottom bar, the at least one baffle member extending from the first end bar to the second end bar.

255. The exhaust baffle assembly as recited in para. 254, wherein the frame is formed of anodized aluminum.

256. The exhaust baffle assembly as recited in para. 254, wherein the frame has a surface roughness average within a range extending from about 150 microinches to about 500 microinches.

257. The exhaust baffle assembly as recited in para. 254, wherein the at least one baffle member includes five baffle members, each of the five baffle members extending from the first end bar to the second end bar, each of the five baffle members shaped to deflect the flow of process exhaust gas when the exhaust baffle assembly is positioned within the exhaust channel, wherein outer surfaces of the five baffle members are conditioned to promote adherence of plasma process byproduct material present within the flow of process exhaust gas to the five baffle members.

258. The exhaust baffle assembly as recited in para. 257, wherein each of the five baffle members has a substantially planar surface oriented at about 45 degrees relative to a primary exhaust flow direction through the exhaust channel when the exhaust baffle assembly is positioned within the exhaust channel.

259. The exhaust baffle assembly as recited in para. 257, wherein each of the five baffle members has a substantially planar surface oriented transverse to a primary exhaust flow direction through the exhaust channel when the exhaust baffle assembly is positioned within the exhaust channel.

260. The exhaust baffle assembly as recited in para. 259, wherein an orientation of the substantially planar surface of each of the five baffle members relative to the primary exhaust flow direction through the exhaust channel is adjustable.

261. The exhaust baffle assembly as recited in para. 257, wherein each of the five baffle members is formed of anodized aluminum.

262. The exhaust baffle assembly as recited in para. 157, wherein each of the five baffle members has a surface roughness average within a range extending from about 150 microinches to about 500 microinches.

263. A plasma process system, comprising:

    a plasma process chamber including a plasma processing region in which a plasma is generated during operation of the plasma process chamber;

    an exhaust channel for the plasma process chamber, the exhaust channel fluidly connected to the plasma processing region, the exhaust channel configured to direct a flow of process exhaust gas from the plasma processing region;
    a pump connected to the exhaust channel, the pump configured to apply a negative pressure to an interior of the exhaust channel; and
    an exhaust baffle assembly positioned within the exhaust channel, the exhaust baffle assembly including at least one baffle member shaped to deflect the flow of process exhaust gas within the exhaust channel, wherein an outer surface of the at least one baffle member is conditioned to promote adherence of plasma process byproduct material present within the flow of process exhaust gas to the at least one baffle member.

264. The plasma process system as recited in para. 263, wherein the exhaust baffle assembly is configured to extend across essentially an entire cross-sectional flow area within the exhaust channel, such that the flow of process exhaust gas from the plasma processing region is required to flow through the exhaust baffle assembly.

265. The plasma process system as recited in para. 263, wherein the at least one baffle member has a substantially planar surface oriented at an angle transverse to a primary exhaust flow direction through the exhaust channel when the at least one baffle member is positioned within the exhaust channel.

266. The plasma process system as recited in para. 265, wherein the angle is about 45 degrees relative to the primary exhaust flow direction.

267. The plasma process system as recited in para. 265, wherein the angle is adjustable.

268. The plasma process system as recited in para. 263, wherein the at least one baffle member is formed of anodized aluminum.

269. The plasma process system as recited in para. 263, wherein the at least one baffle member has a surface roughness average within a range extending from about 150 microinches to about 500 microinches.

270. The plasma process system as recited in para. 263, further comprising:

a frame configured to hold the at least one baffle member, the frame including a bottom bar, a top bar, a first end bar, and a second end bar, the first end bar extending between the top bar and the bottom bar, the second end bar extending between the top bar and the bottom bar, the at least one baffle member extending from the first end bar to the second end bar.

271. The plasma process system as recited in para. 270, wherein the frame is formed of anodized aluminum.

272. The plasma process system as recited in para. 270, wherein the frame has a surface roughness average within a range extending from about 150 microinches to about 500 microinches.

273. The plasma process system as recited in para. 270, wherein the at least one baffle member includes five baffle members, each of the five baffle members extending from the first end bar to the second end bar, each of the five baffle members shaped to deflect the flow of process exhaust gas when the exhaust baffle assembly is positioned within the exhaust channel, wherein outer surfaces of the five baffle members are conditioned to promote adherence of plasma process byproduct material present within the flow of process exhaust gas to the five baffle members.

274. The plasma process system as recited in para. 273, wherein each of the five baffle members has a substantially planar surface oriented at about 45 degrees relative to a primary exhaust flow direction through the exhaust channel when the exhaust baffle assembly is positioned within the exhaust channel.

275. The plasma process system as recited in para. 273, wherein each of the five baffle members has a substantially planar surface oriented transverse to a primary exhaust flow direction through the exhaust channel when the exhaust baffle assembly is positioned within the exhaust channel.

276. The plasma process system as recited in para. 275, wherein an orientation of the substantially planar surface of each of the five baffle members relative to the primary exhaust flow direction through the exhaust channel is adjustable.

277. The plasma process system as recited in para. 273, wherein each of the five baffle members is formed of anodized aluminum.

278. The plasma process system as recited in para. 273, wherein each of the five baffle members has a surface roughness average within a range extending from about 150 microinches to about 500 microinches.

279. A method for plasma processing of a substrate, comprising:

having a plasma process system that includes a plasma process chamber and an exhaust channel for the plasma process chamber, the plasma process chamber including a plasma processing region in which a plasma is generated during operation of the plasma process chamber, the exhaust channel fluidly connected to the plasma processing region, the exhaust channel configured to direct a flow of process exhaust gas from the plasma processing region, the plasma process system including a pump connected to the exhaust channel, the pump configured to apply a negative pressure to an interior of the exhaust channel, the plasma process system including an exhaust baffle assembly positioned within the exhaust channel, the exhaust baffle assembly including at least one baffle member shaped to deflect the flow of process exhaust gas within the exhaust channel, wherein an outer surface of the at least one baffle member is conditioned to promote adherence of plasma process byproduct material present within the flow of process exhaust gas to the at least one baffle member;

generating a plasma in the plasma processing region in exposure to a substrate; and

operating the pump to apply the negative pressure to the interior of the exhaust channel to draw the flow of process exhaust gas from the plasma processing region into the exhaust channel and through the exhaust baffle assembly within the exhaust channel.

280. The method as recited in para. 279, wherein constituents of the plasma interact with a material on the substrate to generate plasma process byproduct material, some of the plasma process byproduct material adhering to the at least one baffle member of the exhaust baffle assembly.

281. The method as recited in para. 280, wherein the material on the substrate is one or both of a lead zirconate titanate film and a platinum film.

282. The method as recited in para. 280, wherein generating the plasma includes applying radiofrequency power to a process gas within the plasma processing region, the radiofrequency power within a range extending from about 400 Watts (W) to about 1250 W.

283. The method as recited in para. 282, wherein the radiofrequency power is applied by radiofrequency signals having a frequency of about 13.56 MHz.

284. The method as recited in para. 282, further comprising:

generating a bias voltage at a substrate support structure upon which the substrate is positioned, the bias voltage within a range extending from about 100 Volts (V) to about 600 V.

285. The method as recited in para. 282, wherein the process gas is one or more of chlorine ($Cl_2$), boron trichloride ($BCl_3$), argon (Ar), carbon tetrafluoride ($CF_4$), oxygen ($O_2$), trifluoromethane ($CHF_3$), and sulfur hexafluoride ($SF_6$).

286. The method as recited in para. 285, further comprising:

maintaining a temperature of a substrate support structure upon which the substrate is positioned within a range extending from about 40° Celsius (C) to about 80° C.

287. The method as recited in para. 285, further comprising:

maintaining a pressure within the plasma processing region within a range extending from about 5 milliTorr to about 50 milliTorr.

288. The method as recited in para. 282, wherein the process gas includes one or more of chlorine ($Cl_2$) supplied to the plasma processing region at a flow rate within a range extending from about 20 standard cubic centimeters per minute (sccm) to about 300 sccm, boron trichloride ($BCl_3$) supplied to the plasma processing region at a flow rate within a range extending from about 50 sccm to about 300 sccm, argon (Ar) supplied to the plasma processing region at a flow rate within a range extending from about 50 sccm to about 300 sccm, carbon tetrafluoride ($CF_4$) supplied to the plasma processing region at a flow rate within a range extending from about 50 sccm to about 200 sccm, oxygen ($O_2$) supplied to the plasma processing region at a flow rate within a range extending from about 20 sccm to about 300 sccm, trifluoromethane ($CHF_3$) supplied to the plasma processing region at a flow rate within a range extending from about 50 sccm to about 300 sccm, and sulfur hexafluoride ($SF_6$) supplied to the plasma processing region at a flow rate within a range extending from about 50 sccm to about 300 sccm.

289. The method as recited in para. 280, wherein the exhaust baffle assembly is configured to extend across essentially an entire cross-sectional flow area within the exhaust channel, such that the flow of process exhaust gas from the plasma processing region is required to flow through the exhaust baffle assembly.

290. The method as recited in para. 280, wherein the at least one baffle member has a substantially planar surface oriented at an angle transverse to a primary exhaust flow direction through the exhaust channel.

291. The method as recited in para. 290, wherein the angle is about 45 degrees relative to the primary exhaust flow direction.

292. The method as recited in para. 290, wherein the angle is adjustable.

293. The method as recited in para. 280, wherein the at least one baffle member is formed of anodized aluminum.

294. The method as recited in para. 280, wherein the at least one baffle member has a surface roughness average within a range extending from about 150 microinches to about 500 microinches.

295. The method as recited in para. 280, wherein the exhaust baffle assembly includes a frame configured to hold the at least one baffle member, the frame including a bottom bar, a top bar, a first end bar, and a second end bar, the first end bar extending between the top bar and the bottom bar, the second end bar extending between the top bar and the bottom bar, the at least one baffle member extending from the first end bar to the second end bar.

296. The method as recited in para. 295, wherein the frame is formed of anodized aluminum.

297. The method as recited in para. 295, wherein the frame has a surface roughness average within a range extending from about 150 microinches to about 500 microinches.

298. A method for manufacturing an exhaust baffle assembly for use in a plasma process system, comprising:

forming at least one baffle member to fit within an exhaust channel of a plasma process chamber, the at least one baffle member shaped to deflect a flow of process exhaust gas when positioned within the exhaust channel; and
conditioning an outer surface of the at least one baffle member to promote adherence of plasma process byproduct material present within the flow of process exhaust gas to the at least one baffle member.

299. The method as recited in para. 298, wherein the at least one baffle member is formed to have a substantially planar surface oriented at an angle transverse to a primary exhaust flow direction through the exhaust channel when the at least one baffle member is positioned within the exhaust channel.

300. The method as recited in para. 299, wherein the angle is about 45 degrees relative to the primary exhaust flow direction.

301. The method as recited in para. 299, wherein the angle is adjustable.

302. The method as recited in para. 298, wherein the at least one baffle member is formed of anodized aluminum.

303. The method as recited in para. 298, wherein the at least one baffle member has a surface roughness average within a range extending from about 150 microinches to about 500 microinches.

304. The method as recited in para. 298, further comprising:
forming a frame to hold the at least one baffle member, the frame including a bottom bar, a top bar, a first end bar, and a second end bar, the first end bar extending between the top bar and the bottom bar, the second end bar extending between the top bar and the bottom bar, the at least one baffle member extending from the first end bar to the second end bar.

305. The method as recited in para. 304, wherein the frame is formed of anodized aluminum.

306. The method as recited in para. 304, wherein the frame has a surface roughness average within a range extending from about 150 microinches to about 500 microinches.

307. The method as recited in para. 304, wherein the at least one baffle member includes five baffle members, each of the five baffle members positioned to extend from the first end bar to the second end bar, each of the five baffle members shaped to deflect the flow of process exhaust gas when the exhaust baffle assembly is positioned within the exhaust channel, wherein the method includes conditioning the outer surfaces of the five baffle members to promote adherence of plasma process byproduct material present within the flow of process exhaust gas to the five baffle members.

308. The method as recited in para. 307, wherein each of the five baffle members is formed to have a substantially planar surface oriented at about 45 degrees relative to a primary exhaust flow direction through the exhaust channel when the exhaust baffle assembly is positioned within the exhaust channel.

309. The method as recited in para. 307, wherein each of the five baffle members is formed to have a substantially planar surface oriented transverse to a primary exhaust flow direction through the exhaust channel when the exhaust baffle assembly is positioned within the exhaust channel.

310. The method as recited in para. 309, wherein each of the five baffle members is formed to provide for adjustment of an orientation of the substantially planar surface of each of the five baffle members relative to the primary exhaust flow direction through the exhaust channel.

311. The method as recited in para. 307, wherein each of the five baffle members is formed of anodized aluminum.

312. The method as recited in para. 307, wherein each of the five baffle members is conditioned to have a surface roughness average within a range extending from about 150 microinches to about 500 microinches.

## Claims

1. An insert liner for a port of a plasma process chamber, comprising:
   an insert liner configured to cover an inner surface of a port formed through a wall of a plasma process chamber, the insert liner configured to have mechanical flexibility sufficient for compression of an outer surface profile of the insert liner to enable insertion of the insert liner into the port, the insert liner configured to impart a spring force against the inner surface of the port upon release of compression of the outer surface profile of the insert liner , wherein the insert liner is configured to wrap around an open volume within the port and cover an outside boundary of the open volume within the port that is proximate to an outer surface of the wall of the plasma process chamber.

2. The insert liner for the port of the plasma process chamber as recited in claim 1, wherein the insert liner includes a first edge separated from a second edge by a gap that forms a discontinuity in the outer surface profile of the insert liner.

3. The insert liner for the port of the plasma process chamber as recited in claim 2, wherein the gap provides mechanical flexibility of the insert liner for compression of the outer surface profile of the insert liner to enable insertion of the insert liner into the port.

4. The insert liner for the port of the plasma process chamber as recited in claim 1, wherein the insert liner is formed of sheetmetal.

5. The insert liner for the port of the plasma process chamber as recited in claim 1, wherein the insert liner is formed of anodized aluminum sheetmetal.

6. The insert liner for the port of the plasma process chamber as recited in claim 1, wherein the insert liner is shaped to substantially cover the inner surface of the port.

7. The insert liner for the port of the plasma process chamber as recited in claim 1, wherein the insert liner is configured to wrap around an open volume within the port and provide a view through the open volume within the port.

8. The insert liner for the port of the plasma process chamber as recited in claim 1, wherein the insert liner is configured to wrap around an open volume within the port and cover an inside boundary of the open volume within the port that is proximate to an inner surface of the wall of the plasma process chamber.

9. The insert liner for the port of the plasma process chamber as recited in claim 8, wherein the insert liner is configured to cover a portion of the inner surface of the wall of the plasma process chamber around the port.

10. The insert liner for the port of the plasma process chamber as recited in claim 1, wherein the port is a viewport configured to provide for viewing of an interior region of the plasma process chamber.

11. The insert liner for the port of the plasma process chamber as recited in claim 1, wherein the spring force imparted by the insert liner against the inner surface of the port is sufficient to physically secure the insert liner within the port.

12. The insert liner for the port of the plasma process chamber as recited in claim 1, wherein the insert liner includes a process-exposed surface that is fluidly exposed to an interior region of the plasma process chamber when the insert liner is inserted into the port, the process-exposed surface conditioned to promote adherence of plasma process byproduct material to the process-exposed surface.

13. The insert liner for the port of the plasma process chamber as recited in claim 12, wherein the process-exposed surface has a surface roughness average within a range extending from 150 microinches to 500 microinches.

14. A plasma process system, comprising:

a plasma process chamber including a plasma processing region in which a plasma is generated during operation of the plasma process chamber, the plasma process chamber including a wall that forms part of an enclosure around the plasma processing region, the wall including a port formed through the wall; and
an insert liner according to any of claims 1-13 positioned within the port.

15. The plasma process system as recited in claim 14, wherein the port is a viewport configured to provide for viewing of the plasma processing region.

**Fig. 1A**

**Fig. 1B**

Fig. 1C

Fig. 1D

**Fig. 1E**

Fig. 1F

**Fig. 2**

**Fig. 3**

**Fig. 4**

**Fig. 5**

133A

133

133B

133C

**Fig. 6**

701

Having a plasma process chamber that includes a substrate support structure and a top window structure, the substrate support structure configured to hold the substrate in exposure to a plasma, the top window structure positioned above the substrate support structure to establish a plasma processing region between the substrate support structure and the top window structure, the top window structure formed of ceramic material, the top window structure having a bottom surface facing the plasma processing region, the bottom surface having a surface roughness/texture that promotes adherence of plasma process byproduct material to the bottom surface.

703

Generate a plasma in the plasma processing region, constituents of the plasma interacting with a material on the substrate to generate plasma process byproduct material, some of the plasma process byproduct material adhering to the bottom surface of the top window structure.

**Fig. 7**

Form ceramic component for installation within plasma process chamber, where the ceramic component has at least one process-exposed surface.

801

Roughen the at least one process-exposed surface to have a surface roughness that promotes adhesion of plasma process byproduct material to the at least one process-exposed surface.

803

**Fig. 8**

Strip coating from ceramic component down to a bare ceramic material of which the ceramic component is formed.

901

Roughen the at least one process-exposed surface of the ceramic component to have a surface roughness that promotes adhesion of plasma process byproduct material to the at least one process-exposed surface.

903

**Fig. 9**

**Fig. 10A**

Fig. 10B

**Fig. 10C**

**Fig. 10D**

**Fig. 10E**

Fig. 10F

Fig. 10G

Fig. 10H

**Fig. 10I**

**Fig. 10J**

**Fig. 10K**

1101

Having a plasma process chamber that includes a substrate support structure and a focus ring structure, the focus ring including a ring portion formed of a ceramic material, the ring portion configured to circumscribe the substrate support structure within the plasma process chamber, the ring portion having an inner surface oriented to be in exposure to plasma process byproduct material during operation of the plasma process chamber, the inner surface of the ring portion formed to have a controlled surface topographical variation that promotes adherence of the plasma process byproduct material to the inner surface of the ring portion.

1103

Generate a plasma in a plasma processing region above the substrate support structure, constituents of the plasma interacting with a material on the substrate to generate plasma process byproduct material, some of the plasma process byproduct material adhering to the inner surface of the ring portion of the focus ring structure.

**Fig. 11**

1201

Form a ring structure of a ceramic material, the ring structure configured to circumscribe a substrate support structure within a plasma process chamber, the ring structure having an inner surface oriented to be in exposure to plasma process byproduct material when the ring structure is placed within the plasma process chamber during operation of the plasma process chamber.

1203

Form a controlled surface topographical variation on the inner surface of the ring structure, the controlled surface topographical variation promoting adherence of the plasma process byproduct material to the inner surface.

**Fig. 12**

**Fig. 13A**

**Fig. 13B**

**Fig. 14**

Fig. 15

Fig. 16

Fig. 17A

Fig. 17B

1801

Having a plasma process chamber that includes a substrate support structure, a focus ring structure, and a substrate access port shield positioned to sit on the focus ring structure.

1803

Positioning the focus ring structure in the lowered vertical position.

1805

Generating a plasma in the plasma processing region above the substrate support structure.

**Fig. 18**

1901

Forming a substrate access port shield 1401/1401A to include a shield segment, a first support segment extending from a first end of the shield segment, and a second support segment extending from a second end of the shield segment, where the first support segment is configured to engage with a vertically movable component within a plasma process chamber, and where the second support segment is configured to engage with the vertically movable component within the chamber, and where the substrate access port shield is formed to extend along an arc and to at least partially cover an opening in a wall of the chamber that serves as a substrate access port when the first support segment and the second support segment are engaged with the vertically movable component and when the vertically movable component is in a lowered vertical position, and where the substrate access port shield is configured to uncover the opening when the first support segment and the second support segment are engaged with the vertically movable component and when the vertically movable component is in a raised vertical position.

1903

**Fig. 19**

**Fig. 20**

**Fig. 21**

**Fig. 22**

**Fig. 23**

2101A

2401

**Fig. 24**

2501

2101A

2401

**Fig. 25**

**Fig. 26**

**Fig. 27**

**Fig. 28**

**Fig. 29**

3001

Having a plasma process chamber that includes a plasma processing region and a wall that forms part of an enclosure around the plasma processing region, with a port formed through the wall.

3003

Positioning an insert liner within the port, with the insert liner configured to substantially cover the inner surface of the port when positioned within the port.

3005

Generating a plasma in the plasma processing region to cause generation of plasma process byproduct material, with some plasma process byproduct material adhering to the insert liner.

**Fig. 30**

3101

Forming an insert liner to cover an inner surface of a port formed through a wall of a plasma processing chamber, with the insert liner is configured to have mechanical flexibility sufficient for compression of an outer surface profile of the insert liner to enable insertion of the insert liner into the port, and with the insert liner being configured to impart a spring force against the inner surface of the port upon release of compression of the outer surface profile of the insert liner.

**Fig. 31**

Fig. 32

Fig. 33

EP 4 578 991 A2

Fig. 34

**Fig. 35**

3200

3501

3505A

3505B

3507A

3507B

3507C

3507D

3507e

3503

**Fig. 36**

3501

3200

3507A

3505A

3507B

3507C

3703

3507D

3507E

3503

3701

**Fig. 37**

3801

Having a plasma process system that includes a plasma process chamber, and an exhaust channel for the plasma process chamber, and a pump connected to the exhaust channel, and an exhaust baffle assembly positioned within the exhaust channel, with the plasma process chamber including a plasma processing region in which a plasma is generated during operation of the plasma process chamber, and with the exhaust channel being fluidly connected to the plasma processing region.

3803

Generating a plasma in the plasma processing region in exposure to a substrate.

3805

Operating the pump to apply negative pressure to the interior of the exhaust channel to draw a flow of process exhaust gas from the plasma processing region into the exhaust channel and through the exhaust baffle assembly within the exhaust channel.

**Fig. 38**

3901

Forming at least one baffle member to fit within an exhaust channel of a plasma process chamber, with the at least one baffle member shaped to deflect a flow of process exhaust gas when positioned within the exhaust channel.

3903

Conditioning an outer surface of the at least one baffle member to promote adherence of plasma process byproduct material present within the flow of process exhaust gas to the at least one baffle member.

**Fig. 39**